# EUROPEAN PATENT APPLICATION

(11) **EP 2 966 080 A1**
(43) Date of publication of application: **13.01.2016**
(21) Application number: 14759530.0
(22) Date of filing: 03.03.2014
(51) Int. Cl.: C07F 5/02, C09B 57/10, H01L 31/04, H01M 14/00

(54) **NOVEL COMPOUND AND PHOTOELECTRIC CONVERSION ELEMENT USING SAME**

(30) Priority: 05.03.2013 JP 2013042865; 04.09.2013 JP 2013182660
(71) Applicant: Tokyo Metropolitan University, Shinjuku-ku Tokyo 163-0926 (JP); Nippon Kayaku Kabushiki Kaisha, Tokyo 100-0005 (JP)
(72) Inventor: KUBO, Yuji, Hachioji-shi Tokyo 192-0397 (JP); SHIGAKI, Koichiro, Tokyo 115-8588 (JP); KANEKO, Masayoshi, Tokyo 115-8588 (JP)
(74) Representative: Gille Hrabal
(86) International application number: PCT/JP2014/055243
(87) International publication number: WO 2014/136710

(57) **Abstract**

Provided are a compound represented by formula (1) and a photoelectric conversion element in which the compound is supported within a thin layer of oxide semiconductor fine particles disposed upon a substrate. (In formula (1), m1 represents an integer from 1 to 4; M represents a metalloid atom; Y₁, Y₂, and Y₃ each independently represent a hydrogen atom or an aromatic residue; Z₁ and Z₂ each independently represent a halogen atom; Ar₁ and Ar₂ each independently represent an aromatic ring; and X₁ is a substituent on aromatic ring(s) Ar₁ and/or Ar₂ and represents either one or more substituents selected from the group consisting of formulas (2), (3), and (4).)

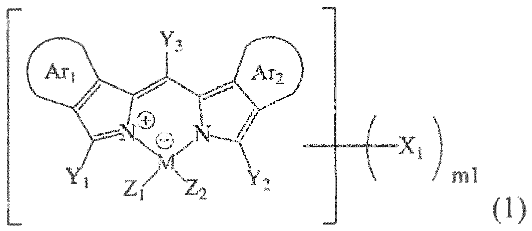

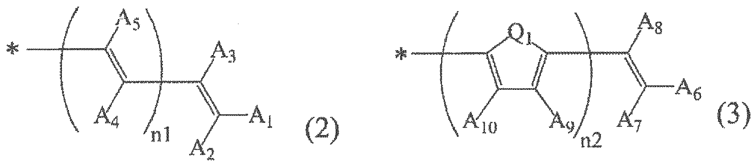

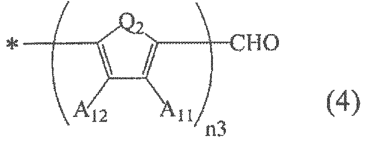

## Description

### Technical Field

The present invention relates to a novel compound having a specific structure, a photoelectric conversion element using the compound, and a solar cell including the photoelectric conversion element.

### Background Art

A solar cell utilizing the solar light has attracted attention as an alternative energy resource to fossil fuels such as oil and coal. At present, silicon solar cells using crystalline or amorphous silicon, or compound semiconductor solar cells using gallium, arsenic or the like, have been actively researched and developed. The manufacture thereof, however, requires a large amount of energy. As a result, they have the problem that their manufacturing costs are still high. On the other hand, a photoelectric conversion element using semiconductor fine particles sensitized with a dye and a solar cell using the element have been known, and materials and methods for manufacturing them have been disclosed (refer to Patent Literature 1, Non Patent Literature 1, and Non Patent Literature 2). The dye-sensitized photoelectric conversion element is manufactured with an oxide semiconductor such as titanium oxide, which is relatively inexpensive. As a result, there is a possibility that a photoelectric conversion element can be manufactured at a lower cost in comparison with conventional solar cells using silicon or the like. In addition, the element allows colorful solar cells to be obtained. In view of the foregoing, the element has attracted attention. In order to obtain the element with high conversion efficiency, however, a ruthenium complex was used as a sensitizing dye, and such a dye is expensive and also has a problem in terms of stable supply. Attempts at using an organic dye as a sensitizer have been already made, but problems such as low conversion efficiency, low stability and low durability have been pointed out. Further improvement in characteristics such as conversion efficiency has been therefore desired (refer to Patent Literature 2 to 4).

### Citation List

### Patent Literature

Patent Literature 1
   JP 01-220380 A
Patent Literature 2
   WO 2002/011213
Patent Literature 3
   JP 2010-184880 A
Patent Literature 4
   JP 2010/199541 A
Non Patent Literature

Non Patent Literature 1
   B.O'Regan and M.Graetzel Nature, Vol. 353, p. 737 (1991)
Non Patent Literature 2
   M.K.Nazeeruddin, A.Kay, I.Rodicio, R.Humphry-Baker, E.Muller, P.Liska, N.Vlachopoulos, M.Graetzel, J.Am.Chem.Soc., Vol. 115, p. 6382 (1993)
Non Patent Literature 3
   Yuji Kubo, Kazuki Watanabe, Ryuhei Nishiyabu, Reiko Hata, Akinori Murakami, Takayuki Shoda, and Hitoshi Ota, Org. Lett., Vol. 13, No.17, 2011
Non Patent Literature 4
   W.Kubo, K.Murakoshi, T.Kitamura, K.Hanabusa, H.Shirai, and S.Yanagida, Chem.Lett., p. 1241 (1998)

### Summary of Invention

### Technical Problem

It has been desired to develop a photoelectric conversion element using oxide semiconductor fine particles sensitized with a dye, wherein the element has stability and high conversion efficiency and thus high practicability.

### Solution to Problem

As a result of extensive investigation to solve the problems, the present inventors have found that a photoelectric conversion element having stability and high conversion efficiency can be manufactured using a new compound having a specific structure to sensitize a thin film of semiconductor fine particles, thereby accomplishing the present invention.

Thus, the present invention relates to:
(1) A compound represented by Formula (1):

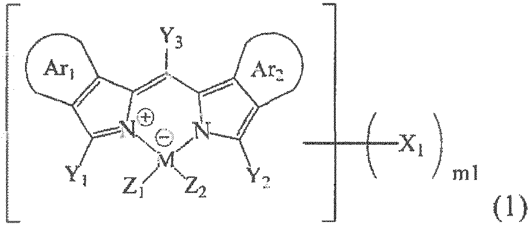

wherein m1 represents an integer of 1 to 4; M represents a semimetal atom; Y₁, Y₂ and Y₃ each independently represent a hydrogen atom or an aromatic residue; Z₁ and Z₂ each independently represent a halogen atom; Ar₁ and Ar₂ each independently represent an aromatic ring; and X₁ represents one or more substituents on the aromatic ring Ar₁ and/or Ar₂ selected from the group consisting of Formulas (2), (3) and (4):

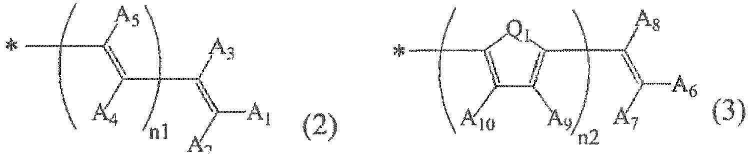

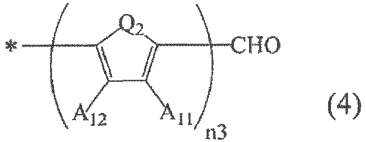

in Formula (2), n1 represents an integer of 0 to 5; A₁ and A₂ each independently represent a hydrogen atom, a carboxyl group, a cyano group, a phosphoric acid group or a sulfonic acid group, or A₁ and A₂ may be linked to each other to form a ring; A₃ represents a hydrogen atom, an aliphatic hydrocarbon residue, a halogen atom or an alkoxyl group; and A₄ and A₅ each independently represent a hydrogen atom, an aliphatic hydrocarbon residue, a halogen atom or an alkoxyl group, and when n1 is two or more so that the number of A₄ and the number of A₅ are each two or more, one of the A₄ substituents may be the same as or different from another thereof and one of the A₅ substituents may be the same as or different from another each other, or A₄ and A₅ may be linked to each other to form a ring;
in Formula (3), n2 represents an integer of 1 to 5; A₆ and A₇ each independently represent a hydrogen atom, a carboxyl group, a cyano group, a phosphoric acid group or a sulfonic acid group, or A₆ and A₇ may be linked to each other to form a ring; A₈ represents a hydrogen atom, an aliphatic hydrocarbon residue, a halogen atom or an alkoxyalkyl group; A₉ and A₁₀ each independently represent a hydrogen atom, an aliphatic hydrocarbon residue, a halogen atom or an alkoxyl group, and when n2 is two or more so that the number of A₉ and the number of A₁₀ are each two or more, one of the A₉ substituents may be the same as or different from another thereof and one of the A₁₀ substituents may be the same as or different from another thereof, or A₉ and A₁₀ may be linked to each other to form a ring; and Q₁ represents an oxygen atom, a sulfur atom or a selenium atom, and when n2 is two or more so that the number of Q₁ is two or more, one of the Q₁ atoms may be the same as or different from another thereof;
in Formula (4), n3 represents an integer of 0 to 5; A₁₁ and A₁₂ each independently represent a hydrogen atom, an aliphatic hydrocarbon residue, a halogen atom or an alkoxyl group, and when n3 is two or more so that the number of A₁₁ and the number of A₁₂ are each two or more, one of the A₁₁ substituents may be the same as or different from another thereof and one of the A₁₂ substituents may be the same as or different from another thereof, or A₁₁ and A₁₂ may be linked to each other to form a ring; Q₂ represents an oxygen atom, a sulfur atom or a selenium atom, and when n3 is two or more so that the number of Q₂ is two or more, one of the Q₂ atoms may be the same as or different from another thereof; and
in Formulas (2) to (4), the mark * represents a binding site with the aromatic ring Ar₁ and/or Ar₂;
(2) The compound according to (1), wherein Ar₁ and Ar₂ in Formula (1) are each a benzene ring;
(3) The compound according to (1) or (2), wherein Y₁ and Y₂ in Formula (1) are each independently an aromatic residue, and Y₃ is a hydrogen atom;
(4) The compound according to any one of (1) to (3), wherein M in Formula (1) is a boron atom;
(5) The compound according to (1) represented by Formula (5):

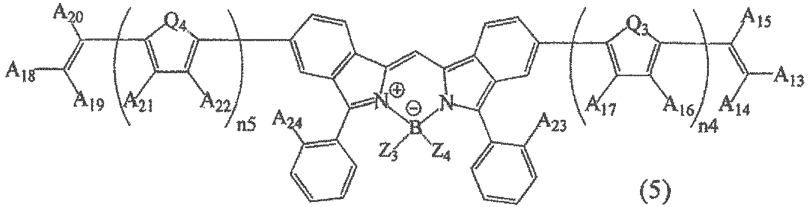

wherein Z₃ and Z₄ each independently represent a halogen atom; n4 represents an integer of 0 to 5; Q₃ represents an oxygen atom, a sulfur atom or a selenium atom, and when n4 is two or more so that the number of Q₃ is two or more, one of the Q₃ atoms may be the same as or different from another thereof; A₁₃ and A₁₄ each independently represent a hydrogen atom, a carboxyl group, a cyano group, a phosphoric acid group or a sulfonic acid group, or A₁₃ and A₁₄ may be linked to each other to form a ring; A₁₅ represents a hydrogen atom, an aliphatic hydrocarbon residue or an alkoxyl group; A₁₆ and A₁₇ each independently represent a hydrogen atom, an aliphatic hydrocarbon residue, a halogen atom or an alkoxyl group, and when n4 is two or more so that the number of A₁₆ and the number of A₁₇ are each two or more, one of the A₁₆ substituents may be the same as or different from another thereof and one of the A₁₇ substituents may be the same as or different from another thereof, or A₁₆ and A₁₇ may be linked to each other to form a ring; n5 represents an integer of 0 to 5; Q₄ represents an oxygen atom, a sulfur atom or a selenium atom, and when n5 is two or more so that the number of Q₄ is two or more, one of the Q₄ atoms may be the same as or different from another thereof; A₁₈ and A₁₉ each independently represent a hydrogen atom, a carboxyl group, a cyano group, a phosphoric acid group or a sulfonic acid group, or A₁₈ and A₁₉ may be linked to each other to form a ring; A₂₀ represents a hydrogen atom, an aliphatic hydrocarbon residue or an alkoxyl group; A₂₁ and A₂₂ each independently represent a hydrogen atom, an aliphatic hydrocarbon residue or an alkoxyl group; when n5 is two or more so that the number of A₂₁ and the number of A₂₂ are each two ro more, one of the A₂₁ substituents may be the same as or different from another thereof and one of the A₂₂ substituents may be the same as or different from another thereof, or A₂₁ and A₂₂ may be linked to each other to form a ring; and A₂₃ and A₂₄ each independently represent a hydrogen atom, a halogen atom, an aliphatic hydrocarbon residue or an alkoxyl group;
(6) The compound according to (5), wherein in Formula (5), Z₃ and Z₄ are each a fluorine atom, n4 and n5 are each an integer of 1, Q₃ and Q₄ are each a sulfur atom, one of A₁₃ and A₁₄ is a carboxyl group and the other is a cyano group, one of A₁₈ and A₁₉ is a carboxyl group and the other is a cyano group, A₁₅ and A₂₀ are each a hydrogen atom A₁₆ and A₂₁ are each a hydrogen atom, A17 and A22 are each an hexyl group, and A23 and A24 are each a methoxy group;
(7) The compound according to (1), represented by Formula (6):

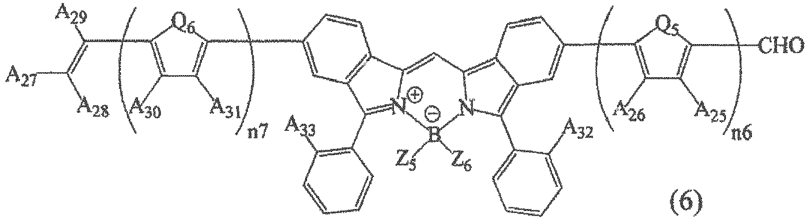

wherein Z₅ and Z₆ each independently represent a halogen atom; n6 represents an integer of 0 to 5; n7 represents an integer of 0 to 5; Q₅ represents an oxygen atom, a sulfur atom or a selenium atom, and when n6 is two or more so that the number of Q₅ is two or more, one of the Q₅ atoms may be the same as or different from another thereof; Q₆ represents an oxygen atom, a sulfur atom or a selenium atom, and when n7 is two or more so that the number of Q₆ is two or more, one of the Q₆ atoms may be the same as or different from another thereof; A₂₅ and A₂₆ each independently represent a hydrogen atom, an aliphatic hydrocarbon residue, a halogen atom or an alkoxyl group, and when n6 is two or more so that the number of A₂₅ and the number of A₂₆ are each two or more, one of the A₂₅ substituents may be the same as or different from another thereof and one of the A₂₆ substituents may be the same as or different from another thereof, or A₂₅ and A₂₆ may be linked to each other to form a ring; A₂₇ and A₂₈ each independently represent a hydrogen atom, a carboxyl group, a cyano group, a phosphoric acid group or a sulfonic acid group, or A₂₇ and A₂₈ may be linked to each other to form a ring; A₂₉ represents a hydrogen atom, an aliphatic hydrocarbon residue or an alkoxyl group; A₃₀ and A₃₁ each independently represent a hydrogen atom, an aliphatic hydrocarbon residue, a halogen atom or an alkoxyl group, and when n7 is two or more so that the number of A₃₀ and the number of A₃₁ are each two or more, one of the A₃₀ substituents may be the same as or different from another thereof and one of the A₃₁ substituents may be the same as or different from another thereof, or A₃₀ and A₃₁ may be linked to each other to form a ring; and A₃₂ and A₃₃ each independently represent a hydrogen atom, a halogen atom, an aliphatic hydrocarbon residue or an alkoxyl group;
(8) The compound according to (7), wherein in Formula (6), Z₅ and Z₆ are each a fluorine atom, n6 and n7 are each an integer of 1, Q₅ and Q₆ are each a sulfur atom, A₂₅, A₂₉ and A₃₀ are each a hydrogen atom, A₂₆ and A₃₁ are each an n-hexyl group, one of A₂₇ and A₂₈ is a carboxyl group and the other is a cyano group, and A₃₂ and A₃₃ are each a methoxy group;
(9) The compound according to (1), represented by Formula (9):

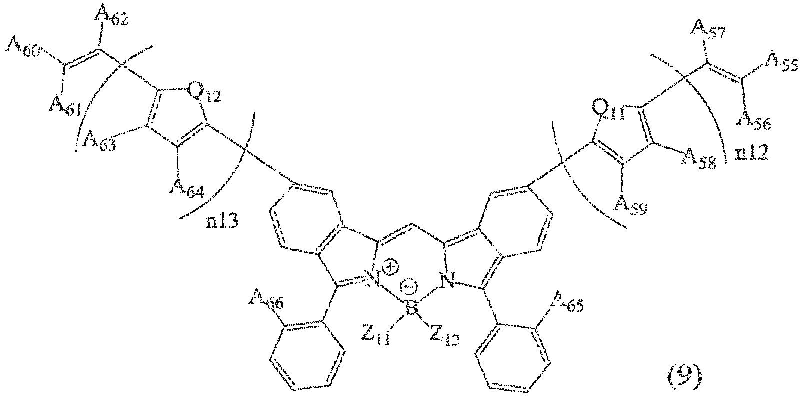

wherein Z₁₁ and Z₁₂ each independently represent a halogen atom; n12 represents an integer of 0 to 5; Q₁₁ represents an oxygen atom, a sulfur atom or a selenium atom, and when n12 is two or more so that the number of Q₁₁ is two or more, one of the Q₁₁ atoms may be the same as or different from another thereof; A₅₅ and A₅₆ each independently represent a hydrogen atom, a carboxyl group, a cyano group, a phosphoric acid group or a sulfonic acid group, or A₅₅ and A₅₆ may be linked to each other to form a ring; A₅₇ represents a hydrogen atom, an aliphatic hydrocarbon residue or an alkoxyl group; A₅₈ and A₅₉ each independently represent a hydrogen atom, an aliphatic hydrocarbon residue, a halogen atom or an alkoxyl group, and when n12 is two or more so that the number of A₅₈ and the number of A₅₉ are each two or more, one of the A₅₈ substituents may be the same as or different from another thereof and one of the A₅₉ substituents may be the same as or different from another thereof, or A₅₈ and A₅₉ may be linked to each other to form a ring; n13 is an integer of 0 to 5; Q₁₂ represents an oxygen atom, a sulfur atom or a selenium atom, and when n13 is two or more so that the number of Q₁₂ is two or more, one of the Q₁₂ atoms may be the same as or different from another thereof; A₆₀ and A₆₁ each independently represent a hydrogen atom, a carboxyl group, a cyano group, a phosphoric acid group or a sulfonic acid group, or A₆₀ and A₆₁ may be linked to each other to form a ring; A₆₂ represents a hydrogen atom, an aliphatic hydrocarbon residue or an alkoxyl group; A₆₃ and A₆₄ each independently represent a hydrogen atom, an aliphatic hydrocarbon residue, a halogen atom or an alkoxyl group; when n13 is two or more so that the number of A₆₃ and the number of A₆₄ are each two or more, one of the A₆₃ substituents may be the same as or different from another thereof and one of the A₆₄ substituents may be the same as or different from another thereof, or A₆₃ and A₆₄ may be linked to each other to form a ring; and A₆₅ and A₆₆ each independently represent a hydrogen atom, a halogen atom, an aliphatic hydrocarbon residue or an alkoxyl group;
(10) The compound according to (9), wherein in Formula (9), Z₁₁ and Z₁₂ are each a fluorine atom, n12 and n13 are each an integer of 1, Q₁₁ and Q₁₂ are each a sulfur atom, one of A₅₅ and A₅₆ is a carboxyl group and the other is a cyano group, one of A₆₀ and A₆₁ is a carboxyl group and the other is a cyano group, A₅₇ and A₆₂ are each a hydrogen atom, A₅₈ and A₆₃ are each a hydrogen atom, A₅₉ and A₆₄ are each an n-hexyl group, and A₆₅ and A₆₆ are each a methoxy group;
(11) The compound according to (1), represented by Formula (10):

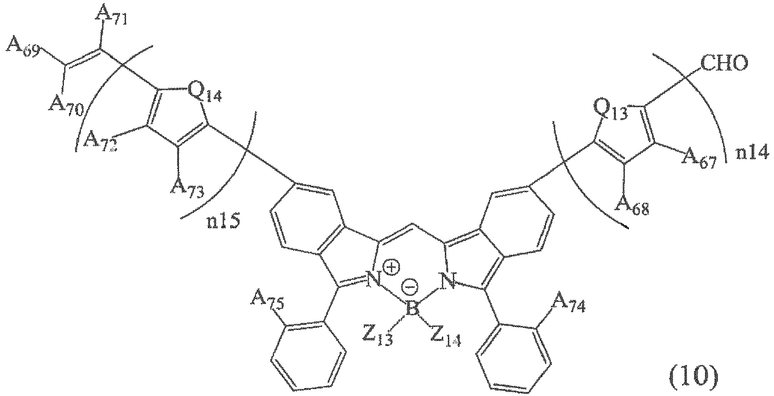

wherein Z₁₃ and Z₁₄ each independently represent a halogen atom; n14 represents an integer of 0 to 5; n15 represents an integer of 0 to 5; Q₁₃ represents an oxygen atom, a sulfur atom, or a selenium atom, and when n14 is two or more so that the number of Q₁₃ is two or more, one of the Q₁₃ atoms may be the same as or different from another thereof; Q₁₄ represents an oxygen atom, a sulfur atom or selenium atom, and when n15 is two or more so that the number of Q₁₄ is two or more, one of the Q₁₄ atoms may be the same as or different from another thereof; A₆₇ and A₆₈ each independently represent a hydrogen atom, an aliphatic hydrocarbon residue, a halogen atom or an alkoxyl group, and when n14 is two or more so that the number of A₆₇ and the number of A₆₈ are each two or more, one of the A₆₇ substituents may be the same as or different from another thereof and one of the A₆₈ substituents may be the same or different from another thereof, or A₆₇ and A₆₈ may be linked to each other to form a ring; A₆₉ and A₇₀ each independently represent a hydrogen atom, a carboxyl group, a cyano group, a phosphoric acid group or a sulfonic acid group, or A₆₉ and A₇₀ may be linked to each other to form a ring; A₇₁ represents a hydrogen atom, an aliphatic hydrocarbon residue or an alkoxyl group; A₇₂ and A₇₃ each independently represent a hydrogen atom, an aliphatic hydrocarbon residue, a halogen atom or an alkoxyl group, and when n15 is two or more so that the number of A₇₂ and the number of A₇₃ are each two or more, one of the A₇₂ substituents may be the same as or different from another thereof and one of the A₇₃ substituents may be the same as or different from another thereof, or A₇₂ and A₇₃ may be linked to each other to form a ring; and A₇₄ and A₇₅ each independently represent a hydrogen atom, a halogen atom, an aliphatic hydrocarbon residue or an alkoxyl group;
(12) The compound according to (11), wherein in Formula (10), Z₁₃ and Z₁₄ are each a fluorine atom, n14 and n15 are each an integer of 1, Q₁₃ and Q₁₄ are each a sulfur atom, A₆₇, A₇₁ and A₇₂ are each a hydrogen atom, A₆₈ and A₇₃ are each an n-hexyl group, one of A₆₉ and A₇₀ is a carboxyl group and the other is a cyano group, and A₇₄ and A₇₅ are each a methoxy group;
(13) A method for manufacturing the compound represented by Formula (1) according to (1), comprising introducing a substituent X₁ by a cross-coupling reaction;
(14) A photoelectric conversion element comprising the compound represented by Formula (1) according to (1) which is supported on a thin film of oxide semiconductor fine particles disposed on a substrate;
(15) A photoelectric conversion element comprising one or more of the compounds represented by Formula (1) according to (1) and a sensitizing dye compound having a structure other than Formula (1) which are carried by a thin film of oxide semiconductor fine particles disposed on a substrate;
(16) The photoelectric conversion element according to (14) or (15), wherein the oxide semiconductor fine particles comprise titanium dioxide, zinc oxide or tin oxide; and
(17) A solar cell comprising the photoelectric conversion element according to any one of (14) to (16).

### Advantageous Effects of Invention

A compound of the present invention having a specific structure represented by Formula (1), which may be herein simply referred to as "a compound of the invention", can be used as sensitizing dye to provide a dye-sensitized solar cell having high conversion efficiency and high stability.

### Description of Embodiments

The present invention is described in detail as follows. The compound of the present invention has a structure represented by Formula (1):

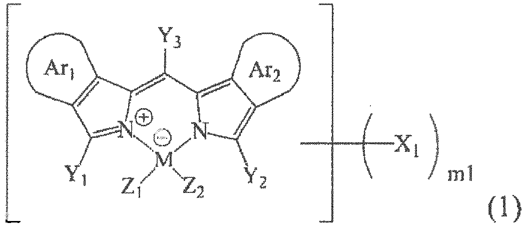

In Formula (1), m1 represents an integer of 1 to 4, preferably 1 to 2, more preferably 2. M represents a semimetal. As used herein, the semimetal means a substance having intermediate properties between metals and nonmetals. Examples thereof include a boron atom, a silicon atom, a germanium atom and an antimony atom; and a boron atom is preferred. Y₁, Y₂ and Y₃ each independently represent a hydrogen atom or an aromatic residue. The aromatic residue may have a substituent.

The aromatic residue represented by Y₁, Y₂ or Y₃ means a residue in which one hydrogen atom is removed from an aromatic ring. Examples of the aromatic ring include an aromatic hydrocarbon ring, a heteroaromatic ring and a condensed aromatic ring. Specific examples thereof include a benzene ring, a naphthalene ring, an anthracene ring, a phenanthrene ring, a pyrene ring, a perylene ring, a terylene ring, an indene ring, an azulene ring, a pyridine ring, a pyrazine ring, a pyrimidine ring, a pyrazole ring, a pyrazolidine ring, a thiazolidine ring, an oxazolidine ring, a pyran ring, a chromene ring, a pyrrole ring, a pyrrolidine ring, a benzimidazole ring, an imidazoline ring, an imidazolidine ring, an imidazole ring, a pyrazole ring, a triazole ring, a triazine ring, a diazole ring, an indoline ring, a thiophene ring, a thienothiophene ring, a furan ring, an oxazole ring, an oxadiazole ring, a thiazine ring, a thiazole ring, an indole ring, a benzothiazole ring, a benzothiadiazole ring, a naphthothiazole ring, a benzoxazole ring, a naphthoxazole ring, an indolenine ring, a benzoindolenine ring, a pyrazine ring, a quinoline ring, a quinazoline ring, a fluorene ring and a carbazole ring. An aromatic hydrocarbon ring, a heteroaromatic ring or a condensed aromatic ring having 5 to 16 carbon atoms is preferred.

Y₁ and Y₂ in Formula (1) are preferably each independently an aromatic residue, more preferably each independently a residue in which one hydrogen atom is removed from a benzene ring, a naphthalene ring or a thiophene ring, and still more preferably a residue in which one hydrogen atom is removed from a benzene ring. Y₃ in Formula (1) is preferably a hydrogen atom.

Examples of a substituent which the aromatic residue represented by Y1, Y2 or Y3 may have include, but not particularly limited to, a sulfonic acid group, a sulfamoyl group, a cyano group, an isocyano group, a thiocyanato group, an isothiocyanato group, a nitro group, a nitrosyl group, a halogen atom, a hydroxyl group, a phosphoric acid group, a phosphoric acid ester group, an amino group, a mercapto group, an amide group, an alkoxyl group, an aryloxy group, a carboxyl group, a carbamoyl group, an acyl group, an aldehyde group, a carbonyl groups, an aromatic residue and an aliphatic hydrocarbon residue.

The halogen atom which the aromatic residue represented by Y1, Y2 or Y3 may have as a substituent include a fluorine atom, a chlorine atom, a bromine atom and an iodine atom; and a fluorine atom, a bromine atom or a chlorine atom is preferred.

The phosphoric acid ester group which the aromatic residue represented by Y1, Y2 or Y3 may have as a substituent include an alkyl phosphate group having 1 to 4 carbon atoms. Specific examples thereof include a methyl phosphate group, an ethyl phosphate group, an n-propyl phosphate group and an n-butyl phosphate group.

The amino group which the aromatic residue represented by Y1, Y2 or Y3 may have as a substituent include: an unsubstituted amino group; an amino group substituted by an alkyl (having 1 to 4 carbon atoms) such as a mono- or dimethylamino group, a mono- or diethylamino group, and a mono- or di(n-propyl)amino group; an amino group substituted by an aromatic ring such as a mono- or diphenylamino group and mono- or dinaphthylamino group; an amino group substituted by one alkyl group (having 1 to 4 carbon atoms) and one aromatic residue such as a monoalkyl monophenyl amino group; and benzylamino group, an acetylamino group and a phenylacetylamino group. Herein, the aromatic ring and the aromatic residue mean the same as described above.

The mercapto group which the aromatic residue represented by Y1, Y2 or Y3 may have as a substituent include: an unsubstituted mercapto group; an alkylmercapto group having 1 to 4 carbon atoms such as a methylmercapto group, an ethylmercapto group, an n-propylmercapto group, an isopropylmercapto group, an n-butylmercapto group, an isobutylmercapto group, a sec-butylmercapto group, and a t-butylmercapto group; and a phenylmercapto group.

The amide group which the aromatic residue represented by Y1, Y2 or Y3 may have as a substituent include an unsubstituted amide group, an acetamide group, an N-methylamide group, an N-ethylamide group, an N-(n-propyl)amide group, an N-(n-butyl)amide group, an N-isobutyl amide group, an N-(sec-butylamide) group, an N-(t-butyl)amide group, an N,N-dimethylamide group, an N,N-diethylamide group, an N,N-di(n-propyl)amide group, an N,N-di(n-butyl)amide group, an N,N-diisobutylamide group, an N-methylacetamide group, an N-ethylacetamide group, an N-(n-propyl)acetamide group, an N-(n-butyl)acetamide group, an N-isobutylacetamide group, an N-(sec- butyl)acetamide group, an N-(t- butyl)acetamide group, an N,N-dimethylacetamide group, an N,N-diethylacetamide group, an N,N-di(n-propyl)acetamide group, an N,N-di(n-butyl)acetamide group, an N,N-diisobutylacetamide group, a phenylamide group, a naphthylamide group, a phenylacetamide group and a naphthylacetamide group.

The alkoxyl group which the aromatic residue represented by Y1, Y2 or Y3 may have as a substituent include an alkoxyl group having 1 to 4 carbons atoms such as a methoxy group, an ethoxy group, an n-propoxy group, an isopropoxy group, an n-butoxy group, an isobutoxy group, a sec-butoxy group and a t-butoxy group.

The aryloxy group which the aromatic residue represented by Y1, Y2 or Y3 may have as a substituent include a monocyclic, bicyclic or tricyclic aryloxy group having 5 to 16 carbon atoms such as a phenoxy group and a naphthoxy group, which may have a phenyl group or a methyl group as a substituent.

The acyl group which the aromatic residue represented by Y1, Y2 or Y3 may have as a substituent include an alkylcarbonyl group and an arylcarbonyl group which have 1 to 10 carbon atoms; and preferably an alkylcarbonyl group having 1 to 4 carbon atoms. Specific examples thereof include an acetyl group, a propionyl group, a trifluoromethylcarbonyl group, a pentafluoroethylcarbonyl group, a benzoyl group and naphthoyl group.

The carbonyl group which the aromatic residue represented by Y1, Y2 or Y3 may have as a substituent include a methoxycarbonyl group, an ethoxycarbonyl group, an n-propoxycarbonyl group, an isopropoxycarbonyl group, an n-butoxycarbonyl group, an isobutoxycarbonyl group, a sec-butoxycarbonyl group, a t-butoxycarbonyl group, an n-pentoxycarbonyl group, an n-hexyloxycarbonyl group, an n-heptyloxycarbonyl group, an n-nonyloxycarbonyl group and an n-decyloxycarbonyl group.

The aromatic residue which the aromatic residue represented by Y1, Y2 or Y3 may have as a substituent include the same as the aromatic residue represented by Y₁, Y₂ and Y₃. The aromatic residue may have a substituent. The substituent include the same as the substituents which the aromatic residue represented by Y1, Y2 or Y3 may have.

The aliphatic hydrocarbon residue which the aromatic residue represented by Y1, Y2 or Y3 may have as a substituent include a saturated or unsaturated straight-chain or branched-chain alkyl group, and a cyclic alkyl group. The straight-chain or branched-chain alkyl group preferably has 1 to 36 carbon atoms, and more preferably 3 to 18 carbon atoms. The cyclic alkyl group include a cycloalkyl having 3 to 8 carbon atoms. Specific examples of the aliphatic hydrocarbon residue include a methyl group, an ethyl group, an n-propyl group, an isopropyl group, an n-butyl group, an isobutyl group, a sec-butyl group, a t-butyl group, an n-pentyl group, an n-hexyl group, an n-heptyl group, an n-octyl group, an n-nonyl group, an n-decyl group, an undecyl group, an n-dodecyl group, an n-tridecyl group, an n-tetradecyl group, an n-pentadecyl group, an n-hexadecyl group, an n-heptadecyl group, an n-octadecyl group, a cyclohexyl group, a vinyl group, a propenyl group, a pentynyl group, a butenyl group, a hexenyl group, a hexadienyl group, an isopropenyl group, an isohexenyl group, a cyclohexenyl group, a cyclopentadienyl group, an ethynyl group, a propynyl group, a pentynyl group, a hexynyl group, an isohexynyl group, and a cyclohexynyl group. In particular, a straight-chain alkyl group having 3 to 18 carbon atoms is preferred.

These aliphatic hydrocarbon residues may have a substituent. The substituent include the same as the substituents which the aromatic residue represented by Y1, Y2 or Y3 may have.

In Formula (1), Z₁ and Z₂ each independently represent a halogen atom. The halogen atom include the same as the halogen atoms which the aromatic residue represented by Y1, Y2 or Y3 may have as a substituent; and preferably a fluorine atom.

In Formula (1), Z₁ and Y₁, or Z₂ and Y₂ may be linked to form a ring. When Y₁ or Y₂ is an aromatic residue, Z₁ and a substituent on the aromatic residue represented by Y₁, or Z₂ and a substituent on the aromatic residues represented by Y₂ may be linked to form a ring.

In Formula (1), Ar₁ and Ar₂ each independently represent an aromatic ring. Specific examples of the aromatic ring include the same as the specific examples to describe the aromatic residue represented by Y1, Y2 or Y3. Ar₁ and Ar₂ preferably each independently represent a benzene ring, a naphthalene ring or a thiophene ring, and more preferably a benzene ring.

In Formula (1), X₁ represents one or more substituents on the aromatic ring Ar₁ and/or Ar₂ selected from the group consisting of Formulas (2), (3) and (4).

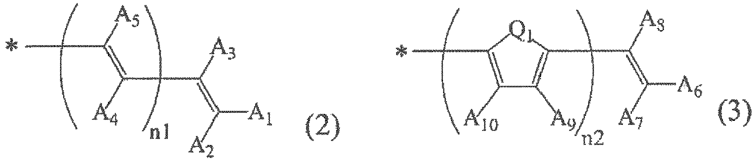

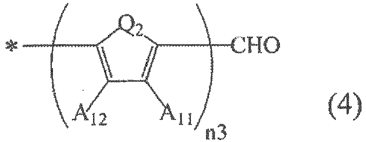

In Formula (2), n1 represents an integer of 0 to 5, preferably 0 to 4, and more preferably 0.

In Formula (2), A₁ and A₂ each independently represent a hydrogen atom, a carboxyl group, a cyano group, a phosphoric acid group, a sulfonic acid group or an aromatic residue. Alternatively, A₁ and A₂ may be linked to each other to form a ring.

Specific examples of the aromatic residue represented by A₁ or A₂ include the same as those of the aromatic residue represented by Y₁, Y₂ or Y₃. The aromatic residue may have a substituent, and examples of the substituent include the same as those of the substituent which the aromatic residue represented by Y1, Y2 or Y3 may have.

The aromatic residue represented by A₁ or A₂ is preferably an aromatic residue having at least one substitute selected from the group consisting of a carboxyl group, a hydroxyl group, a phosphoric acid group, a sulfonic acid group, and a salt thereof, and more preferably a group represented by any one of Formulas (1001) to (1033).

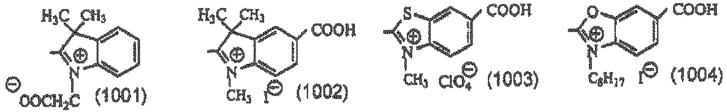

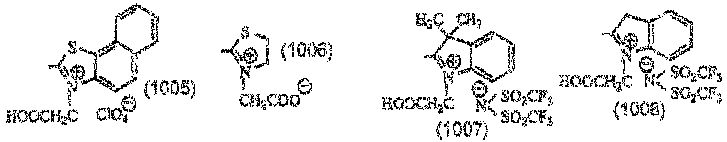

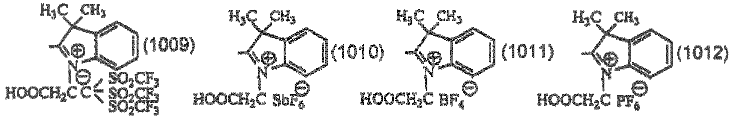

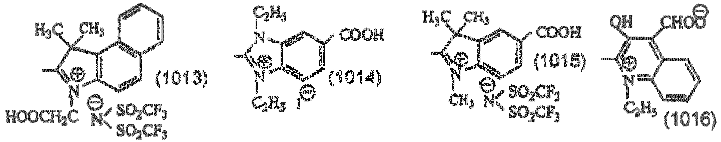

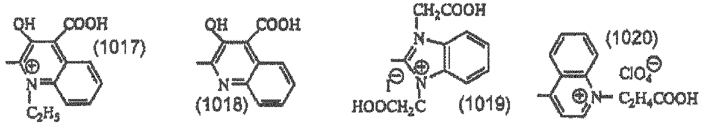

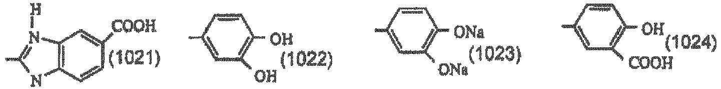

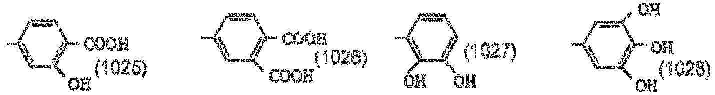

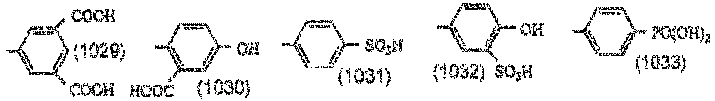

The ring formed by A₁ and A₂ include an aromatic ring and a heterocyclic ring, which may have a substituent.

Specific examples of the aromatic ring formed by A₁ and A₂ include the same as the specific examples to describe the aromatic residue represented by Y1, Y2 or Y3. And examples of the substituent which the ring formed by A₁ and A₂ may have include the same as those of the substituent which the aromatic residue represented by Y1, Y2 or Y3 may have.

The heterocyclic ring formed by A₁ and A2 include a 4- to 7-membered heterocyclic ring containing a heteroatom such as S, N and O, preferably a ring represented by any one of Formulas (2001) to (2017), more preferably a ring represented by Formula (2007) or (2012), and still more preferably a ring represented by Formula (2007).

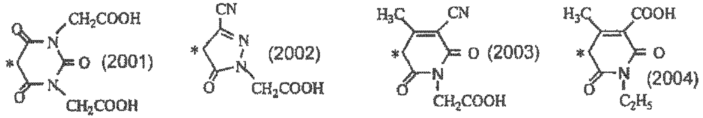

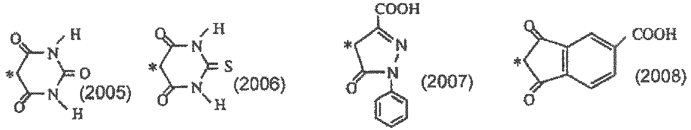

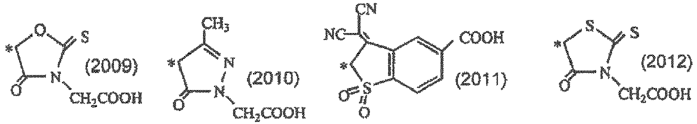

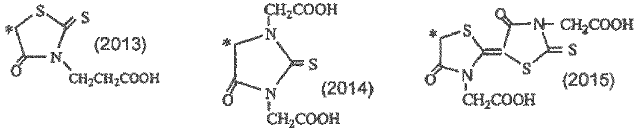

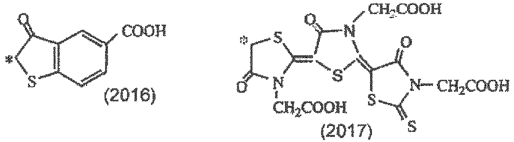

In Formulas (2001) to (2017), the mark * represents a carbon atom to which both of A₁ and A₂ are bonded in Formula (2).

In Formula (2), preferably A₁ and A₂ are each independently a carboxyl group or a cyano group, more preferably one of A₁ and A₂ is a carboxyl group and the other is a carboxyl group or a cyano group, and still more preferably one of A₁ and A₂ is a carboxyl group and the other is a cyano group.

In Formula (2), A₃ represents a hydrogen atom, an aliphatic hydrocarbon residue, a halogen atom or an alkoxyl group. Examples of the aliphatic hydrocarbon residue, the halogen atom and the alkoxyl group represented by A₃ include the same as those of the aliphatic hydrocarbon residue, the halogen atom and the alkoxyl group which the aromatic residue represented by Y1, Y2 or Y3 may have as a substituent.

In Formula (2), A₃ is preferably each independently a hydrogen atom or an aliphatic hydrocarbon residue, and more preferably a hydrogen atom.

In Formula (2), A₄ and A₅ each independently represent a hydrogen atom, an aliphatic hydrocarbon residue, a halogen atom or an alkoxyl group. When n1 is two or more so that the number of A₄ and the number of A₅ are each two or more, one of the A₄ substituents may be the same as or different from another thereof and one of the A₅ substituents may be the same as or different from another thereof. Examples of the aliphatic hydrocarbon residue, the halogen atom and the alkoxyl group represented by A₄ or A₅ include the same as those of the aliphatic hydrocarbon residue, the halogen atom and the alkoxyl group which the aromatic residue represented by Y1, Y2 or Y3 may have as a substituent.

Further, neighboring A₄ and A₄, neighboring A₅ and A₅, or A₄ and A₅ may be linked to form a ring. Examples of the ring to be formed include the same as those of the ring formed by A₁ and A₂, and the ring to be formed may have a substituent. Examples of the substituent include the same as those of the substituent which the aromatic residue represented by Y1, Y2 or Y3 may have.

In Formula (2), A₄ and A₅ are preferably each independently a hydrogen atom or an aliphatic hydrocarbon residue, and more preferably a hydrogen atom.

In Formula (3), n2 represents an integer of 1 to 5, preferably 1 to 4, still more preferably 1.

In Formula (3), A₆ and A₇ each independently represent a hydrogen atom, a carboxyl group, a cyano group, a phosphoric acid group, a sulfonic acid group or an aromatic residue, or A₆ and A₇ may be linked to each other to form a ring.

Specific examples of the aromatic residue represented by A₆ or A₇ include the same as those of the aromatic residue represented by Y₁, Y₂ or Y₃. The aromatic residue may have a substituent, and examples of the substituent include the same as those of the substituent which the aromatic residue represented by Y1, Y2 or Y3 may have.

The aromatic residue represented by A₆ or A₇ preferably includes an aromatic residue having at least one substituent selected from the group consisting of a carboxyl group, a hydroxyl group, a phosphoric acid group, a sulfonic acid group, and a salt thereof, and more preferably a group represented by any one of Formulas (1001) to (1033), as mentioned above.

The ring formed by A₆ and A₇ includes an aromatic ring and a heterocyclic ring, which may have a substituent.

Specific examples of the aromatic ring formed by A₆ and A₇ include the same as the specific examples to describe the aromatic residue represented by Y1, Y2 or Y3. Further, examples of the substituent which the ring formed by A₆ and A₇ may have include the same as those of the substituent which the aromatic residue represented by Y1, Y2 or Y3 may have.

The heterocyclic ring formed by A₆ and A₇ include a 4- to 7-membered heterocyclic ring containing a heteroatom such as S, N and O, preferably a ring represented by any one of Formulas (2001) to (2017), more preferably a ring represented by any one of Formula (2007) or (2012), and still more preferably a ring represented by Formula (2007). When the heterocyclic ring formed by A₆ and A₇ is represented by any one of Formulas (2001) to (2017), the mark * in Formulas (2001) to (2017) represents a carbon atom to which both of A₆ and A₇ are linked in Formula (3).

In Formula (3), preferably A₆ and A₇ are each independently a carboxyl group or a cyano group, more preferably one of A₆ and A₇ is a carboxyl group and the other is a carboxyl group or a cyano group, and still more preferably one of A₆ and A₇ is a carboxyl group and the other is a cyano group.

In Formula (3), A₈ each independently represents a hydrogen atom, an aliphatic hydrocarbon residue, a halogen atom or an alkoxyl group. Examples of the aliphatic hydrocarbon residue, the halogen atom and the alkoxyl group represented by A₈ include the same as those of the aliphatic hydrocarbon residue, the halogen atom and the alkoxyl group which the aromatic residue represented by Y1, Y2 or Y3 may have as a substituent.

In Formula (3), preferably A₈ is each independently a hydrogen atom or an aliphatic hydrocarbon residue, and more preferably a hydrogen atom.

In Formula (3), A₉ and A₁₀ each independently represent a hydrogen atom, an aliphatic hydrocarbon residue, a halogen atom and an alkoxyl group. When n2 is two or more so that the number of A₉ and the number of A₁₀ are each two or more, one of the A₉ substituents may be the same as or different from another thereof and one of the A₁₀ substituents may be the same as or different from another thereof. Examples of the aliphatic hydrocarbon residue, the halogen atom and the alkoxyl group represented by A₉ or A₁₀ include the same as those of the aliphatic hydrocarbon residue, the halogen atom and the alkoxyl group which the aromatic residue represented by Y1, Y2 or Y3 may have as a substituent.

Alternatively, A₉ and A₁₀ may be linked to each other to form a ring. Examples of the ring to be formed include the same as those of the ring formed by A₁ and A₂, and the ring to be formed may have a substituent. Examples of the substituent include the same as those of the substituent which the aromatic residue represented by Y1, Y2 or Y3 may have.

In Formula (3), preferably A₉ and A₁₀ each independently represent a hydrogen atom or an aliphatic hydrocarbon residue, more preferably A₉ is a hydrogen atom and A₁₀ is an aliphatic hydrocarbon residue, and still more preferably A₉ is a hydrogen atom and A₁₀ is an n-hexyl group.

In Formula (3), Q₁ represents an oxygen atom, a sulfur atom or a selenium atom. When n2 is two or more so that the number of Q₁ is two or more, one of the Q₁ atoms may be the same as or different from another thereof.

In Formula (3), Q₁ is preferably an oxygen atom or a sulfur atom, and more preferably a sulfur atom.

In Formula (4), n3 represents an integer of 0 to 5, preferably 1 to 4, and more preferably 1.

In Formula (4), A₁₁ and A₁₂ each independently represent a hydrogen atom, an aliphatic hydrocarbon residue, a halogen atom or an alkoxyl group. When n3 is two or more so that the number of A₁₁ and the number of A₁₂ are each two or more, one of the A₁₁ substituents may be the same as or different from another thereof and one of the A₁₂ substituents may be the same as or different from another thereof. Examples of the aliphatic hydrocarbon residue, the halogen atom and the alkoxyl group represented by A₁₁ or A₁₂ include the same as those of the aliphatic hydrocarbon residue, the halogen atom and the alkoxyl group which the aromatic residue represented by Y1, Y2 or Y3 may have as a substituent.

Alternatively, A₁₁ and A₁₂ may be linked to each other to form a ring. Examples of the ring to be formed include the same as those of the ring formed by A₁ and A₂, and the ring to be formed may have a substituent. Examples of the substituent include the same as those of the substituent which the aromatic residue represented by Y1, Y2 or Y3 may have.

In Formula (4), preferably A₁₁ and A₁₂ are each independently a hydrogen atom or an aliphatic hydrocarbon residue, more preferably A₁₁ is a hydrogen atom and A₁₂ is an aliphatic hydrocarbon residue, and still more preferably A₁₁ is a hydrogen atom and A₁₂ is an n-hexyl group.

In Formula (4), Q₂ represents an oxygen atom, a sulfur atom or a selenium atom. When n3 is two or more so that the number of Q₂ are two or more, one of the Q₂ atoms may be the same as or different from another thereof.

In Formula (4), Q₂ is preferably an oxygen atom or a sulfur atom, and more preferably a sulfur atom.

In Formulas (2) to (4), the mark * represents a binding site with the aromatic ring Ar₁ and/or Ar₂.

In Formula (1) and Formulas (2) to (4), a preferred combination of m1, M, Y₁ to Y₃, Z₁ and Z₂, Ar₁ and Ar₂, X₁, n1 to n3, A₁ to R₁₁, and Q₁ and Q₂ is a combination of the preferred ones each in the above, and a more preferred combination thereof is a combination of the still more preferred ones each in the above.

The compound of the present invention preferably has a structure represented by Formula (5).

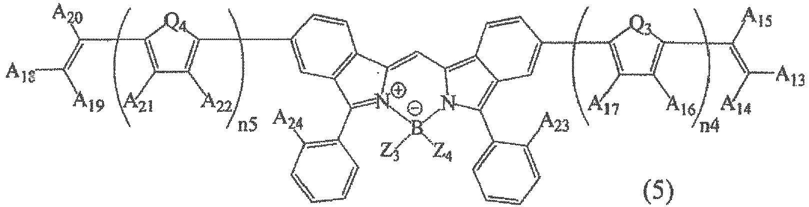

In Formula (5), Z₃ and Z₄ each independently represent halogen atoms, and examples of the halogen atom include the same as those the halogen atom which the aromatic residue represented by Y1, Y2 or Y3 may have as a substituent.

In Formula (5), Z₃ and Z₄ are preferably each a fluorine atom.

In Formula (5), n4 represents an integer of 0 to 5, preferably 1 to 4, and more preferably 1.

In Formula (5), Q₃ represents an oxygen atom, a sulfur atom or a selenium atom. When n4 is two or more so that the number of Q₃ is two or more, one of the Q₃ atoms may be the same as or different from another thereof.

In Formula (5), Q₃ is preferably an oxygen atom or a sulfur atom, and more preferably a sulfur atom.

In Formula (5), A₁₃ and A₁₄ each independently represent a hydrogen atom, a carboxyl group, a cyano group, a phosphoric acid group, a sulfonic acid group or an aromatic residue. Alternatively, A₁₃ and A₁₄ may be linked to each other to form a ring.

Specific examples of the aromatic residue represented by A₁₃ or A₁₄ include the same as those of the aromatic residue represented by Y₁, Y₂ or Y₃. The aromatic residue may have a substituent, and examples of the substituent include the same as those of the substituent which the aromatic residue represented by Y1, Y2 or Y3 may have.

The aromatic residue represented by A₁₃ or A₁₄ are preferably an aromatic residue having at least one substituent selected from the group consisting of a carboxyl group, a hydroxyl group, a phosphoric acid group, a sulfonic acid group, and a salt thereof, and more preferably a group represented by any one of Formulas (1001) to (1033), mentioned above.

The ring formed by A₁₃ and A₁₄ include an aromatic ring and a heterocyclic ring, which may have a substituent.

The aromatic ring formed by A₁₃ and A₁₄ include the same as the specific examples to describe the aromatic residue represented by Y1, Y2 or Y3. Examples of the substituent which the ring formed by A₁₃ and A₁₄ may have include the same as those of the substituent which the aromatic residue represented by Y1, Y2 or Y3 may have.

The heterocyclic ring formed by A₁₃ and A₁₄ preferably include a 4- to 7-membered heterocyclic ring containing a hetero atom, more preferably a ring represented by any one of Formulas (2001) to (2017), more preferably a ring represented by Formula (2007) or (2012), and still more preferably a ring represented by Formula (2007). When the heterocyclic ring formed by A₁₃ and A₁₄ is represented by any one of Formulas (2001) to (2017), the mark * in Formulas (2001) to (2017) represents a carbon atom to which both of A₁₃ and A₁₄ are linked in formula (5).

In Formula (5), preferably A₁₃ and A₁₄ are each independently a carboxyl group or a cyano group, more preferably one of A₁₃ and A₁₄ is a carboxyl group and the other is a carboxyl group or a cyano group, and still more preferably one of A₁₃ and A₁₄ is a carboxyl group and the other is a cyano group.

In Formula (5), A₁₅ represents a hydrogen atom, an aliphatic hydrocarbon residue, a halogen atom or an alkoxyl group. Examples of the aliphatic hydrocarbon residue, the halogen atom and the alkoxyl group represented by A₁₅ include the same as those of the aliphatic hydrocarbon residue, the halogen atom and the alkoxyl group which the aromatic residue represented by Y1, Y2 or Y3 may have as a substituent.

In Formula (5), A₁₅ is preferably a hydrogen atom or an aliphatic hydrocarbon residue, and more preferably a hydrogen atom.

In Formula (5), A₁₆ and A₁₇ each independently represent a hydrogen atom, an aliphatic hydrocarbon residue, a halogen atom or an alkoxyl group. When n4 is two or more so that the number of A₁₆ and the number of A₁₇ are each two or more, one of the A₁₆ substituents may be the same as or different from another thereof and one of the A₁₇ substituents may be the same as or different from another thereof. Examples of the aliphatic hydrocarbon residue, the halogen atom and the alkoxyl group represented by A₁₆ or A₁₇ include the same as those of the aliphatic hydrocarbon residue, the halogen atom and the alkoxyl group which the aromatic residue represented by Y1, Y2 or Y3 may have as a substituent.

Alternatively, A₁₆ and A₁₇ may be linked to each other to form a ring. Examples of the ring to be formed include the same as those of the ring formed by A₁ and A₂, and the ring to be formed may have a substituent. Examples of the substituent include the same as those of the substituent which the aromatic residue represented by Y1, Y2 or Y3 may have.

In Formula (5), preferably A₁₆ and A₁₇ each independently are a hydrogen atom or an aliphatic hydrocarbon residue, more preferably A₁₆ is a hydrogen atom and A₁₇ is an aliphatic hydrocarbon residue, and still more preferably A₁₆ is a hydrogen atom and A₁₇ is an n-hexyl group.

In Formula (5), n5 represents an integer of 0 to 5, preferably 1 to 4, and more preferably 1.

In Formula (5), Q₄ represents an oxygen atom, a sulfur atom, or a selenium atom. When n5 is two or more so that the number of Q₄ is two or more, one of the Q₄ atoms may be the same as or different from another thereof.

In Formula (5), Q₄ is preferably an oxygen atom or a sulfur atom, and more preferably a sulfur atom.

In Formula (5), A₁₈ and A₁₉ each independently represent a hydrogen atom, a carboxyl group, a cyano group, a phosphoric acid group, a sulfonic acid group or an aromatic residue, or A₁₈ and A₁₉ may be linked to each other to form a ring.

Specific examples of the aromatic residue represented by A₁₈ or A₁₉ include the same as those of the aromatic residue represented by Y₁, Y₂ or Y₃. The aromatic residue may have a substituent, and examples of the substituent include the same as those of the substituent which the aromatic residue represented by Y1, Y2 or Y3 may have.

The aromatic residue represented by A₁₈ or A₁₉ is preferably an aromatic residue having at least one substituent selected from the group consisting of a carboxyl group, a hydroxyl group, a phosphoric acid group, a sulfonic acid group, and a salt thereof, and more preferably a group represented by any one of Formulas (1001) to (1033), mentioned above.

The ring formed by A₁₈ and A₁₉ includes an aromatic ring and a heterocyclic ring, which may have a substituent.

Specific examples of the aromatic ring formed by A₁₈ and A₁₉ include the same as the specific examples to describe the aromatic residue represented by Y1, Y2 or Y3. Examples of the substituent which the ring formed by A₁₈ and A₁₉ may have include the same as those of the substituent which the aromatic residue represented by Y1, Y2 or Y3 may have.

The heterocyclic ring formed by A₁₈ and A₁₉ includes a 4- to 7-membered heterocyclic ring containing a heteroatom such as S, N and O, preferably a ring represented by any one of Formulas (2001) to (2017), more preferably a ring represented by Formula (2007) or (2012), and still more preferably a ring represented by Formula (2007). When the heterocyclic ring formed by A₁₈ and A₁₉ is represented by any one of Formulas (2001) to (2017), the mark * in Formulas (2001) to (2017) represents a carbon atom to which both of A₁₈ and A₁₉ are linked in Formula (5).

In Formula (5), preferably A₁₈ and A₁₉ are each independently a carboxyl group or a cyano group, more preferably one of A₁₈ and A₁₉ is a carboxyl group and the other is a carboxyl group or a cyano group, and still more preferably one of A₁₈ and A₁₉ is a carboxyl group and the other is a cyano group.

In Formula (5), A₂₀ represents a hydrogen atom, an aliphatic hydrocarbon residue, a halogen atom or an alkoxyl group. Examples of the aliphatic hydrocarbon residue, the halogen atom and the alkoxyl group represented by A₂₀ include the same as those of the aliphatic hydrocarbon residue, the halogen atom and the alkoxyl group which the aromatic residue represented by Y1, Y2 or Y3 may have as a substituent.

In Formula (5), preferably A₂₀ is a hydrogen atom or an aliphatic hydrocarbon residue, and more preferably a hydrogen atom.

In Formula (5), A₂₁ and A₂₂ each independently represent a hydrogen atom, an aliphatic hydrocarbon residue, a halogen atom or an alkoxyl group. When n5 is two or more so that the number of A₂₁ and the number of A₂₂ are each two or more, one of the A₂₁ substituents may be the same as or different from another thereof and one of the A₂₂ substituents may be the same as or different from another thereof. Examples of the aliphatic hydrocarbon residue, the halogen atom and the alkoxyl group represented by A₂₁ or A₂₂ include the same as those of the aliphatic hydrocarbon residue, the halogen atom and the alkoxyl group which the aromatic residue represented by Y1, Y2 or Y3 may have as a substituent.

Alternatively, A₂₁ and A₂₂ may be linked to each other to form a ring. Examples of the ring to be formed include the same as those of the ring formed by A₁ and A₂, and the ring to be formed may have a substituent. Examples of the substituent include the same as those of the substituent which the aromatic residue represented by Y1, Y2 or Y3 may have.

In Formula (5), preferably A₂₁ and A₂₂ are each independently a hydrogen atom or an aliphatic hydrocarbon residue, more preferably A₂₁ is a hydrogen atom and A₂₂ is an aliphatic hydrocarbon residue, and still more preferably A₂₁ is a hydrogen atom and A₂₂ is an n-hexyl group.

In Formula (5), A₂₃ and A₂₄ each independently represent a hydrogen atom, a halogen atom, an aliphatic hydrocarbon residue or an alkoxyl group. Examples of the halogen atom, the aliphatic hydrocarbon residue and the alkoxyl group represented by A₂₃ or A₂₄ include the same as those the aliphatic hydrocarbon residue, the halogen atom and the alkoxyl group which the aromatic residue represented by Y1, Y2 or Y3 may have as a substituent.

In Formula (5), A₂₃ and A₂₄ are preferably each independently a hydrogen atom, an aliphatic hydrocarbon residue or an alkoxyl group, more preferably an alkoxyl group, still more preferably an alkoxyl group having 1 to 4 carbon atoms, and particularly preferably a methoxy group.

Among the compounds represented by Formula (5), preferred is a compound of the formula wherein Z₃ and Z₄ are each a fluorine atom, n4 and n5 are each an integer of 1, Q₃ and Q₄ are each a sulfur atom, one of A₁₃ and A₁₄ is a carboxyl group and the other is a cyano group, one of A₁₈ and A₁₉ is a carboxyl group and the other is a cyano group, A₁₅ and A₂₀ are each a hydrogen atom, A₁₆ and A₂₁ are each a hydrogen atom, A₁₇ and A₂₂ are each an n-hexyl group, and A₂₃ and A₂₄ are each a methoxy group.

Meanwhile, a compound represented by Formula (5) has a substituent represented by Formula (3) at the fifth position of each of the two indole rings in Formula (5), but a compound of the present invention can preferably have a substituent represented by Formula (3) at the sixth position of each of the indole rings.

A compound of the present invention also preferably has a structure represented by Formula (6).

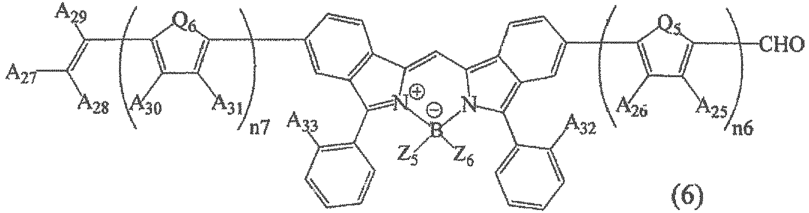

In Formula (6), Z₅ and Z₆ each independently represent a halogen atom. Examples of the halogen atom include the same as those of the halogen atom which the aromatic residue represented by Y1, Y2 or Y3 may have as a substituent.

In Formula (6), Z₅ and Z₆ are each preferably a fluorine atom.

In Formula (6), n6 represents an integer of 0 to 5, preferably 1 to 4, and more preferably 1.

In Formula (6), Q₅ represents an oxygen atom, a sulfur atom or a selenium atom. When n6 is two or more so that the number of Q₅ is two or more, one of the Q₅ atoms may be the same as or different from another thereof.

In Formula (6), Q₅ is preferably an oxygen atom or a sulfur atom, and more preferably a sulfur atom.

In Formula (6), A₂₅ and A₂₆ each independently represent a hydrogen atom, an aliphatic hydrocarbon residue, a halogen atom or an alkoxyl group. When n6 is two or more so that the number of A₂₅ and the number of A₂₆ are each two or more, one of the A₂₅ substituents may be the same as or different from another thereof and one of the A₂₆ substituents may be the same as or different from another thereof. Examples of the aliphatic hydrocarbon residue, the halogen atom and the alkoxyl group represented by A₂₅ or A₂₆ include the same as those of the aliphatic hydrocarbon residue, the halogen atom and the alkoxyl group which the aromatic residue represented by Y1, Y2 or Y3 may have as a substituent.

Alternatively, A₂₅ and A₂₆ may be linked to each other to form a ring. Examples of the ring to be formed include the same as those of the ring formed by A₁ and A₂, and the ring to be formed may have a substituent. Examples of the substituent include the same as those the substituent which the aromatic residue represented by Y1, Y2 or Y3 may have.

In Formula (6), preferably A₂₅ and A₂₆ are each independently a hydrogen atom or an aliphatic hydrocarbon residue, more preferably A₂₅ is a hydrogen atom and A₂₆ is an aliphatic hydrocarbon residue, and still more preferably A₂₅ is a hydrogen atom and A₂₆ is an n-hexyl group.

In Formula (6), n7 represents an integer of 0 to 5, preferably 1 to 4, and more preferably 1.

In Formula (6), Q₆ represents an oxygen atom, a sulfur atom or a selenium atom. When n7 is two or more so that the number of Q₆ is two or more, one of the Q₆ atoms may be the same as or different from another thereof.

In Formula (6), Q₆ is preferably an oxygen atom or a sulfur atom, and more preferably a sulfur atom.

In Formula (6), A₂₇ and A₂₈ each independently represent a hydrogen atom, a carboxyl group, a cyano group, a phosphoric acid group, a sulfonic acid group or an aromatic residue, or A₂₇ and A₂₈ may be linked to each other to form a ring.

Specific examples of the aromatic residue represented by A₂₇ or A₂₈ include the same as those of the aromatic residue represented by Y₁, Y₂ or Y₃. The aromatic residue may have a substituent, and examples of the substituent include the same as those of the substituent which the aromatic residue represented by Y1, Y2 or Y3 may have.

The aromatic residue represented by A₂₇ or A₂₈ is preferably an aromatic residue having at least one substituent selected from the group consisting of a carboxyl group, a hydroxyl group, a phosphoric acid group, a sulfonic acid group, and a salt thereof, and more preferably a group represented by any of Formulas (1001) to (1033), mentioned above.

The ring formed by A₂₇ and A₂₈ includes an aromatic ring and a heterocyclic ring, which may have a substituent.

Specific examples of the aromatic ring formed by A₂₇ and A₂₈ include the same as the specific examples to describe the aromatic residue represented by Y1, Y2 or Y3. Examples of the substituent which the ring formed by A₂₇ and A₂₈ may have, include the same as those of the substituent which the aromatic residue represented by Y1, Y2 or Y3 may have.

The heterocyclic ring formed by A₂₇ and A₂₈ includes a 4- to 7-membered heterocyclic ring containing a heteroatom such as S, N and O, preferably a ring represented by any one of Formulas (2001) to (2017), more preferably a ring represented by Formula (2007) or (2012), and still more preferably a ring represented by Formula (2007). When the heterocyclic ring formed by A₂₇ and A₂₈ is represented by any one of Formulas (2001) to (2017), the mark * in Formulas (2001) to (2017) represents a carbon atom to which both of A₂₇ and A₂₈ are linked in formula (6).

In Formula (6), preferably A₂₇ and A₂₈ are each independently a carboxyl group or a cyano group, more preferably one of A₂₇ and A₂₈ is a carboxyl group and the other is a carboxyl group or a cyano group, and still more preferably one of A₂₇ and A₂₈ is a carboxyl group and the other is a cyano group.

In Formula (6), A₂₉ represents a hydrogen atom, an aliphatic hydrocarbon residue, a halogen atom or an alkoxyl group. Examples of the aliphatic hydrocarbon residue, the halogen atom and the alkoxyl group represented by A₂₉ include the same as those of the aliphatic hydrocarbon residue, the halogen atom and the alkoxyl group which the aromatic residue represented by Y1, Y2 or Y3 may have as a substituent.

In Formula (6), A₂₉ is preferably a hydrogen atom or an aliphatic hydrocarbon residue, and more preferably a hydrogen atom.

In Formula (6), A₃₀ and A₃₁ each independently represent a hydrogen atom, an aliphatic hydrocarbon residue, a halogen atom or an alkoxyl group. When n7 is two or more so that the number of A₃₀ and the number of A₃₁ are each two or more, one of the A₃₀ substituents may be the same as or different from another thereof and one of the A₃₁ substituents may be the same as or different from another thereof. Examples of the aliphatic hydrocarbon residue, the halogen atom and the alkoxyl group represented by A₃₀ or A₃₁ include the same as those of the aliphatic hydrocarbon residue, the halogen atom and the alkoxyl group which the aromatic residue represented by Y1, Y2 or Y3 may have as a substituent.

Alternatively, A₃₀ and A₃₁ may be linked to each other to form a ring. Examples of the ring to be formed include the same as those of the ring formed by A₁ and A₂, and the ring to be formed may have a substituent. Examples of the substituent include the same as those of the substituent which the aromatic residue represented by Y1, Y2 or Y3 may have.

In Formula (6), preferably A₃₀ and A₃₁ are each independently a hydrogen atom or an aliphatic hydrocarbon residue, more preferably A₃₀ is a hydrogen atom and A₃₁ is an aliphatic hydrocarbon residue, and still more preferably A₃₀ is a hydrogen atom and A₃₁ is an n-hexyl group.

In Formula (6), A₃₂ and A₃₃ each independently represent a hydrogen atom, a halogen atom, an aliphatic hydrocarbon residue or an alkoxyl group. Examples of the halogen atom, the aliphatic hydrocarbon residue and the alkoxyl group represented by A₃₂ or A₃₃ include the same as those of the aliphatic hydrocarbon residue, the halogen atom and the alkoxyl group which the aromatic residue represented by Y1, Y2 or Y3 may have as a substituent.

In Formula (6), A₃₂ and A₃₃ are preferably each independently a hydrogen atom, an aliphatic hydrocarbon residue or an alkoxyl group, more preferably an alkoxyl group, still more preferably an alkoxyl group having 1 to 4 carbon atoms, and particularly preferably a methoxy group.

Among the compounds represented by Formula (6), preferred are a compound of the formula wherein Z₅ and Z₆ are each a fluorine atom, n6 and n7 are each an integer of 1, Q₅ and Q₆ are each a sulfur atom, A₂₅, A₂₉ and A₃₀ are each a hydrogen atom, A₂₆ and A₃₁ are each an n-hexyl group, one of A₂₇ and A₂₈ is a carboxyl group and the other is a cyano group, and A₃₂ and A₃₃ are each a methoxy group.

Meanwhile, a compound represented by Formula (6) has substituents represented by Formulas (3) and (4) respectively at each of the fifth positions of the two indole rings in Formula (6), but a compound of the present invention can also preferably have substituents represented by Formulas (3) and (4) at each of the sixth positions of the indole rings.

A compound of the present invention can also preferably has a structure represented by Formula (9).

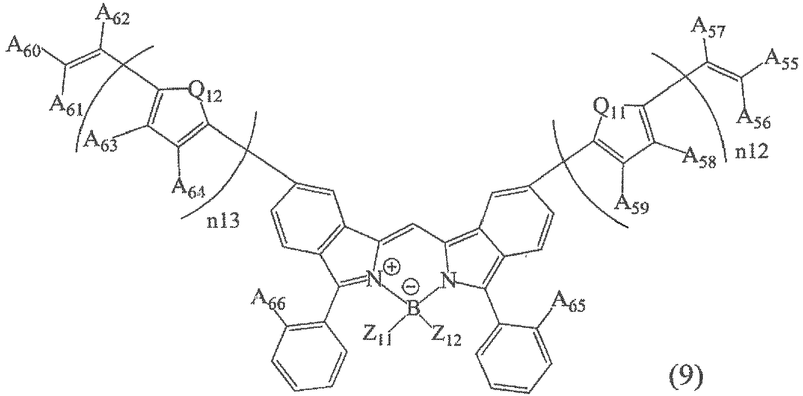

In Formula (9), Z₁₁ and Z₁₂ each independently represent a halogen atom. Examples of the halogen atom include the same as those of the halogen atom which the aromatic residue represented by Y1, Y2 or Y3 may have as a substituent.

In Formula (9), Z₁₁ and Z₁₂ are each preferably a fluorine atom.

In Formula (9), n12 represents an integer of 0 to 5, preferably 1 to 4, and more preferably 1.

In Formula (9), Q₁₁ represents an oxygen atom, a sulfur atom or a selenium atom. When n12 is two or more so that the number of Q₁₁ is two or more, one of the Q₁₁ atoms may be the same as or different from another thereof.

In Formula (9), Q₁₁ is preferably an oxygen atom or a sulfur atom, and more preferably a sulfur atom.

In Formula (9), A₅₅ and A₅₆ each independently represent a hydrogen atom, a carboxyl group, a cyano group, a phosphoric acid group, a sulfonic acid group or an aromatic residue, or A₅₅ and A₅₆ may be linked to each other to form a ring.

Specific examples of the aromatic residue represented by A₅₅ or A₅₆ include the same as those of the aromatic residue represented by Y₁, Y₂ or Y₃. The aromatic residue may have a substituent, and examples of the substituent include the same as those of the substituent which the aromatic residue represented by Y1, Y2 or Y3 may have.

The aromatic residue represented by A₅₅ or A₅₆ is preferably an aromatic residue having at least one substituent selected from the group consisting of a carboxyl group, a hydroxyl group, a phosphoric acid group, a sulfonic acid group, and a salt thereof, and more preferably a group represented by any of Formulas (1001) to (1033), mentioned above.

The ring formed by A₅₅ and A₅₆ includes an aromatic ring and a heterocyclic ring, which may have a substituent.

Specific examples of the aromatic ring formed by A₅₅ and A₅₆ include the same as the specific examples to describe the aromatic residue represented by Y1, Y2 or Y3. Examples of the substituent which the ring formed by A₅₅ and A₅₆ may have, include the same as those of the substituent which the aromatic residue represented by Y1, Y2 or Y3 may have.

The heterocyclic ring formed by A₅₅ and A₅₆ includes a 4- to 7-membered heterocyclic ring containing a heteroatom such as S, N and O, preferably a ring represented by any one of Formulas (2001) to (2017), more preferably a ring represented by Formula (2007) or (2012), and still more preferably a ring represented by Formula (2007). When the heterocyclic ring formed by A₅₅ and A₅₆ is represented by any one of Formulas (2001) to (2017), the mark * in Formulas (2001) to (2017) represents a carbon atom to which both of A₅₅ and A₅₆ are linked in formula (9).

In Formula (9), preferably A₅₅ and A₅₆ are each independently a carboxyl group or a cyano group, more preferably one of A₅₅ and A₅₆ is a carboxyl group and the other is a carboxyl group or a cyano group, and still more preferably one of A₅₅ and A₅₆ is a carboxyl group and the other is a cyano group.

In Formula (9), A₅₇ represents a hydrogen atom, an aliphatic hydrocarbon residue, a halogen atom or an alkoxyl group. Examples of the aliphatic hydrocarbon residue, the halogen atom and the alkoxyl group represented by A₅₇ include the same as those of the aliphatic hydrocarbon residue, the halogen atom and the alkoxyl group which the aromatic residue represented by Y1, Y2 or Y3 may have as a substituent.

In Formula (9), A₅₇ is preferably a hydrogen atom or an aliphatic hydrocarbon residue, and more preferably a hydrogen atom.

In Formula (9), A₅₈ and A₅₉ each independently represent a hydrogen atom, an aliphatic hydrocarbon residue, a halogen atom or an alkoxyl group. When n12 is two or more so that the number of A₅₈ and the number of A₅₉ are each two or more, one of the A₅₈ substituents may be the same as or different from another thereof and one of the A₅₉ substituents may be the same as or different from another thereof. Examples of the aliphatic hydrocarbon residue, the halogen atom and the alkoxyl group represented by A₅₈ or A₅₉ include the same as those of the aliphatic hydrocarbon residue, the halogen atom and the alkoxyl group which the aromatic residue represented by Y1, Y2 or Y3 may have as a substituent.

Alternatively, A₅₈ and A₅₉ may be linked to each other to form a ring. Examples of the ring to be formed include the same as those of the ring formed by A₁ and A₂, and the ring to be formed may have a substituent. Examples of the substituent include the same as those of the substituent which the aromatic residue represented by Y1, Y2 or Y3 may have.

In Formula (9), preferably A₅₈ and A₅₉ are each independently a hydrogen atom or an aliphatic hydrocarbon residue, more preferably A₅₈ is a hydrogen atom and A₅₉ is an aliphatic hydrocarbon residue, and still more preferably A₅₈ is a hydrogen atom and A₅₉ is an n-hexyl group.

In Formula (9), n13 represents an integer of 0 to 5, preferably 1 to 4, and more preferably 1.

In Formula (9), Q₁₂ represents an oxygen atom, a sulfur atom or a selenium atom. When n13 is two or more so that the number of Q₁₂ is two or more, one of the Q₁₂ atoms may be the same as or different from another thereof.

In Formula (9), Q₁₂ is preferably an oxygen atom or a sulfur atom, and more preferably a sulfur atom.

In Formula (9), A₆₀ and A₆₁ each independently represent a hydrogen atom, a carboxyl group, a cyano group, a phosphoric acid group, a sulfonic acid group or an aromatic residue, or A₆₀ and A₆₁ may be linked to each other to form a ring.

Specific examples of the aromatic residue represented by A₆₀ or A₆₁ include the same as those of the aromatic residue represented by Y₁, Y₂ or Y₃. The aromatic residue may have a substituent, and examples of the substituent include the same as those of the substituent which the aromatic residue represented by Y1, Y2 or Y3 may have.

The aromatic residue represented by A₆₀ or A₆₁ is preferably an aromatic residue having at least one substituent selected from the group consisting of a carboxyl group, a hydroxyl group, a phosphoric acid group, a sulfonic acid group, and a salt thereof, and more preferably a group represented by any of Formulas (1001) to (1033), mentioned above.

The ring formed by A₆₀ and A₆₁ includes an aromatic ring and a heterocyclic ring, which may have a substituent.

Specific examples of the aromatic ring formed by A₆₀ and A₆₁ include the same as the specific examples to describe the aromatic residue represented by Y1, Y2 or Y3. Examples of the substituent which the ring formed by A₆₀ and A₆₁ may have, include the same as those of the substituent which the aromatic residue represented by Y1, Y2 or Y3 may have.

The heterocyclic ring formed by A₆₀ and A₆₁ includes a 4- to 7-membered heterocyclic ring containing a heteroatom such as S, N and O, preferably a ring represented by any one of Formulas (2001) to (2017), more preferably a ring represented by Formula (2007) or (2012), and still more preferably a ring represented by Formula (2007). When the heterocyclic ring formed by A₆₀ and A₆₁ is represented by any one of Formulas (2001) to (2017), the mark * in Formulas (2001) to (2017) represents a carbon atom to which both of A₆₀ and A₆₁ are linked in formula (9).

In Formula (9), preferably A₆₀ and A₆₁ are each independently a carboxyl group or a cyano group, more preferably one of A₆₀ and A₆₁ is a carboxyl group and the other is a carboxyl group or a cyano group, and still more preferably one of A₆₀ and A₆₁ is a carboxyl group and the other is a cyano group.

In Formula (9), A₆₂ represents a hydrogen atom, an aliphatic hydrocarbon residue, a halogen atom or an alkoxyl group. Examples of the aliphatic hydrocarbon residue, the halogen atom and the alkoxyl group represented by A₆₂ include the same as those of the aliphatic hydrocarbon residue, the halogen atom and the alkoxyl group which the aromatic residue represented by Y1, Y2 or Y3 may have as a substituent.

In Formula (9), A₆₂ is preferably a hydrogen atom or an aliphatic hydrocarbon residue, and more preferably a hydrogen atom.

In Formula (9), A₆₃ and A₆₄ each independently represent a hydrogen atom, an aliphatic hydrocarbon residue, a halogen atom or an alkoxyl group. When n13 is two or more so that the number of A₆₃ and the number of A₆₄ are each two or more, one of the A₆₃ substituents may be the same as or different from another thereof and one of the A₆₄ substituents may be the same as or different from another thereof. Examples of the aliphatic hydrocarbon residue, the halogen atom and the alkoxyl group represented by A₆₃ or A₆₄ include the same as those of the aliphatic hydrocarbon residue, the halogen atom and the alkoxyl group which the aromatic residue represented by Y1, Y2 or Y3 may have as a substituent.

Alternatively, A₆₃ and A₆₄ may be linked to each other to form a ring. Examples of the ring to be formed include the same as those of the ring formed by A₁ and A₂, and the ring to be formed may have a substituent. Examples of the substituent include the same as those of the substituent which the aromatic residue represented by Y1, Y2 or Y3 may have.

In Formula (9), preferably A₆₃ and A₆₄ are each independently a hydrogen atom or an aliphatic hydrocarbon residue, more preferably A₆₃ is a hydrogen atom and A₆₄ is an aliphatic hydrocarbon residue, and still more preferably A₆₃ is a hydrogen atom and A₆₄ is an n-hexyl group.

In Formula (9), A₆₅ and A₆₆ each independently represent a hydrogen atom, a halogen atom, an aliphatic hydrocarbon residue or an alkoxyl group. Examples of the halogen atom, the aliphatic hydrocarbon residue and the alkoxyl group represented by A₆₅ or A₆₆ include the same as those of the aliphatic hydrocarbon residue, the halogen atom and the alkoxyl group which the aromatic residue represented by Y1, Y2 or Y3 may have as a substituent.

In Formula (9), A₆₅ and A₆₆ are preferably each independently a hydrogen atom, an aliphatic hydrocarbon residue or an alkoxyl group, more preferably an alkoxyl group, still more preferably an alkoxyl group having 1 to 4 carbon atoms, and particularly preferably a methoxy group.

Among the compounds represented by Formula (9), preferred are a compound of the formula wherein Z₁₁ and Z₁₂ are each a fluorine atom, n12 and n13 are each an integer of 1, Q₁₁ and Q₁₂ are each a sulfur atom, one of A₅₅ and A₅₆ is a carboxyl group and the other is a cyano group, one of A₆₀ and A₆₁ is a carboxyl group and the other is a cyano group, A₅₇ and A₆₂ are each a hydrogen atom, A₅₈ and A₆₃ are each a hydrogen atom, A₅₉ and A₆₄ are each an n-hexyl group, and A₆₅ and A₆₆ are each a methoxy group.

A compound of the present invention can also preferably have a structure represented by Formula (10).

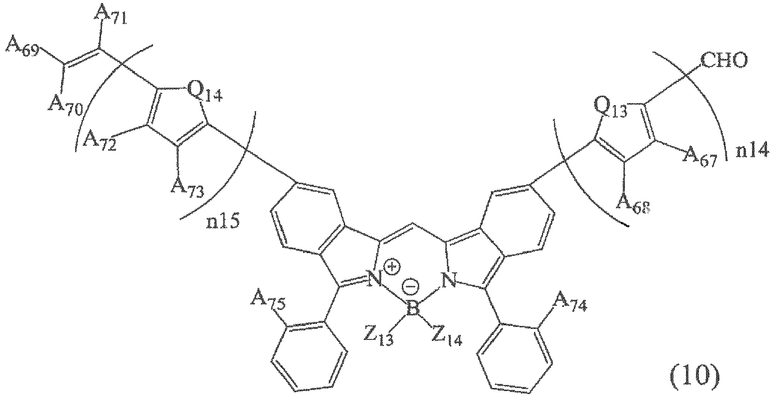

In Formula (10), Z₁₃ and Z₁₄ each independently represent a halogen atom. Examples of the halogen atom include the same as those of the halogen atom which the aromatic residue represented by Y1, Y2 or Y3 may have as a substituent.

In Formula (6), Z₁₃ and Z₁₄ are each preferably a fluorine atom.

In Formula (10), n14 represents an integer of 0 to 5, preferably 1 to 4, and more preferably 1.

In Formula (10), Q₁₃ represents an oxygen atom, a sulfur atom or a selenium atom. When n14 is two or more so that the number of Q₁₃ is two or more, one of the Q₁₃ atoms may be the same as or different from another thereof.

In Formula (10), Q₁₃ is preferably an oxygen atom or a sulfur atom, and more preferably a sulfur atom.

In Formula (10), A₆₇ and A₆₈ each independently represent a hydrogen atom, an aliphatic hydrocarbon residue, a halogen atom or an alkoxyl group. When n14 is two or more so that the number of A₆₇ and the number of A₆₈ are each two or more, one of the A₆₇ substituents may be the same as or different from another thereof and one of the A₆₈ substituents may be the same as or different from another thereof. Examples of the aliphatic hydrocarbon residue, the halogen atom and the alkoxyl group represented by A₆₇ or A₆₈ include the same as those of the aliphatic hydrocarbon residue, the halogen atom and the alkoxyl group which the aromatic residue represented by Y1, Y2 or Y3 may have as a substituent.

Alternatively, A₆₇ and A₆₈ may be linked to each other to form a ring. Examples of the ring to be formed include the same as those of the ring formed by A₁ and A₂, and the ring to be formed may have a substituent. Examples of the substituent include the same as those of the substituent which the aromatic residue represented by Y1, Y2 or Y3 may have.

In Formula (10), preferably A₆₇ and A₆₈ are each independently a hydrogen atom or an aliphatic hydrocarbon residue, more preferably A₆₇ is a hydrogen atom and A₆₈ is an aliphatic hydrocarbon residue, and still more preferably A₆₇ is a hydrogen atom and A₆₈ is an n-hexyl group.

In Formula (10), n15 represents an integer of 0 to 5, preferably 1 to 4, and more preferably 1.

In Formula (10), Q₁₄ represents an oxygen atom, a sulfur atom or a selenium atom. When n15 is two or more so that the number of Q₁₄ is two or more, one of the Q₁₄ atoms may be the same as or different from another thereof.

In Formula (10), Q₁₄ is preferably an oxygen atom or a sulfur atom, and more preferably a sulfur atom.

In Formula (10), A₆₉ and A₇₀ each independently represent a hydrogen atom, a carboxyl group, a cyano group, a phosphoric acid group, a sulfonic acid group or an aromatic residue, or A₆₉ and A₇₀ may be linked to each other to form a ring.

Specific examples of the aromatic residue represented by A₆₉ or A₇₀ include the same as those of the aromatic residue represented by Y₁, Y₂ or Y₃. The aromatic residue may have a substituent, and examples of the substituent include the same as those of the substituent which the aromatic residue represented by Y1, Y2 or Y3 may have.

The aromatic residue represented by A₆₉ or A₇₀ is preferably an aromatic residue having at least one substituent selected from the group consisting of a carboxyl group, a hydroxyl group, a phosphoric acid group, a sulfonic acid group, and a salt thereof, and more preferably a group represented by any of Formulas (1001) to (1033), mentioned above.

The ring formed by A₆₉ and A₇₀ includes an aromatic ring and a heterocyclic ring, which may have a substituent.

Specific examples of the aromatic ring formed by A₆₉ and A₇₀ include the same as the specific examples to describe the aromatic residue represented by Y1, Y2 or Y3. Examples of the substituent which the ring formed by A₆₉ and A₇₀ may have, include the same as those of the substituent which the aromatic residue represented by Y1, Y2 or Y3 may have.

The heterocyclic ring formed by A₆₉ and A₇₀ includes a 4- to 7-membered heterocyclic ring containing a heteroatom such as S, N and O, preferably a ring represented by any one of Formulas (2001) to (2017), more preferably a ring represented by Formula (2007) or (2012), and still more preferably a ring represented by Formula (2007). When the heterocyclic ring formed by A₆₉ A₆₉ and A₇₀ is represented by any one of Formulas (2001) to (2017), the mark * in Formulas (2001) to (2017) represents a carbon atom to which both of A₆₉ A₆₉ and A₇₀ are linked in formula (10).

In Formula (10), preferably A₆₉ A₆₉ and A₇₀ are each independently a carboxyl group or a cyano group, more preferably one of A₆₉ and A₇₀ is a carboxyl group and the other is a carboxyl group or a cyano group, and still more preferably one of A₆₉ A₆₉ and A₇₀ is a carboxyl group and the other is a cyano group.

In Formula (10), A₇₁ represents a hydrogen atom, an aliphatic hydrocarbon residue, a halogen atom or an alkoxyl group. Examples of the aliphatic hydrocarbon residue, the halogen atom and the alkoxyl group represented by A₇₁ include the same as those of the aliphatic hydrocarbon residue, the halogen atom and the alkoxyl group which the aromatic residue represented by Y1, Y2 or Y3 may have as a substituent.

In Formula (10), A₇₁ is preferably a hydrogen atom or an aliphatic hydrocarbon residue, and more preferably a hydrogen atom.

In Formula (10), A₇₂ and A₇₃ each independently represent a hydrogen atom, an aliphatic hydrocarbon residue, a halogen atom or an alkoxyl group. When n 15 is two or more so that the number of A₇₂ and the number of A₇₃ are each two or more, one of the A₇₂ substituents may be the same as or different from another thereof and one of the A₇₃ substituents may be the same as or different from another thereof. Examples of the aliphatic hydrocarbon residue, the halogen atom and the alkoxyl group represented by A₇₂ or A₇₃ include the same as those of the aliphatic hydrocarbon residue, the halogen atom and the alkoxyl group which the aromatic residue represented by Y1, Y2 or Y3 may have as a substituent.

Alternatively, A₇₂ and A₇₃ may be linked to each other to form a ring. Examples of the ring to be formed include the same as those of the ring formed by A₁ and A₂, and the ring to be formed may have a substituent. Examples of the substituent include the same as those of the substituent which the aromatic residue represented by Y1, Y2 or Y3 may have.

In Formula (10), preferably A₇₂ and A₇₃ are each independently a hydrogen atom or an aliphatic hydrocarbon residue, more preferably A₇₂ is a hydrogen atom and A₇₃ is an aliphatic hydrocarbon residue, and still more preferably A₇₂ is a hydrogen atom and A₇₃ is an n-hexyl group.

In Formula (10), A₇₄ and A₇₅ each independently represent a hydrogen atom, a halogen atom, an aliphatic hydrocarbon residue or an alkoxyl group. Examples of the halogen atom, the aliphatic hydrocarbon residue and the alkoxyl group represented by A₇₄ or A₇₅ include the same as those of the aliphatic hydrocarbon residue, the halogen atom and the alkoxyl group which the aromatic residue represented by Y1, Y2 or Y3 may have as a substituent.

In Formula (10), A₇₄ and A₇₅ are preferably each independently a hydrogen atom, an aliphatic hydrocarbon residue or an alkoxyl group, more preferably an alkoxyl group, still more preferably an alkoxyl group having 1 to 4 carbon atoms, and particularly preferably a methoxy group.

Among the compounds represented by Formula (10), preferred are a compound of the formula wherein Z₁₃ and Z₁₄ are each a fluorine atom, n14 and n15 are each an integer of 1, Q₁₃ and Q₁₄ are each a sulfur atom, A₆₇, A₇₁ and A₇₂ are each a hydrogen atom, A₆₈ and A₇₃ are each an n-hexyl group, one of A₆₉ and A₇₀ is a carboxyl group and the other is a cyano group, and A₇₄ and A₇₅ are each a methoxy group.

A compound represented by Formula (1) of the present invention can be obtained by, for example, synthesizing an intermediate compound according to the method for synthesizing Compound No. 2 set forth in Scheme 1 of Non Patent Literature 3 and introducing a substituent presented by X₁ into the intermediate compound by formylation, cross-coupling or the like.

A specific reaction mechanism is described as follows. Raw material compounds a and b are reacted in a proper solvent such as alcohol so as to produce a compound c. The compound c is then treated with lead tetraacetate in a proper solvent such as tetrahydrofuran so as to produce a compound d (when aromatic rings Ar₁ and Ar₂ are different, raw material compounds e and f are reacted to produce a compound g, and then a compound h may be produced in the same way as described above). Subsequently ammonia water is added to a proper mixed solvent of alcohol and acetic acid containing the compound d to react the compound d at room temperature, thereby producing a compound i. When the aromatic rings Ar₁ and Ar₂ are different, the compound d and the compound h may be reacted. Subsequently, the compound i is reacted with boron trifluoride to produce a compound j. Further, the linkage of the compound j with a compound k is caused by cross-coupling or the like to produce a compound represented by Formula (1). On an as needed basis, Y₃ can be a substituent other than a hydrogen atom by substituting a hydrogen atom through a Grignard reaction or the like.

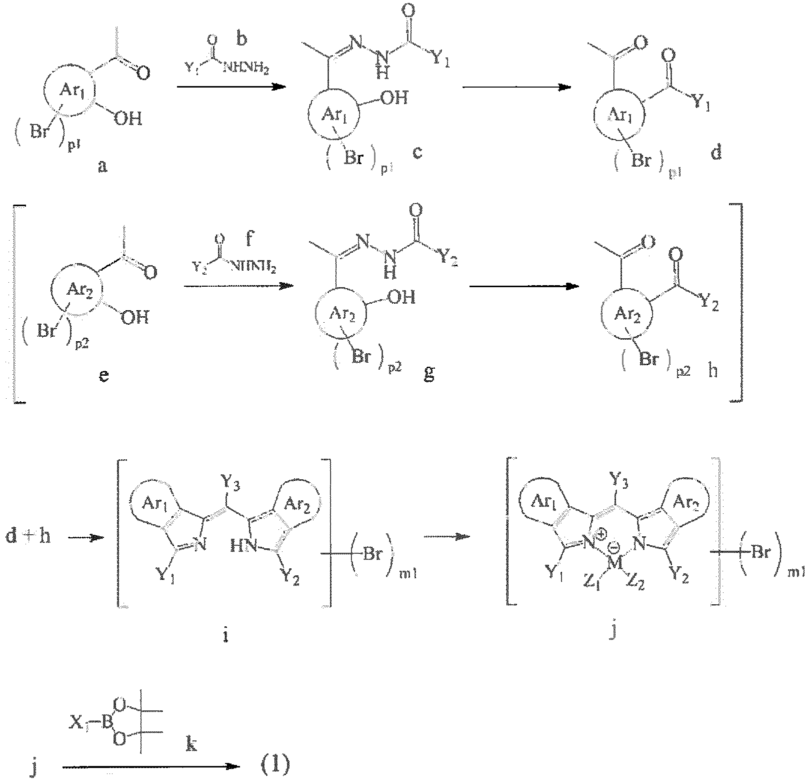

Specific examples of a compound represented by Formula (7) are as follows.

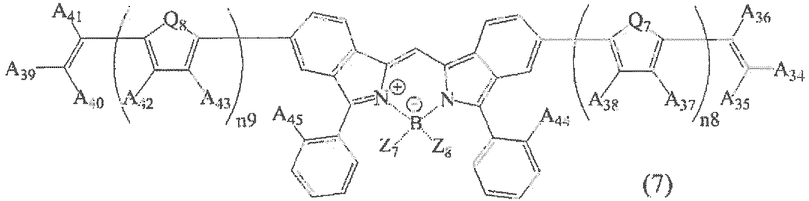

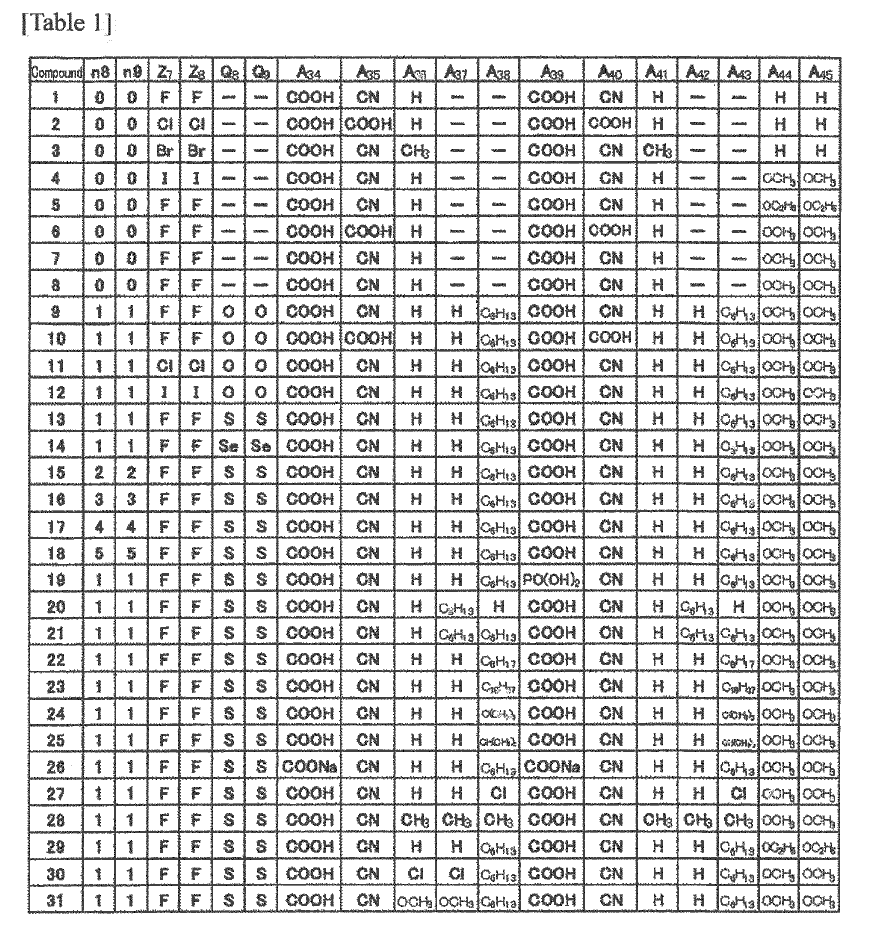

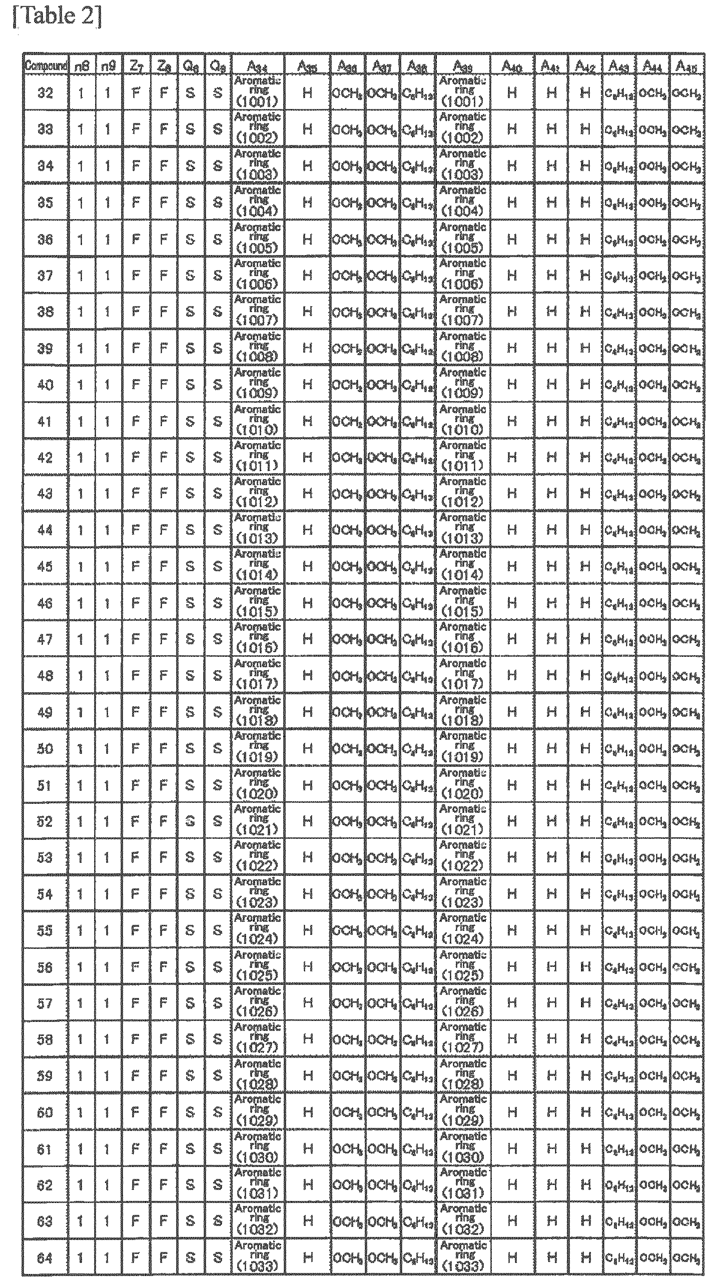

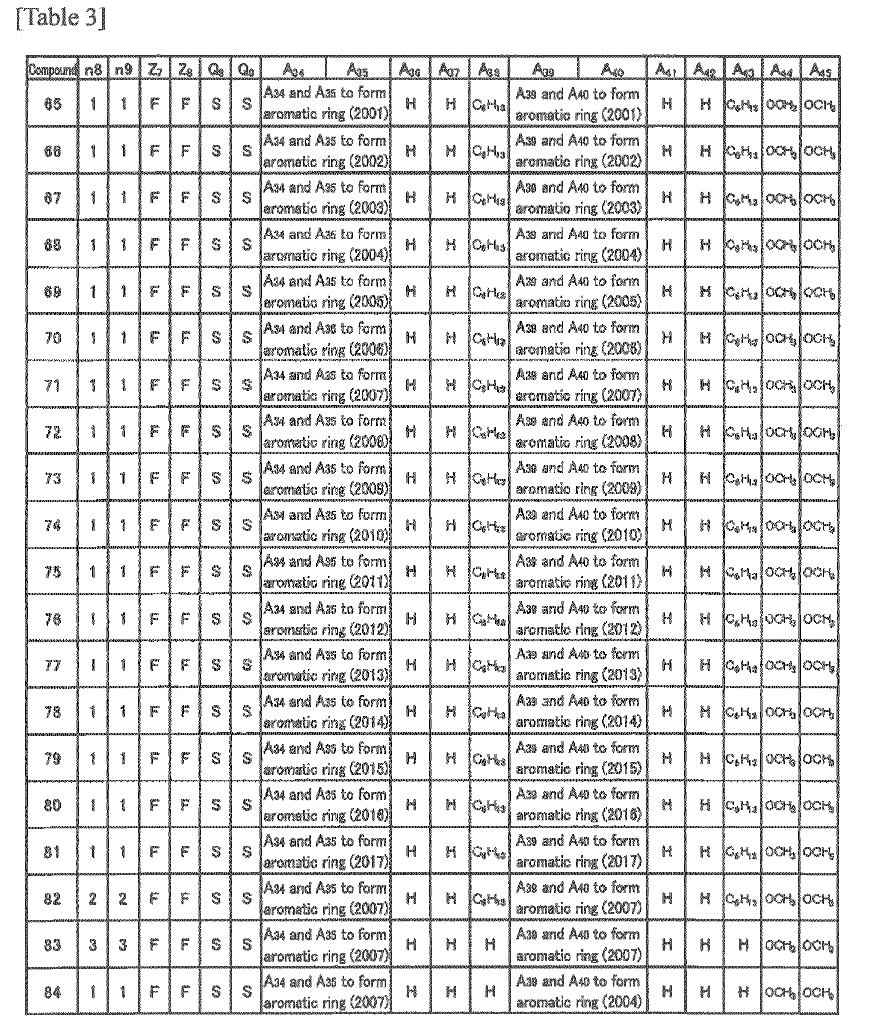

Specific examples of a compound represented by Formula (8) are as follows.

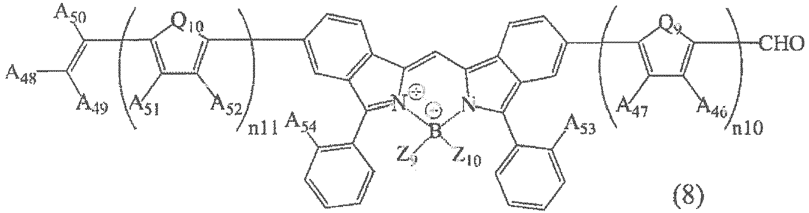

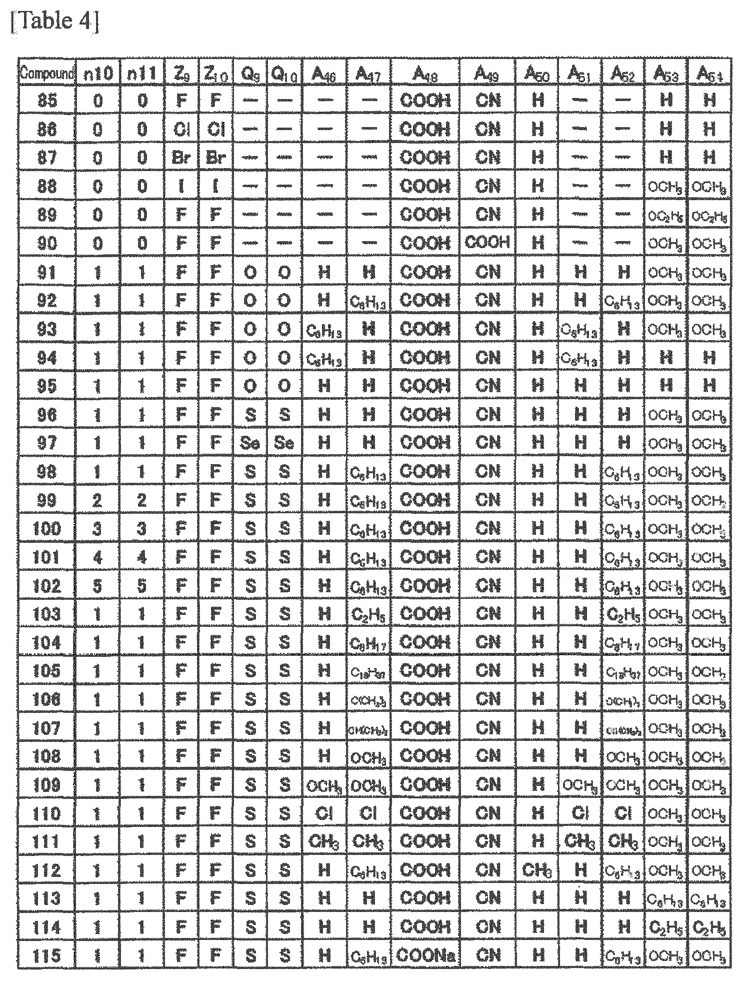

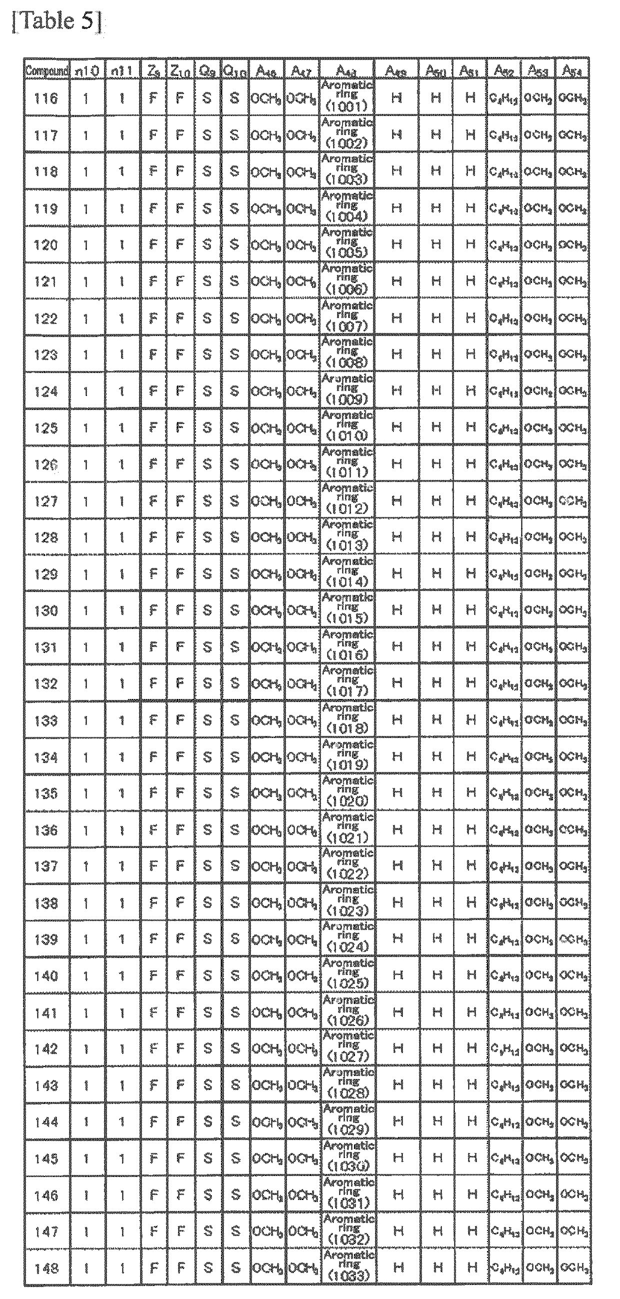

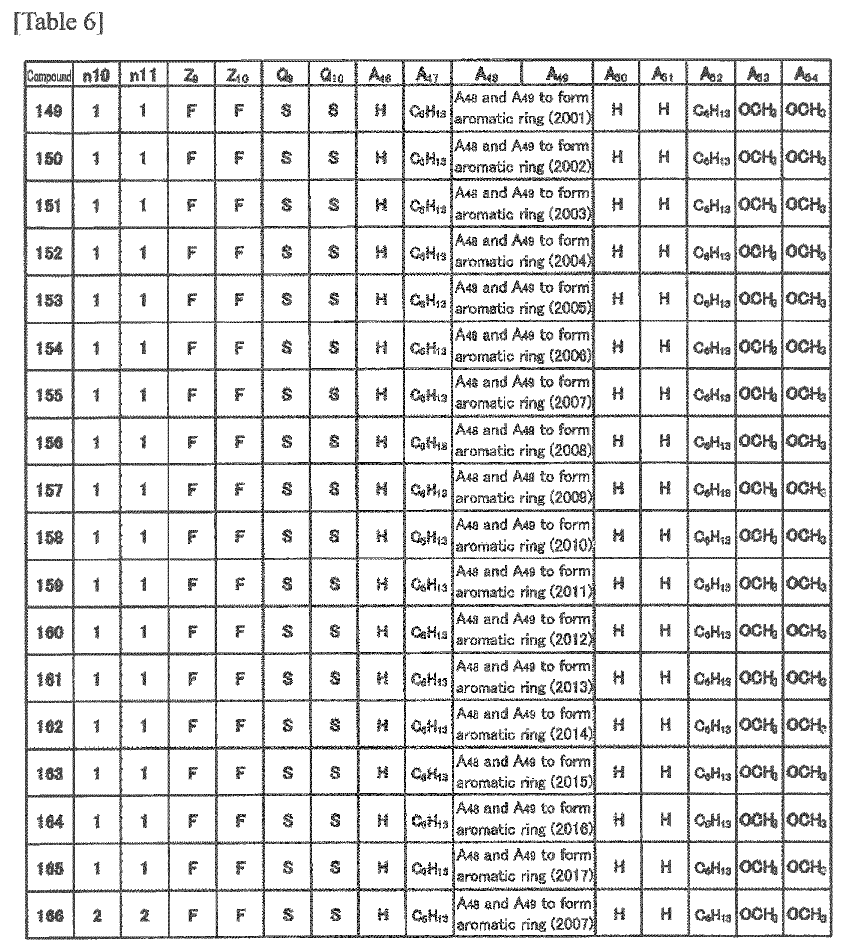

Specific examples of a compound represented by Formula (1) but not by Formula (7) or (8), are as follows.

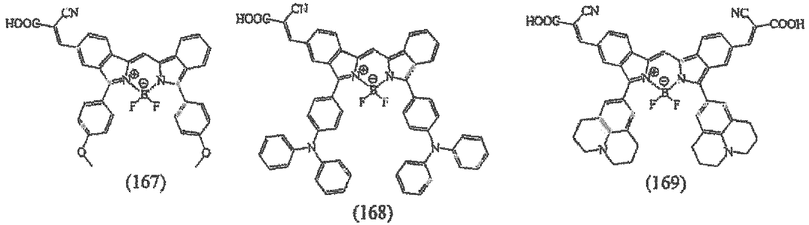

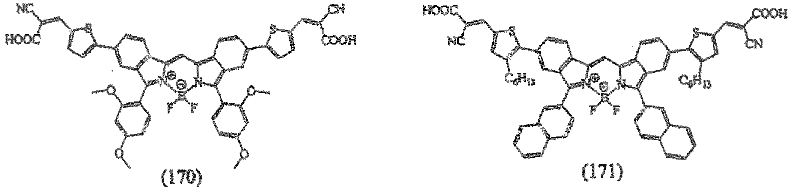

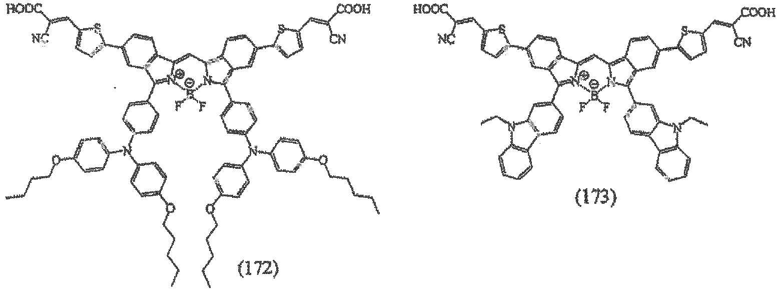

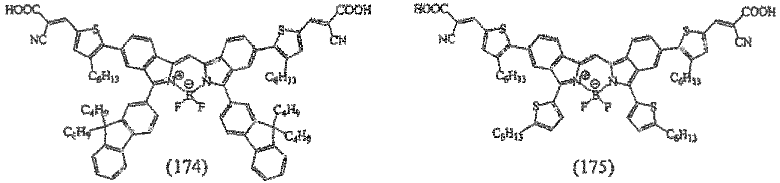

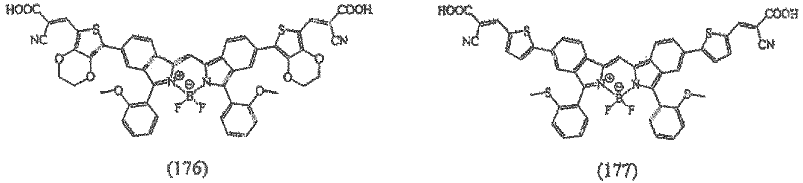

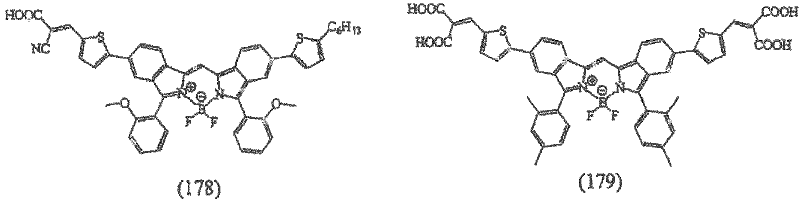

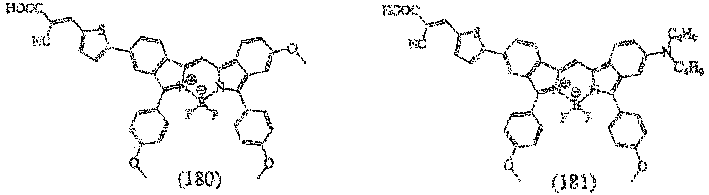

Specific examples of a compound represented by Formula (11) are as follows.

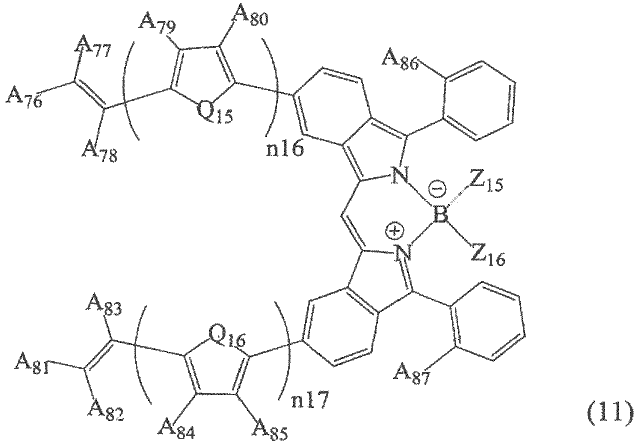

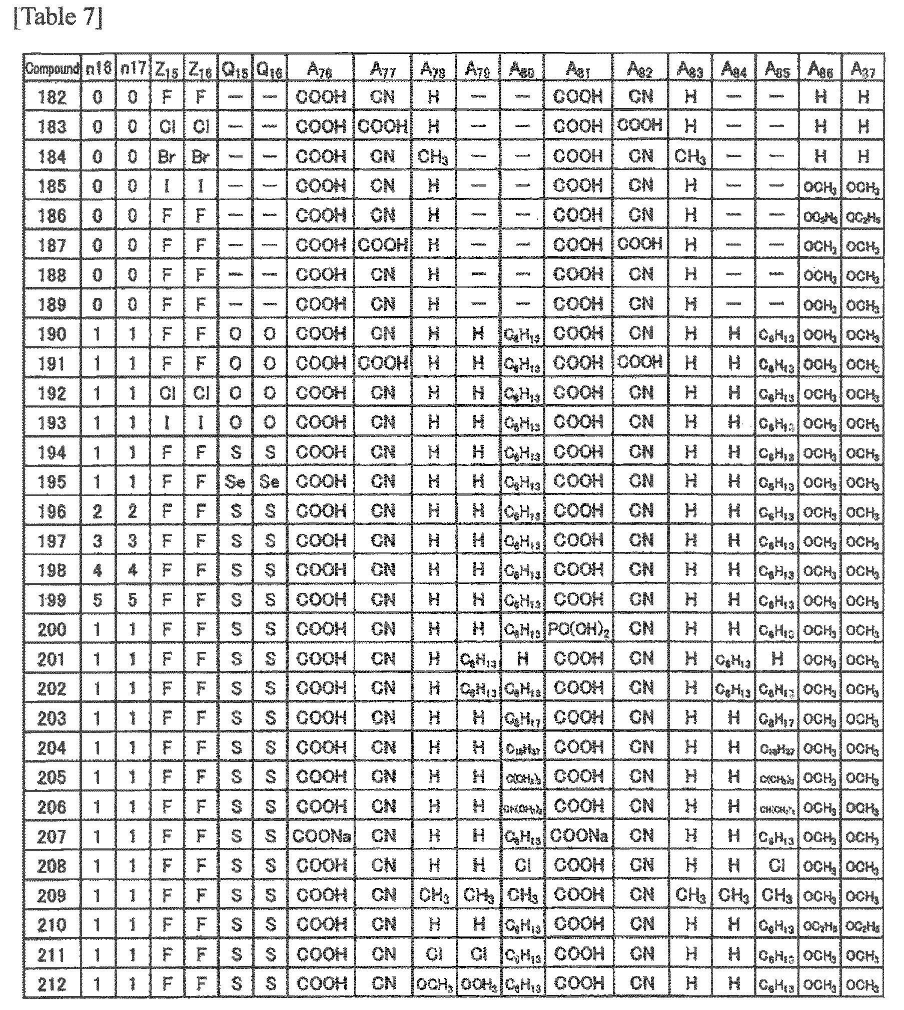

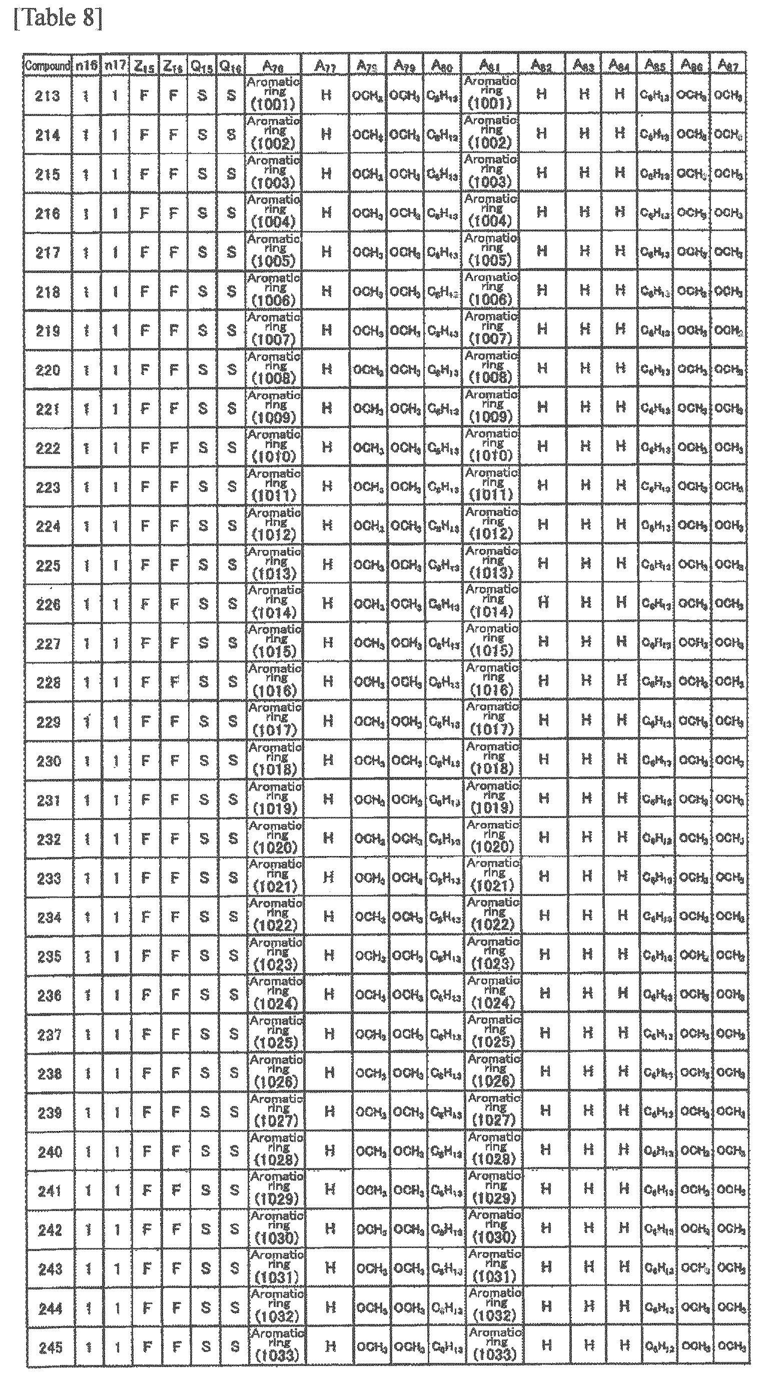

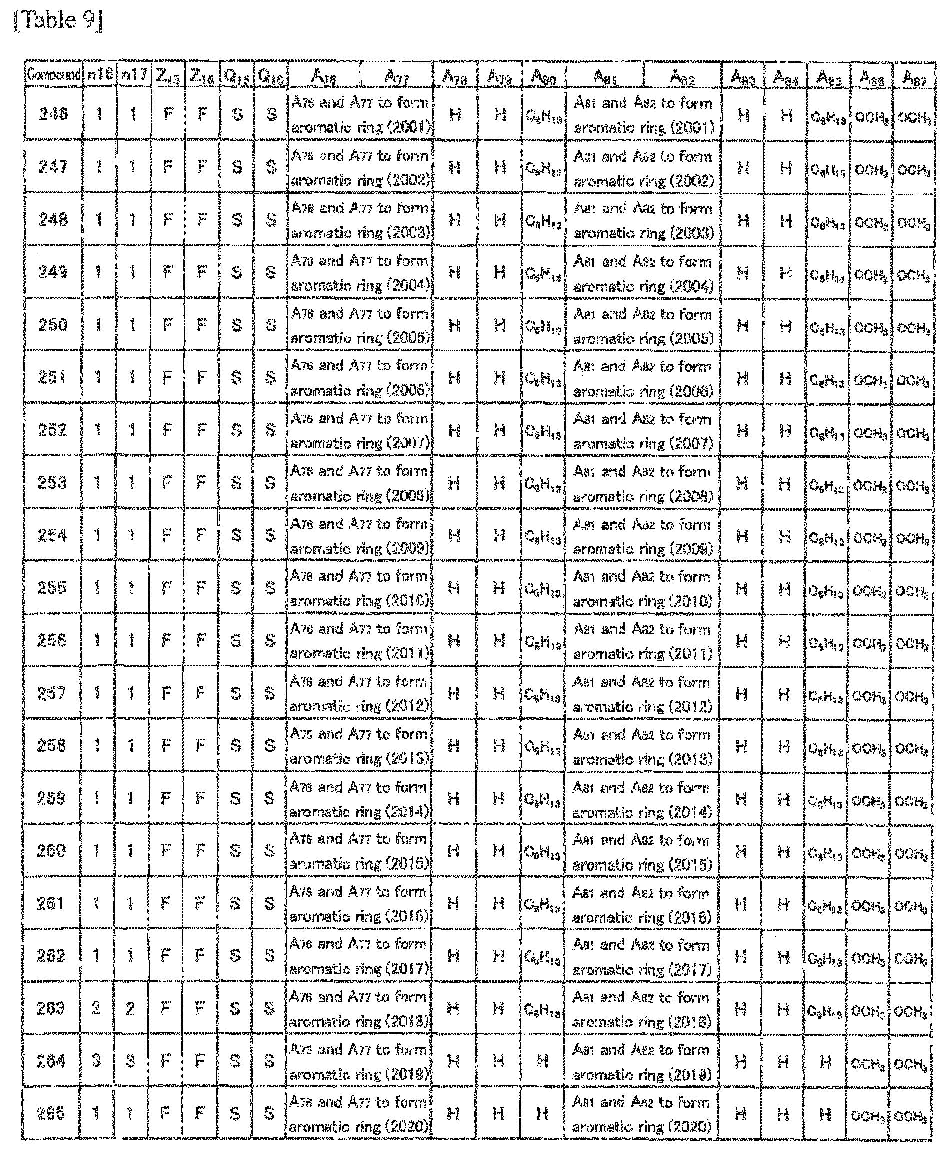

Specific examples of a compound represented by Formula (12) are as follows.

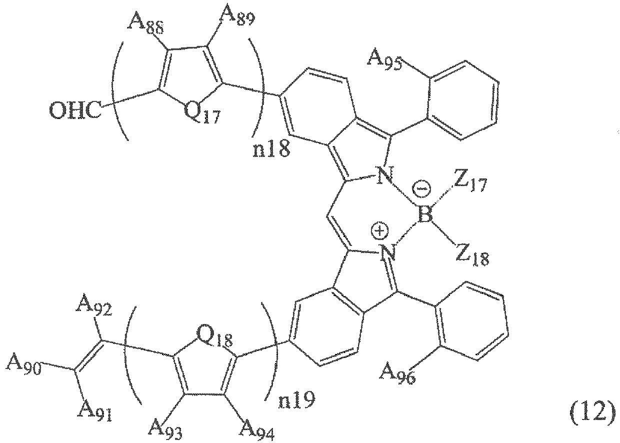

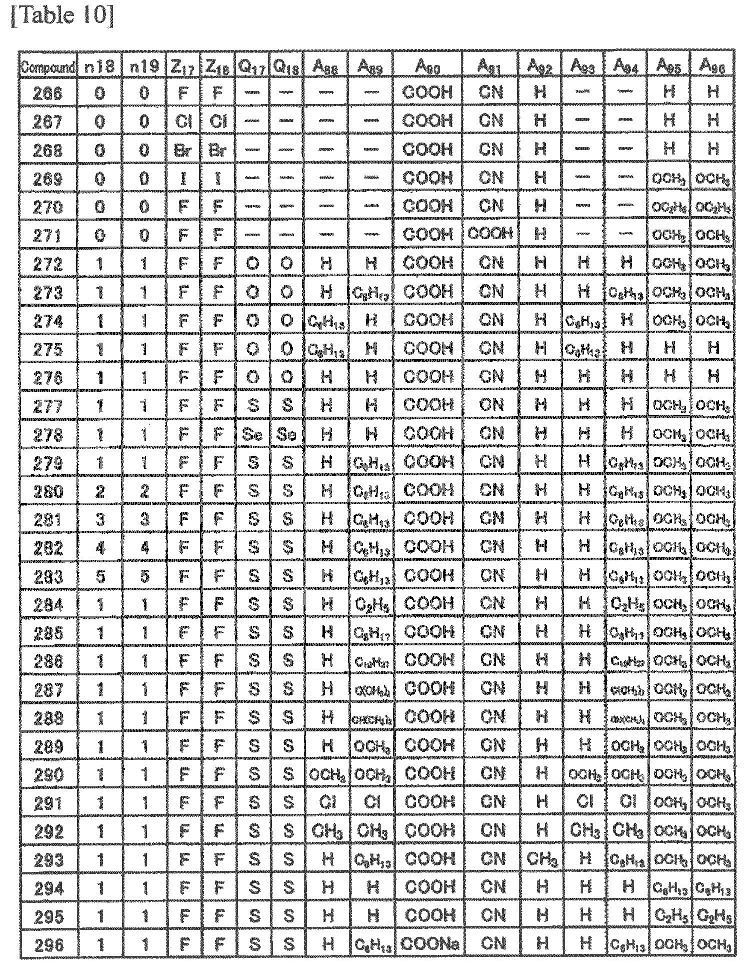

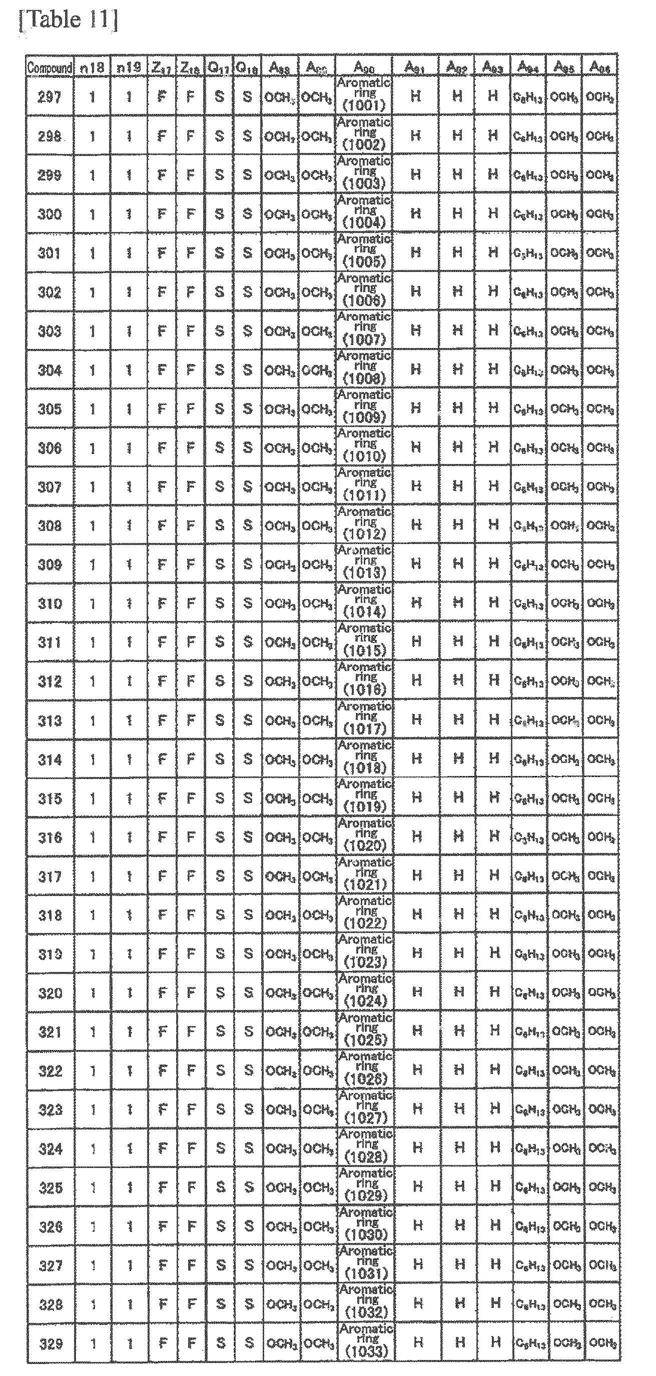

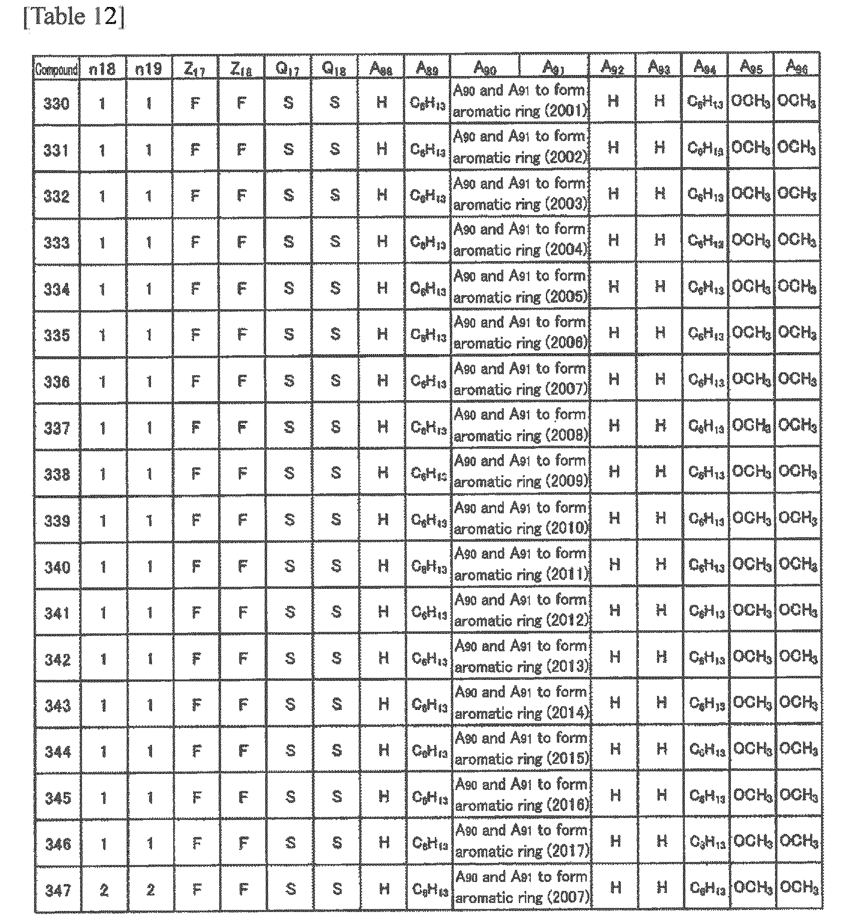

Specific examples of a compound represented by Formula (1) but not by Formula (11) or (12), are as follows.

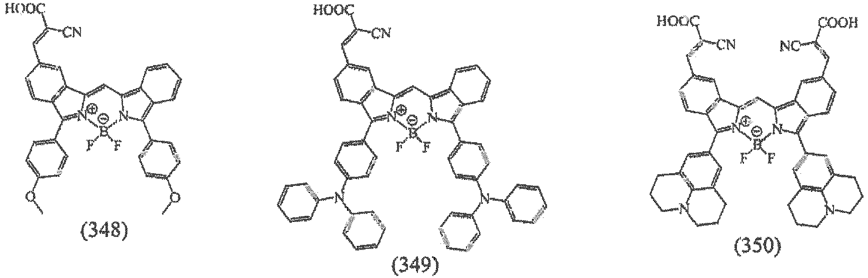

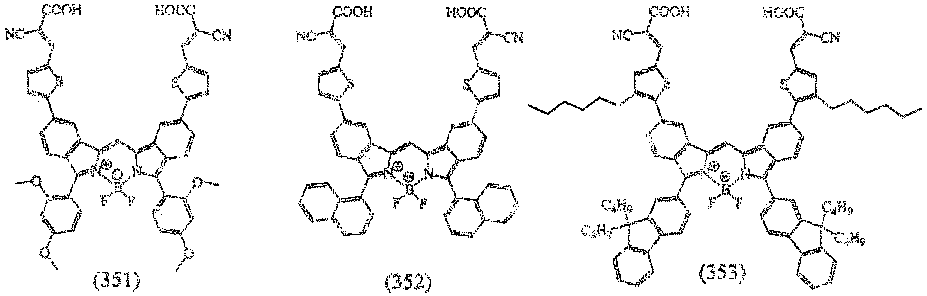

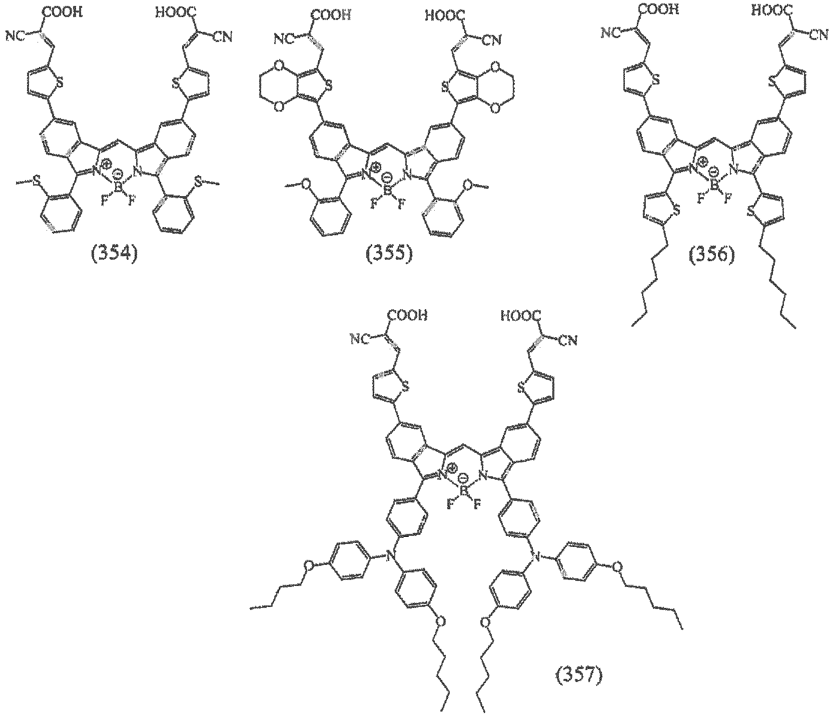

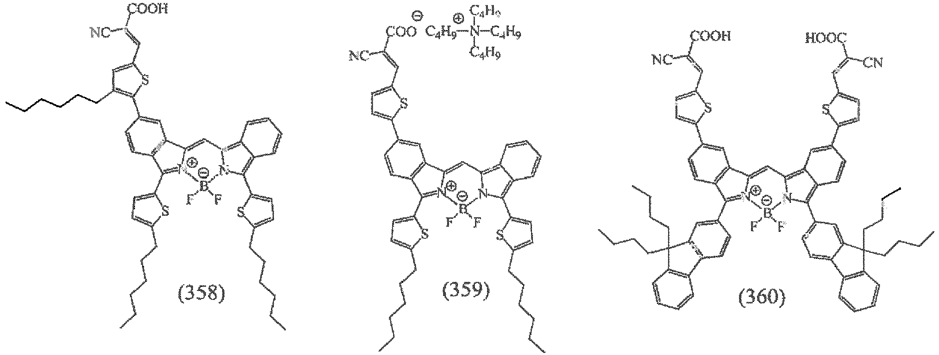

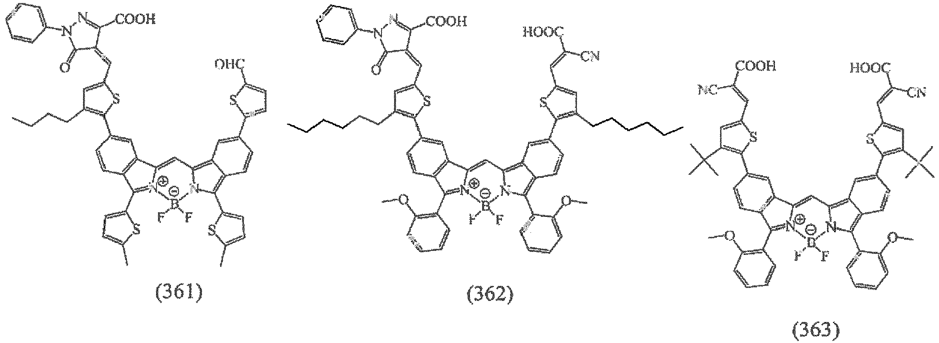

The compound represented by Formula (1) of the present invention can be carried by a thin film of oxide semiconductor fine particles formed on a substrate so as to make a photoelectric conversion element.

In the present invention, a substrate on which a thin film of oxide semiconductor fine particles is formed preferably has an electrically conductive surface, and such a substrate is easily available on the market. For example, a substrate of glass or transparent polymer material such as polyethylene terephthalate and polyether sulfone having, on the surface, a thin film of electrically conductive metal oxide such as tin oxide doped with indium, fluorine or antimony, or a thin film of metal such as copper, silver and gold, can be used. The conductivity may be typically 1000 Ω or less, and particularly preferably 100 Ω or less.

Metal oxides are preferred for the oxide semiconductor fine particles, and specific examples thereof include the oxides of titanium, tin, zinc, tungsten, zirconium, gallium, indium, yttrium, niobium, tantalum, vanadium, and the like. Among them, the oxides of titanium, tin, zinc, niobium, indium and the like are more preferred, and titanium oxide, zinc oxide, and tin oxide are most preferred. These oxide semiconductors may be used singly, or may be mixed or applied to the surface of a semiconductor to be coated. The oxide semiconductor fine particles have an average particle diameter of typically 1 to 500 nm, and preferably 1 to 100 nm. The oxide semiconductor fine particles having a large particle diameter and the oxide semiconductor fine particles having a small particle diameter may be mixed, or multi-layered.

A thin film of oxide semiconductor fine particles can be manufactured by: a method of directly spraying oxide semiconductor fine particles onto a substrate to form a thin film of semiconductor fine particles; a method of electrically depositing semiconductor fine particles in a thin film form on a substrate which functions as an electrode, and a method of applying a slurry of semiconductor fine particles or a paste containing fine particles obtained by hydrolysis of a precursor of semiconductor fine particles such as semiconductor alkoxide onto a substrate, and then drying, curing or firing the slurry or the paste. Due to the characteristics of the electrode using an oxide semiconductor, a method using slurry is preferred. In this method, the slurry is obtained by dispersing secondary aggregated oxide semiconductor fine particles into a dispersion medium so as to have an average primary particle diameter of 1 to 200 nm by a conventional method.

The dispersion medium for use in dispersing the slurry may be any medium as long as capable of dispersing the semiconductor fine particles. Water; alcohols such as ethanol; ketones such as acetone and acetylacetone; and hydrocarbons such as hexane can be used. These dispersion media may be mixed for use, and use of water is preferable from the view point of reducing the change in viscosity of the slurry. In order to stabilize the dispersion state of oxide semiconductor fine particles, a dispersion stabilizer may be used. Examples of the dispersion stabilizer for use include an acid such as acetic acid, hydrochloric acid and nitric acid, or organic solvents such as acetylacetone, acrylic acid, polyethylene glycol, and polyvinyl alcohol.

Substrate coated with the slurry may be fired at a firing temperature of typically 100°C or higher, preferably 200°C or higher, with an upper limit approximately at the melting point (softening point) of the substrate or lower, typically at 900°C, preferably at 600°C or lower. Preferably the firing time is approximately 4 hours or less, though not particularly limited thereto. The thickness of the thin film on a substrate is typically 1 to 200 µm, preferably 1 to 50 µm.

The thin film of oxide semiconductor fine particles may be subjected to a secondary treatment. For example, a whole thin film with a substrate may be directly immersed into a solution of an alkoxide, a chloride, a nitride, or a sulfide of the same metal as the semiconductor, and then dried or re-fired to improve the performance of the thin film of semiconductor fine particles. Examples of the metal alkoxide include titanium ethoxide, titanium isopropoxide, titanium t-butoxide, and n-dibutyl-diacetyl tin, and an alcohol solution thereof is used. Examples of the chloride include titanium tetrachloride, tin tetrachloride, and zinc chloride, and an aqueous solution thereof is used. The oxide semiconductor thin film thus obtained includes oxide semiconductor fine particles.

Subsequently, a method for supporting a compound of the present invention on the thin film of oxide semiconductor fine particles is described as follows. Examples of the supporting method include immersing a substrate with the thin film of oxide semiconductor fine particles into a solution of the compound dissolved in a solvent capable of dissolving the compound, or a dispersion liquid obtained by dispersing the compound when the compound has low solubility. The concentration in the solution or in the dispersion liquid may be appropriately determined depending on the film of compound to be supported of the present invention. The thin film of semiconductor fine particles formed on a substrate is immersed into the solution. The immersion temperature is in the approximate range from room temperature to the boiling point of the solvent, and the immersion time is in the approximate range from 1 minute to 48 hours. Specific examples of the solvents which can be used in dissolving or dispersing a compound of the present invention include methanol, ethanol, isopropanol, tetrahydrofuran (THF), acetonitrile, dimethylsulfoxide (DMSO), dimethylformamide (DMF), acetone, n-propanol, n-butanol, t-butanol, water, n-hexane, chloroform, dichloromethane, and toluene, which may be used singly or a plurality thereof may be mixed for use depending on the solubility and the like of the compound of the present invention. The compound concentration in a solution may be typically 1×10⁻⁶ M to 1 M, preferably 1×10⁻⁵ M to 1×10⁻¹ M. After immersion, the solvent is removed by air drying or by heating on an as needed basis. The photoelectric conversion element having a thin film of oxide semiconductor fine particles sensitized by the compound of the present invention is thus obtained.

One sensitizing dye compound to be supported of the present invention may be used alone or a plurality of kinds thereof may be mixed. In the case of mixing, the sensitizing dye compounds of the present invention may be mixed with each other, or the sensitizing dye compound of the present invention may be mixed with a sensitizing dye compound other than the compound of the present invention. In particular, mixing with a sensitizing dye compound having a different absorption wavelength allows a wide range of absorption wavelengths to be utilized, so that a solar cell having a high conversion efficiency can be obtained. Examples of the sensitizing dye compound other than the compound of the present invention which can be mixed include: a ruthenium complex and a quaternary ammonium salt compound thereof, phthalocyanine, porphyrin, metal-free phthalocyanine, porphyrin, cyanine, merocyanine, oxonol and triphenylmethane, which are described in Non Patent Literature 2; and an acrylic acid dye, xanthene, azo, anthraquinone, perylene and the like, which are described in Patent Literature 2; though not limited thereto. Among them, a ruthenium complex, merocyanine, an acrylic acid sensitizing dye compound and the like are preferred; a ruthenium complex and an acrylic acid sensitizing dye compound are more preferred; and a cyanoacetic acid sensitizing dye compound is particularly preferred. When a plurality of compounds including the compound of the present invention are used, each may be sequentially supported on a thin film of semiconductor fine particles, or a dissolved mixture thereof may be supported.

When a plurality of sensitizing dye compounds including the compound of the present invention are mixed, the proportion of the compounds is not particularly limited, so that optimum conditions may be appropriately selected. In general, an equimolar mixture including sensitizing dye compounds each in an amount of 10 mol% or more is preferably used. When a solution of a plurality of sensitizing dye compounds dissolved or dispersed are adsorbed on a thin film of oxide semiconductor fine particles, the total concentration of the sensitizing dye compounds in the solution may be the same as in the case of supporting one only. When a plurality of sensitizing dye compounds are mixed for use, the solvents described above may be used. In that case, one solvent may be used or different solvents may be used for each compound.

A compound of the present invention may be supported on a thin film of oxide semiconductor fine particles under coexistence of a clathrate compound in order to effectively prevent association between the compounds. Examples of the clathrate compound include a steroidal compound such as cholic acid, a crown ether, cyclodextrin, calixarene, and polyethylene oxide. Specific preferred examples thereof include cholic acids such as deoxycholic acid, dehydrodeoxycholic acid, chenodeoxycholic acid, ursodeoxycholic acid, lithocholic acid, hyodeoxycholic acid, cholic acid methyl ester, and sodium cholate, and polyethylene oxide. Further, after the compound and the dye are supported, the thin film of semiconductor fine particles may be treated with an amine compound such as 4-t-butylpyridine, or an acid such as acetic acid and propionic acid. Examples of the treatment method include immersing a substrate having a thin film of semiconductor fine particles which supports a sensitizing dye compound into an ethanol solution including an amine compound or an acid.

A solar cell can be manufactured from the thin film of oxide semiconductor fine particles, using one electrode of a photoelectric conversion element supporting the compound of the present invention, a counter electrode, a redox electrolyte or a hole transport material or a p-type semiconductor, and the like. The redox electrolyte, the hole transport material, the p-type semiconductor, and the like for use may be known materials in a liquid state, in a coagulated state (gel and gelatinous state), in a solid state and the like. Examples thereof in a liquid state include a redox electrolyte, a molten salt, a hole transport material, a p-type semiconductor or the like each dissolved in a solvent, and a normal temperature molten salt; and examples thereof in a coagulated state (gel and gelatinous state) include the same contained in a polymer matrix, a low-molecular weight gelling agent and the like. Examples thereof in a solid state for use include a redox electrolyte, a molten salt, a hole transport material, and a p-type semiconductor. Examples of the hole transport material include amine derivatives and conductive polymers such as polyacetylene, polyaniline, and polythiophene, and triphenylene compounds. Examples of the p-type semiconductor include CuI and CuSCN. Preferably a counter electrode has conductivity and catalyzes the reduction reaction of a redox electrolyte. For example, a glass or a polymer film on which platinum, carbon, rhodium, ruthenium or the like is deposited, or a glass or a polymer film coated with conductive fine particles, may be used.

Examples of the redox electrolyte for use in a solar cell include: a halogen redox electrolyte including a halogen compound having a halogen counter ion and a halogen molecule; a metal redox electrolyte such as ferrocyanate-ferricyanate, ferrocene-ferncinium ion and a metal complex such as cobalt complex; and an organic redox electrolyte such as alkylthiol-alkyldisulfide, a viologen dye, and hydroquinone-quinone; and among them, a halogen redox electrolyte is preferred. Examples of the halogen molecule of the halogen redox electrolyte including a halogen compound-halogen molecule include an iodine molecule and a bromine molecule, and an iodine molecule is preferred. Examples of the halogen compound having a halogen counter ion include a metal halide salt such as LiBr, NaBr, KBr, LiI, NaI, KI, CsI, CaI₂, MgI₂, and Cul or a halogen organic quaternary ammonium salt such as tetraalkyl ammonium iodide, imidazolium iodide, pyridinium iodide, and the salts having an iodine counter ion are preferred. Other than the iodine ion, use of an electrolyte having an imide counter ion such as a bis(trifluoromethanesulfonyl)imide ion and a dicyano imide ion is also preferred.

When the redox electrolyte is contained in a solution, an electrochemically inert solvent is used for the solvent. Examples thereof include acetonitrile, propylene carbonate, ethylene carbonate, 3-methoxypropionitrile; methoxyacetonitrile, ethylene glycol, propylene glycol, diethylene glycol, triethylene glycol, γ-butyrolactone, dimethoxyethane, diethyl carbonate, diethyl ether, diethyl carbonate, dimethyl carbonate, 1,2-dimethoxyethane, dimethylformamide, dimethylsulfoxide, 1,3-dioxolane, methylformate, 2-methyltetrahydrofuran, 3-methyl-oxazolidin-2-one, sulfolane, tetrahydrofuran, and water. Among them, acetonitrile, propylene carbonate, ethylene carbonate, 3-methoxypropionitrile, methoxyacetonitrile, ethylene glycol, 3-methyl-oxazolidin-2-one, γ- butyrolactone and the like are particularly preferred. These may be used singly or in combinations of two or more. Examples of the gelatinous electrolyte include an electrolyte or electrolyte solution contained in a matrix of oligomer or polymer, and an electrolyte or electrolyte solution also contained in a low-molecular gelling agent or the like described in Non Patent Literature 4. The concentration of the redox electrolyte is typically 0.01 to 99 mass%, preferably about 0.1 to 90 mass%.

The solar cell includes an electrode of photoelectric conversion element which supports a compound on a thin film of oxide semiconductor fine particles on a substrate, which is sandwiched between counter electrodes. A solution containing a redox electrolyte is filled between the electrodes.

### Examples

The present invention is described in more detail with reference to Examples as follows, but the present invention is not limited thereto. In Examples, parts represent parts by mass unless otherwise specified. M represents the concentration of a solution by mol/L. The compound numbers correspond to the ones of the specific examples described above. The maximum absorption wavelength was measured by a spectrophotometer UV-3100PC (manufactured by Shimadzu Corporation), and the nuclear magnetic resonance was measured by a nuclear magnetic resonance apparatus BRUKER AVANCE 500 (500 MHz), using tetramethylsilane as an internal standard. Further, mass spectrometry was performed with a mass spectrometer JEOL JMS-700 (manufactured by JEOL Ltd.), and elemental analysis was performed with an analyzer CE-440F (manufactured by Exeter Analytical, Inc.).

### Example 1 (Synthesis of a compound represented by Formula (5 a))

### (Step 1)

In a mixed solvent of 75 ml of THF and 10 ml of water, 1.5023 g (2.2689 mmol) of the compound represented by Formula (101), 2.7828 g (6.8139 mmol) of the compound represented by Formula (102), and 6.2805 g (45.4351 mmol) of K₂CO₃ were dissolved. To the produced solution, 0.80 g (0.69 mmol) of Pd(PPh₃)₄ was added, and the mixture was refluxed overnight under N₂ atmosphere. After completion of the reaction, the THF was distilled away under reduced pressure, and extraction was performed using 150 ml of CH₂Cl₂. The produced organic phase was washed with 150 ml of water, and then dried with Na₂SO₄. After the solvent was distilled away under reduced pressure, the produced residue was purified by column chromatography (normal phase SiO₂, CH₂Cl₂/hexane=1/1 (volume ratio)), so that 0.9843 g of the compound represented by Formula (103) was obtained as a dark blue solid (yield: 41%).

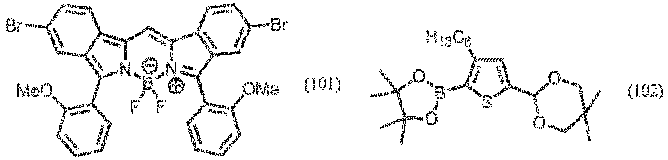

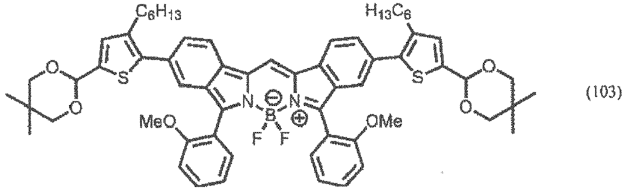

Measured values by nuclear magnetic resonance and mass spectrometry for the compound represented by Formula (103) were as follows.
¹H NMR (500 MHz, CDCl₃) δ (ppm): 0.79 (s, 6H, CH_{3 ax}), 0.83 (t, 6H, J = 6.92 Hz, Hq), 1.18-1.22 (m, 12H, Hₙ₋ₚ), 1.28 (s, 6H, CH₃ eq), 1.47-1.53 (m, 4H, Hₘ), 2.56 (t, 4H, J = 7.82 Hz, H₁), 3.64 (d, 4H, J = 10.95 Hz, Hₐₓ), 3.69 (s, 3H, H_{g}), 3.75 (d, 4H, J = 9.75 Hz, H_{eq}), 3.76 (s, 3H, H_{g'}),

5.59 (s, 2H, Hₑ) 6.95 (d, 1H, J = 8.35 Hz, Hₕ), 6.99 (s, 2H, H_{d}), 6.99-7.01 (m, 2H, H_{k',j}), 7.06 (t, 1H, J = 7.33 Hz, H_{j'}), 7.36 (s, 1H, H_{f}), 7.37 (s, 1H, H_{f}), 7.38 - 7.42 (m, 2H, Hᵢ), 7.49 (d, 2H, J = 8.35 Hz, H_{c}), 7.54 (d, 1H, J = 7.55 Hz, Hₖ), 7.66 (d, 1H, J = 7.30 Hz, H_{k'}), 7.81 and 7.82 (s, 1H, Hₐ), 7.89 (d, 2H, J = 8.45 Hz, H_{b}), 7.90 (d, 1H, J = 8.55 Hz, H_{b'}).

### FAB MS: m/z 1064 [M+H]⁺

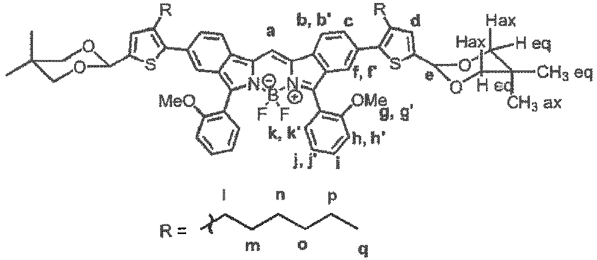

### (Step 2)

In 120 ml of THF, 980.0 mg (0.9200 mmol) of the compound represented by Formula (103) obtained in the step 1 was dissolved. To the produced solution, a solution containing 270.4 mg (1.4215 mmol) of p-toluenesulfonic acid dissolved in 20 ml of water was added and stirred overnight with shielding light at 40°C. After completion of the reaction, the THF was distilled away under reduced pressure, and extraction was performed using 100 ml of CH₂Cl₂. The produced organic phase was washed with 100 ml of water two times, and then dried with Na₂SO₄. After the solvent was distilled away under reduced pressure, reprecipitation (CH₂Cl₂:hexane=10 ml:80 ml) was performed, so that 723.0 mg of the compound represented by Formula (104) was obtained as a dark blue solid.

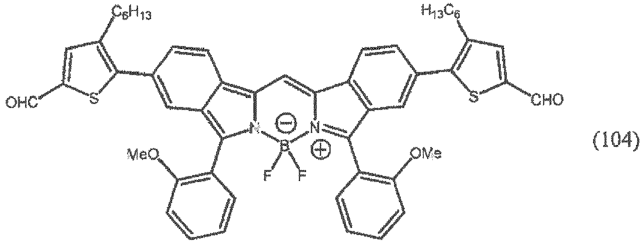

Measured values by nuclear magnetic resonance, mass spectrometry, elemental analysis, and ultraviolet and visible absorption spectroscopy for the compound represented by Formula (104) were as follows.
¹H NMR (500 MHz,CDCl₃) δ (ppm) 0.84 (t, 6H, J = 6.95 Hz H_{q}), 1.21-1.25 (m, 12H, Hₙ₋ₚ), 1.57-1.64 (m, 4H, Hₘ), 2.66 (t, 4H, J = 7.80 Hz, Hₗ), 3.72 (s, 3H, H_{g}), 3.80 (s, 3H, H_{g'}), 6.99 (d, 1H, J = 8.65 Hz, Hₕ), 7.03 (t, 1H, J = 8.00 Hz, Hⱼ), 7.08 (t, 1H, J = 7.15 Hz, H_{j'}), 7.41 - 7.43 (m, 3H, H_{h',i}), 7.45 (s, 1H, H_{f}), 7.46 (s, 1H, H_{f}), 7.52 - 7.54 (m, 2H, H_{c}), 7.56 (d, 1H, J = 7.65 Hz, Hₖ), 7.63 (s, 2H, H_{d}), 7.69 (d, 1H, J = 7.55 Hz, H_{k'}), 7.88 and 7.89 (s, 1H, Hₐ), 7.96 (d, 1H, J = 8.45 Hz, H_{b}), 7.97 (d, 1H, J = 8.05 Hz, H_{b'}), 9.84 (s, 2H, Hₑ).
FAB MS: m/z 892 [M⁺]
Elemental analysis: Calc. For C₅₃H₅₁BF₂N₄O₆S₂: C, 71.29; H, 5.76; N, 3.14, Found: C, 71.39; H, 6.12; N, 2.98
UV/Vis; λₘₐₓ = 641 nm (ε =1.38 × 10⁵ M⁻¹ cm⁻¹)

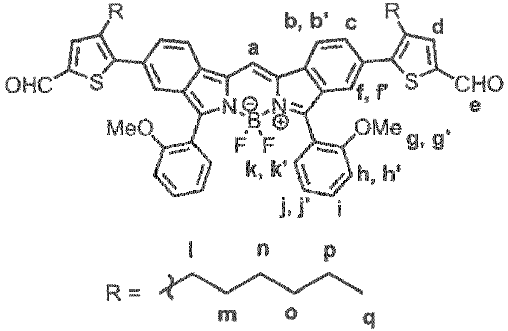

### (Step 3)

Under N₂ atmosphere, in 14 ml of THF, 500.9 mg (0.5610 mmol) of the compound represented by Formula (104) was dissolved. To the produced solution, 0.28 ml (2.83 mmol) of piperidine was added, and the mixture was refluxed for 1 hour and returned to room temperature. To the mixture, a solution obtained by dissolving 241.5 mg (2.8392 mmol) of cyanoacetic acid and 0.28 ml (2.83 mmol) of piperidine in 14 ml of THF and refluxing the mixture for 1 hour was added, and the mixture was refluxed for 5 hours. After completion of the reaction, the mixture was quenched with 100 ml of water and subjected to liquid separation treatment with 100 ml of CH₂Cl₂. The produced organic phase A was washed with 100 ml of saturated saline solution and 100 ml of water. The precipitated green solid was separated by filtration and subjected to liquid separation treatment (1% hydrochloric acid water: CH₂Cl₂=100 ml:400 ml). The CH₂Cl₂ phase was then distilled away under reduced pressure, so that 246.2 mg of Compound 13 represented by Formula (5a) according to the present invention was obtained (yield: 43%).

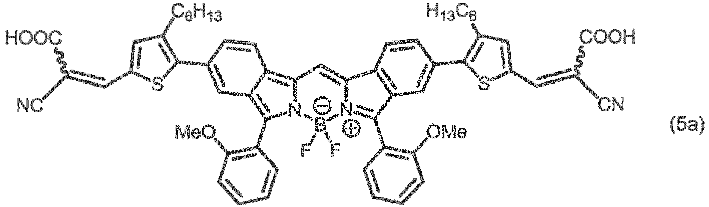

Measured values by nuclear magnetic resonance, mass spectrometry, elemental analysis, and ultraviolet and visible absorption spectroscopy for Compound 13 were as follows. FAB MS: m/z 1026 [M⁺]
¹H NMR (500MHz, DMSO-d₆) δ(ppm): 0.79 (t, 6H, J = 6.77 Hz, Hᵣ), 1.14 - 1.18 (m, 12H, H_{o-q}), 1.50-1.58 (m, 4H, Hₙ), 2.61 - 2.65 (m, 4H, Hₘ), 3.69 (s, 3H, Hₕ), 3.76 (s, 3H, H_{h'}), 7.03 (t, 1H, J = 7.53 Hz, Hₖ), 7.10 (t, 1H, J = 7.47 Hz, H_{k'}), 7.20 (d, 1H, J = 8.30 Hz, Hᵢ), 7.24 (d, 1H, J = 8.45 Hz, H_{i'}), 7.37 (s, 1H, H_{g}), 7.39 (s, 1H, H_{g'}), 7.45 (d, 1H, J = 7.50 Hz, Hₗ), 7.51 (t, 3H, J = 8.18 Hz, H_{j.l'}), 7.71 (d, 2H, J = 8.45 Hz, H_{c}), 7.94 (s, 2H, H_{d}), 8.30 (d, 1H, J = 8.30 H_{b}), 8.31 (d, 1H, J = 8.20 Hz, H_{b'}), 8.43 (s, 2H, Hₑ), 8.84 and 8.85 (s, 1H, Hₐ), 13.75 (broad signal, 2H, H_{f}) Elemental analysis: Calc. For C₅₉H₅₃BF₂N₄O₆S₂·H₂O: C, 67.81; H, 5.30; N, 5.36, Found: C, 67.70; H, 5.15; N, 5.34
UV/Vis; λₘₐₓ = 647 nm (ε = 1.58 × 10⁵ M⁻¹ cm⁻¹)

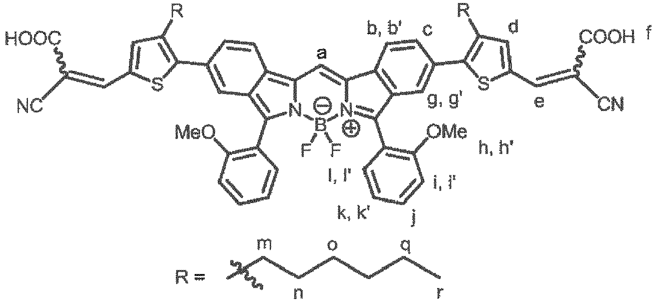

### Example 2 (Synthesis of Compound 98 represented by Formula (5b))

### (Step 4)

The organic phase A obtained in the course of the step 3 was dried with Na₂SO₄, so that the solvent was distilled away. The product was then purified by column chromatography (normal phase SiO₂, CH₂Cl₂→CH₂Cl₂/EtOH=9/1 (volume radio)), so that 213.0 mg of Compound 98 represented by Formula (5b) according to the present invention was obtained as a green solid (yield: 40%).

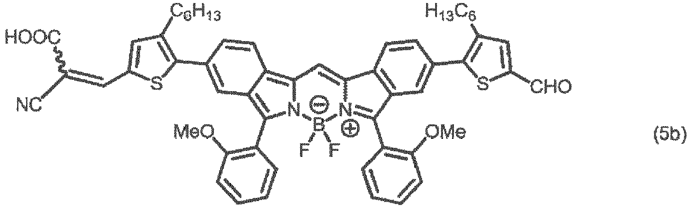

Measured values by nuclear magnetic resonance, mass spectrometry, elemental analysis, and ultraviolet and visible absorption spectroscopy for Compound 98 were as follows. ¹H NMR (500MHz, DMSO-d₆) δ (ppm): 0.79 (t, 6H, J = 6.90Hz, H_{r,H}), 1.14 - 1.19 (m, 12H, H_{o-q,E-G}), 1.48 - 1.58 (m, 4H, H_{n,D}), 2.61 - 2.65 (m, 4H, H_{m,C}), 3.69 (s, 3H, H_{h,X}), 3.75 and 3.76 (s, 3H, H_{h',X'}), 7.03 (t, 1H, J = 7.45 Hz, H_{k,A}), 7.10 (t, 1H, J = 7.53 Hz, H_{k',A'}), 7.19 (dd, 1H, J = 2.73 and 8.47 Hz, H_{i,y}), 7.23 (dd, 1H, J = 2.25 and 8.55 Hz, H_{i',y'}), 7.35 - 7.38 (m, 2H, H_{g,w}), 7.44 (t, 1H, J = 6.05 Hz, H_{j,Z}), 7.51 (t, 3H, J = 8.15 Hz, H_{j',z',B,l}), 7.68 - 7.72 (m, 2H, Hc, ₜ), 7.90 (s, 1H, Hᵤ), 7.97 and 7.98 (d, 1H, H_{d}), 8.29 (d, 1H, J = 8.35 Hz, H_{b,s}), 8.30 (d, 1H, J = 8.45 Hz, H_{b',s'}), 8.38 (s, 1H, He), 8.83 and 8.84 (s, 1H, Hₐ), 9.87 (s, 1H, Hᵥ), 13.77 (broad signal, 1H, H_{f}) FAB MS: m/z 959 [M⁺]
Elemental analysis: Calc. For C₅₆H₅₂BF₂N₃O₅S₂-0.5H₂O: C, 69.41; H, 5.51; N, 4.34, Found: C, 69.08; H, 5.43; N, 4.33
UV/Vis; λₘₐₓ = 644 nm (ε = 1.44 × 10⁵ M⁻¹ cm⁻¹)

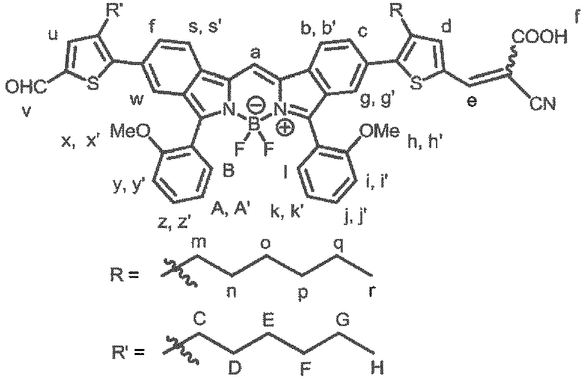

### Example 3 (Synthesis of Compound 194 represented by Formula (5c))

### (Step 5)

424.5 mg (0.4267 mmol) of the compound represented by Formula (105), which was synthesized from 5-bromo-2-hydroxyacetophenone according to the method described in Non Patent Literature 3, and 655.1 mg of (1.604 mmol) of the compound represented by Formula (102) were dissolved in 32.7 ml of THF, to which 6.5 ml of 2 M K₂CO₃ aqueous solution was added. The mixture was degassed by lyophilization. After refreezing, 0.16 g (0.1385 mmol) of Pd(PPh₃)₄ was added, and N₂ substitution was then performed. The solution was returned to room temperature, and refluxed overnight at 70°C under N₂ atmosphere. After completion of the reaction, the product was quenched with 20 ml of water, and subjected to liquid separation treatment with 100 ml of ethyl acetate. The organic layer was washed with 230 ml of water, and dried with Na₂SO₄. The solvent was distilled away under reduced pressure. The produced residue was then purified by column chromatography (normal phase SiO₂, CH₂Cl₂/hexane=3/2 (volume ratio)), so that 445.5 mg of the compound represented by Formula (106) was obtained as a dark green solid (yield: 65%).

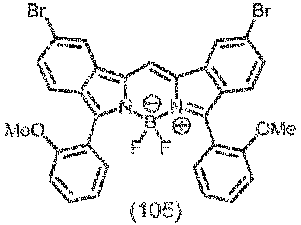

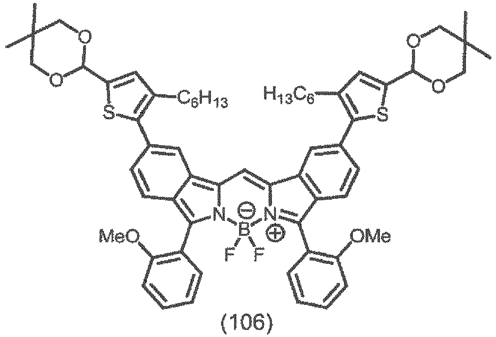

Measured values by nuclear magnetic resonance for the compound represented by Formula (106) were as follows.
¹H NMR (500 MHz, DMSO-d₆) δ (ppm) 0.76 (t, 6H, J = 6.93 Hz, Hₚ), 1.19 (s,12H, Hₛ), 1.20-1.25 (m, 12H, Hₘ₋ₒ), 1.57 (quint, 4H, J = 7.32 Hz, Hₗ), 2.70 (t, 4H, J = 7.70 Hz, Hₖ), 3.67 (s, 8H, Hᵣ), 3.69 (s, 3H, Hᵢ), 3.75 (s, 3H, H_{i'}), 5.70 (s, 2H, H_{q}), 7.02 (td, 1H, J = 7.50,0.63Hz, H_{f}), 7.08 (td, 1 H, J = 7.58, 0.73 Hz, H_{f}), 7.10 (s, 2H, Hⱼ), 7.19 (d, 1H, J = 8.35 Hz, Hₕ), 7.22 (d, 1H, J = 8.10 Hz, H_{h'}), 7.31 (d, 1H, J = 8.50 Hz, H_{d}), 7.31 (d, 1H, J = 8.35 Hz, H_{d'}), 7.37 (d, 2H, J = 8.45 Hz, H_{c}), 7.41 (d, 1H, J = 7.50 Hz, Hₑ), 7.48 (dd, 1H, J = 1.73 and 7.90 Hz, H_{e'}), 7.50 (td, 2H, J = 7.98, 1.42Hz, H_{g}), 8.20 (s, 2H,H_{b}), 8.78 (s, 1H, Hₐ)

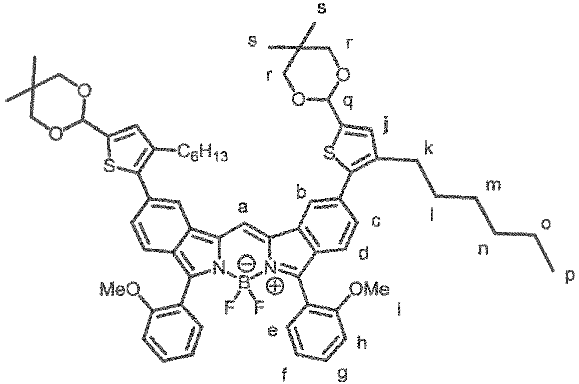

### (Step 6)

In 54 ml of THF, 445.4 mg (0.4261 mmol) of the compound represented by Formula (106) obtained in the step 5 was dissolved. To the produced solution, a solution containing 121.6 mg (0.6392 mmol) of p-toluenesulfonic acid hydrate dissolved in 8.5 ml of water was added, and heated to 40°C. After completion of the reaction, liquid separation treatment was performed with 50 ml of ethyl acetate. The organic layer was washed with 150 ml of water, and dried with Na₂SO_{4.} The solvent was distilled away under reduced pressure. The produced residue was then purified by column chromatography (normal phase SiO₂, CH₂Cl₂/hexane=2/1 (volume ratio)), so that 282.5 mg of the compound represented by Formula (107) was obtained as a dark green solid (yield: 61%).

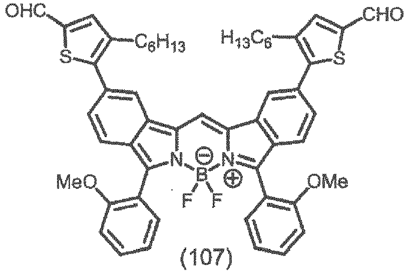

Measured values by nuclear magnetic resonance for the compound represented by Formula (107) were as follows.
¹H NMR (500MHz, DMSO-d₆) δ (ppm): 0.76 (t, 6H, J = 7.00 Hz, Hₚ), 1.19-1.27 (m, 12H, Hₘ₋ₒ), 1.62 (quint, 4H, J = 7.37 Hz, Hₗ), 2.78 (t, 4H, J = 7.67 Hz, Hₖ), 3.70 (s, 3H, Hᵢ), 3.75 (s, 3H, H_{i'}), 7.03 (t, 1H, J = 7.78 Hz, H_{f}), 7.09 (t, 1H, J = 7.47 Hz, H_{f}), 7.20 (d, 1H, J = 8.20 Hz, Hₕ), 7.23 (1H, J = 8.05 Hz, H_{h'}), 7.38-7.45 (m, 5H, H_{c,d,e}), 7.49 (d, 1H, J = 8.25 Hz, H_{e'}), 7.51 (app. t, 2H, J = 8.00 Hz, H_{g}), 8.06 (s, 2H, Hⱼ), 8.29 and 8.30 (s, 1H, H_{b,b'}), 8.84 (s, 1H, Hₐ), 8.85 (s, 1H, H_{a'}), 9.93 (s, 2H, H_{q})

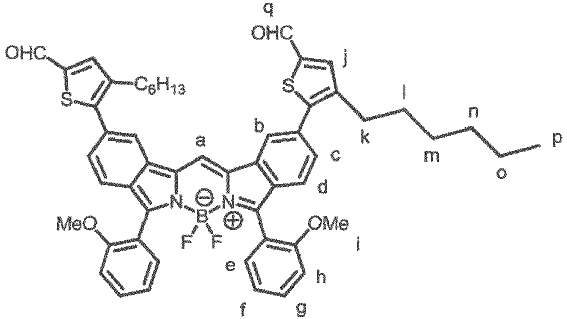

### (Step 7)

In a 30 ml two-neck eggplant-shaped flask, 265.8 mg (0.2976 mmol) of the compound represented by Formula (107) obtained in the step 6 was placed and subjected to freeze drying three times. 7.84 ml of THF was then added to dissolve the compound, to which 0.2 ml (2.025 mmol) of piperidine was further added and refluxed for 1 hour. In another two-neck eggplant-shaped flask, 158.9 mg (1.868 mmol) of cyanoacetic acid was placed and subjected to lyophilization three times, and 7.84 ml of THF was then added thereto to dissolve the compound. Further, 0.2 ml (2.025 mmol) of piperidine was added thereto and the mixture was refluxed for 1 hour. After both of the two-necked eggplant-shaped flasks were returned to room temperature, the THF solution in which cyanoacetic acid and piperidine were dissolved was added to the THF solution in which the compound represented by Formula (107) and piperidine were dissolved, and the mixture was refluxed for two days. After completion of the reaction, 30 mol of CH₂Cl₂ was added thereto to precipitate and the precipitated solid was collected by Kiriyama filtration. The collected solid was subjected to liquid separation treatment with 100 ml of 1 N hydrochloric acid and 100 ml of CH₂Cl₂, and then the organic phase was dried with Na₂SO₄. The solvent was distilled away under reduced pressure, and reprecipitation (CH₂Cl₂:hexane=10 ml): 100 ml) was performed, so that 209.2 mg of Compound 194 represented by Formula (5c) according to the present invention was obtained as a dark green solid (yield: 65%).

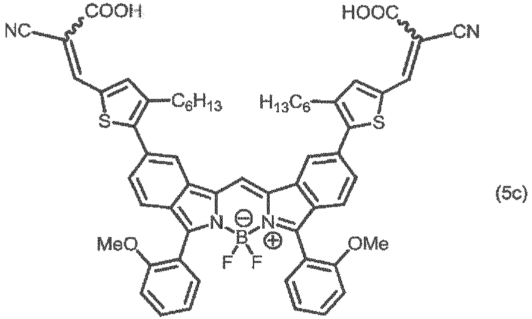

Measured values by nuclear magnetic resonance, mass spectrometry, elemental analysis, and ultraviolet and visible absorption spectroscopy for the compound 194 were as follows.
¹H NMR (500 MHz, DMSO-d₆) δ (ppm) 0.76 (t, 6H, J = 6.95 Hz, Hₚ), 1.19-1.26 (m, 12H, Hₘ₋ₒ), 1.60 (quint, 4H, J = 7.28 Hz, Hₗ), 2.78 (t, 6H, J = 7.50Hz, Hₖ), 3.70 (s, 3H, Hᵢ), 3.76 (s, 3H, H_{i'}), 7.03 (t, 1H, J = 7.80 Hz, H_{f}), 7.10 (t, 1H, J = 7.53 Hz, H_{f}), 7.20 (d, 1H, J = 8.35 Hz, Hₕ), 7.24 (d, 1H, J = 8.30 Hz, H_{h'}), 7.38-7.46 (m, 5H, H_{c.e,d}), 7.49 (app. d, 1H, J = 7.25 Hz, H_{e'}), 7.51 (t, 1H, J = 8.00 Hz, H_{g,g'}), 8.03 (s, 2H, Hⱼ), 8.32 (s, 1H, H_{b}) and 8.33 (s, 1H, H_{b'}), 8.51 (s, 2H, Hq), 8.91 (s, 1H, H_{a,a'}), 13.8 (s, 2H, Hᵣ)
FAB MASS: m/z 1026 [M]⁺
Elemental Analysis: Calc. For C₅₉H₅₃BF₂N₄O₆S₂·0.5H₂O: C, 68.40; H, 5.25; N, 5.41, Found: C, 68.24; H, 5.08; N, 5.33.
UV/Vis (THF); λₘₐₓ = 660 nm (ε = 1.09 × 10⁵ M⁻¹ cm⁻¹)

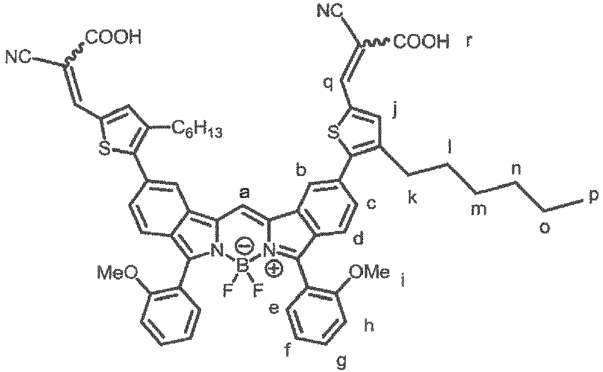

### Examples 4 to 10

The compounds of Formulas 5a, 5b and 5c obtained in Examples 1 and 2 were respectively dissolved at a concentration of 1.6×10⁻⁴ M in acetone, and 10 mM of deoxycholic acid was added thereto as a clathrate to make the clathrate carry the compound. In each of the solutions, a porous substrate (a semiconductor thin film of porous titanium oxide sintered at 500°C for 1 hour on a transparent conductive glass electrode) was immersed for 12 hours at room temperature (20°C). After completion of the immersion, the porous substrates were each taken out from the solution, washed with acetone and dried, so that photoelectric conversion elements according to the present invention, which each comprise a thin film of semiconductor fine particles carrying any one of the compounds, were obtained. The obtained substrates, having a thin film of semiconductor fine particles carrying any one of the compounds, were each disposed and fixed in such a manner that the thin film-side thereof faced the sputtered surface of a conductive glass sputtered with platinum and a gap of 20 µm was formed. Into the gap, an electrolyte-containing solution (electrolyte solution) was introduced to fill. Three types of electrolyte solutions were used, and they include an electrolyte solution A (0.1 M iodine, 0.1 M lithium iodide, 0.1 M dimethylpropyl imidazolium iodide, and 1 M t-butylpyridine dissolved in methoxy propionitrile), an electrolyte solution B (0.05 M iodine and 0.5 M tetrapropylammonium iodide dissolved in a mixed solvent prepared at a ratio of acetonitrile:ethylene carbonate=4:6), and an electrolyte solution C (0.1 M iodine, 0.1 M of lithium iodide, and 0.6 M dimethylpropyl imidazolium iodide dissolved in methoxypropionitrile).

The cells to be measured had an effective part with a size of 0.25 cm². A 500 W xenon lamp was used as light source, set to 100 mW/cm² through an AM (air mass passing through atmosphere) 1.5 filter. The short-circuit current, the open-circuit voltage, and the conversion efficiency were measured with a solar simulator WXS-1555-10, AM 1.5G (manufactured by Wacom electric Co., Ltd.).

The evaluation results on the power generation performance are described in Table 13.

**[Table 13]**

| Example | Compound No. | Electrolyte | Open-circuit voltage (V) | Short-circuit current (mA/cm²) | Conversion efficiency (%) |
|---|---|---|---|---|---|
| 4 | 13 | A | 0.60 | 7.8 | 2.9 |
| 5 | 13 | B | 0.59 | 14.5 | 4.6 |
| 6 | 13 | C | 0.53 | 19.2 | 5.2 |
| 7 | 98 | A | 0.62 | 4.7 | 2.1 |
| 8 | 98 | B | 0.58 | 13.0 | 4.4 |
| 9 | 98 | C | 0.53 | 17.2 | 5.4 |
| 10 | 194 | C | 0.54 | 19.0 | 6 |

From the results described in Table 13, it was found that use of the photoelectric conversion element sensitized by the compound of the present invention allows the artificial sunlight to be effectively converted to electricity, even using different types of electrolytes.

### Industrial Applicability

A compound of the present invention having the specific structure can be used as sensitizing dye to provide a dye-sensitized solar cell having high conversion efficiency and high stability.

## Claims

1. A compound represented by Formula (1): 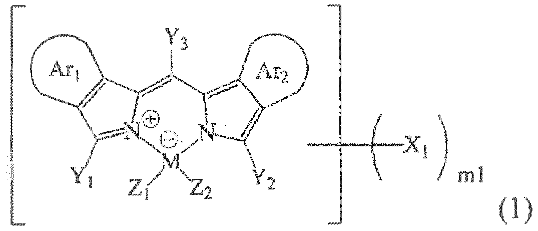 wherein ml represents an integer of 1 to 4; M represents a semimetal atom; Y₁, Y₂ and Y₃ each independently represent a hydrogen atom or an aromatic residue; Z₁ and Z₂ each independently represent a halogen atom; Ar₁ and Ar₂ each independently represent an aromatic ring; and X₁ represents one or more substituents on the aromatic ring Ar₁ and/or Ar₂ selected from the group consisting of Formulas (2), (3) and (4): 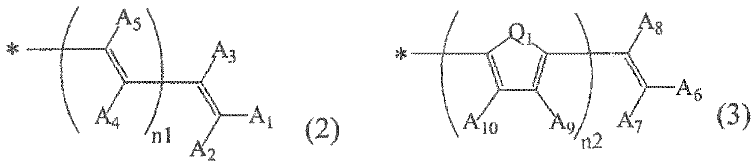 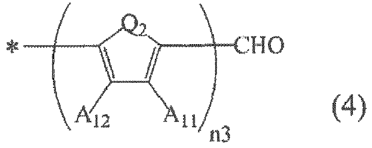 in Formula (2), n1 represents an integer of 0 to 5; A₁ and A₂ each independently represent a hydrogen atom, a carboxyl group, a cyano group, a phosphoric acid group or a sulfonic acid group, or A₁ and A₂ may be linked to each other to form a ring; A₃ represents a hydrogen atom, an aliphatic hydrocarbon residue, a halogen atom or an alkoxyl group; and A₄ and A₅ each independently represent a hydrogen atom, an aliphatic hydrocarbon residue, a halogen atom or an alkoxyl group, and when n1 is two or more so that the number of A₄ and the number of A₅ are each two or more, one of the A₄ substituents may be the same as or different from another thereof and one of the A₅ substituents may be the same as or different from another each other, or A₄ and A₅ may be linked to each other to form a ring;
in Formula (3), n2 represents an integer of 1 to 5; A₆ and A₇ each independently represent a hydrogen atom, a carboxyl group, a cyano group, a phosphoric acid group or a sulfonic acid group, or A₆ and A₇ may be linked to each other to form a ring; A₈ represents a hydrogen atom, an aliphatic hydrocarbon residue, a halogen atom or an alkoxyalkyl group; A₉ and A₁₀ each independently represent a hydrogen atom, an aliphatic hydrocarbon residue, a halogen atom or an alkoxyl group, and when n2 is two or more so that the number of A₉ and the number of A₁₀ are each two or more, one of the A₉ substituents may be the same as or different from another thereof and one of the A₁₀ substituents may be the same as or different from another thereof, or A₉ and A₁₀ may be linked to each other to form a ring; and Q₁ represents an oxygen atom, a sulfur atom or a selenium atom, and when n2 is two or more so that the number of Q₁ is two or more, one of the Q₁ atoms may be the same as or different from another thereof;
in Formula (4), n3 represents an integer of 0 to 5; A₁₁ and A₁₂ each independently represent a hydrogen atom, an aliphatic hydrocarbon residue, a halogen atom or an alkoxyl group, and when n3 is two or more so that the number of A₁₁ and the number of A₁₂ are each two or more, one of the A₁₁ substituents may be the same as or different from another thereof and one of the A₁₂ substituents may be the same as or different from another thereof, or A₁₁ and A₁₂ may be linked to each other to form a ring; Q₂ represents an oxygen atom, a sulfur atom or a selenium atom, and when n3 is two or more so that the number of Q₂ is two or more, one of the Q₂ atoms may be the same as or different from another thereof; and
in Formulas (2) to (4), the mark * represents a binding site with the aromatic ring Ar₁ and/or Ar₂.

2. The compound according to claim 1, wherein Ar₁ and Aᵣ₂ in Formula (1) are each a benzene ring.

3. The compound according to claim 1 or 2, wherein Y₁ and Y₂ in Formula (1) are each independently an aromatic residue, and Y₃ is a hydrogen atom;

4. The compound according to any one of claims 1 to 3, wherein M in Formula (1) is a boron atom.

5. The compound according to (1) represented by Formula (5): 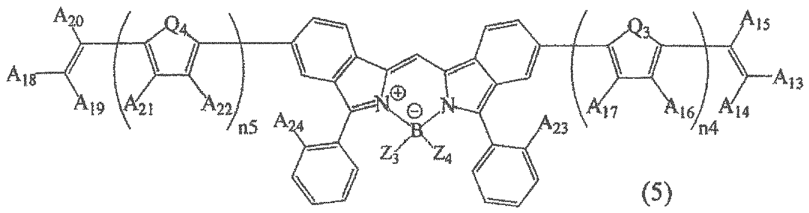 wherein Z₃ and Z₄ each independently represent a halogen atom; n4 represents an integer of 0 to 5; Q₃ represents an oxygen atom, a sulfur atom or a selenium atom, and when n4 is two or more so that the number of Q₃ is two or more, one of the Q₃ atoms may be the same as or different from another thereof; A₁₃ and A₁₄ each independently represent a hydrogen atom, a carboxyl group, a cyano group, a phosphoric acid group or a sulfonic acid group, or A₁₃ and A₁₄ may be linked to each other to form a ring; A₁₅ represents a hydrogen atom, an aliphatic hydrocarbon residue or an alkoxyl group; A₁₆ and A₁₇ each independently represent a hydrogen atom, an aliphatic hydrocarbon residue, a halogen atom or an alkoxyl group, and when n4 is two or more so that the number of A₁₆ and the number of A₁₇ are each two or more, one of the A₁₆ substituents may be the same as or different from another thereof and one of the A₁₇ substituents may be the same as or different from another thereof, or A₁₆ and A₁₇ may be linked to each other to form a ring; n5 represents an integer of 0 to 5; Qa represents an oxygen atom, a sulfur atom or a selenium atom, and when n5 is two or more so that the number of Q₄ is two or more, one of the Q₄ atoms may be the same as or different from another thereof; A₁₈ and A₁₉ each independently represent a hydrogen atom, a carboxyl group, a cyano group, a phosphoric acid group or a sulfonic acid group, or A₁₈ and A₁₉ may be linked to each other to form a ring; A₂₀ represents a hydrogen atom, an aliphatic hydrocarbon residue or an alkoxyl group; A₂₁ and A₂₂ each independently represent a hydrogen atom, an aliphatic hydrocarbon residue or an alkoxyl group; when n5 is two or more so that the number of A₂₁ and the number of A₂₂ are each two or more, one of the A₂₁ substituents may be the same as or different from another thereof and one of the A₂₂ substituents may be the same as or different from another thereof, or A₂₁ and A₂₂ may be linked to each other to form a ring; and A₂₃ and A₂₄ each independently represent a hydrogen atom, a halogen atom, an aliphatic hydrocarbon residue or an alkoxyl group;

6. The compound according to claim 5, wherein in Formula (5), Z₃ and Z₄ are each a fluorine atom, n4 and n5 are each an integer of 1, Q₃ and Q₄ are each a sulfur atom, one of A₁₃ and A₁₄ is a carboxyl group and the other is a cyano group, one of A₁₈ and A₁₉ is a carboxyl group and the other is a cyano group, A₁₅ and A₂₀ are each a hydrogen atom, A₁₆ and A₂₁ are each a hydrogen atom, A₁₇ and A₂₂ are each an n-hexyl group, and A₂₃ and A₂₄ are each a methoxy group.

7. The compound according to claim 1, represented by Formula (6): 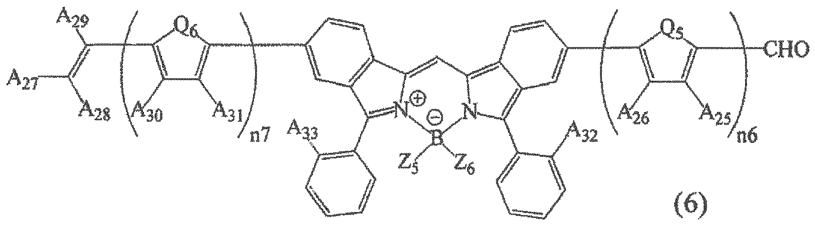 wherein Z₅ and Z₆ each independently represent a halogen atom; n6 represents an integer of 0 to 5; n7 represents an integer of 0 to 5; Q₅ represents an oxygen atom, a sulfur atom or a selenium atom, and when n6 is two or more so that the number of Q₅ is two or more, one of the Q₅ atoms may be the same as or different from another thereof; Q₆ represents an oxygen atom, a sulfur atom or a selenium atom, and when n7 is two or more so that the number of Q₆ is two or more, one of the Q₆ atoms may be the same as or different from another thereof; A₂₅ and A₂₆ each independently represent a hydrogen atom, an aliphatic hydrocarbon residue, a halogen atom or an alkoxyl group, and when n6 is two or more so that the number of A₂₅ and the number of A₂₆ are each two or more, one of the A₂₅ substituents may be the same as or different from another thereof and one of the A₂₆ substituents may be the same as or different from another thereof, or A₂₅ and A₂₆ may be linked to each other to form a ring; A₂₇ and A₂₈ each independently represent a hydrogen atom, a carboxyl group, a cyano group, a phosphoric acid group or a sulfonic acid group, or A₂₇ and A₂₈ may be linked to each other to form a ring; A₂₉ represents a hydrogen atom, an aliphatic hydrocarbon residue or an alkoxyl group; A₃₀ and A₃₁ each independently represent a hydrogen atom, an aliphatic hydrocarbon residue, a halogen atom or an alkoxyl group, and when n7 is two or more so that the number of A₃₀ and the number of A₃₁ are each two or more, one of the A₃₀ substituents may be the same as or different from another thereof and one of the A₃₁ substituents may be the same as or different from another thereof, or A₃₀ and A₃₁ may be linked to each other to form a ring; and A₃₂ and A₃₃ each independently represent a hydrogen atom, a halogen atom, an aliphatic hydrocarbon residue or an alkoxyl group.

8. The compound according to claim 7, wherein in Formula (6), Z₅ and Z₆ are each a fluorine atom, n6 and n7 are each an integer of 1, Q₅ and Q₆ are each a sulfur atom, A₂₅, A₂₉ and A₃₀ are each a hydrogen atom, A₂₆ and A₃₁ are each an n-hexyl group, one of A₂₇ and A₂₈ is a carboxyl group and the other is a cyano group, and A₃₂ and A₃₃ are each a methoxy group.

9. The compound according to claim 1, represented by Formula (9): 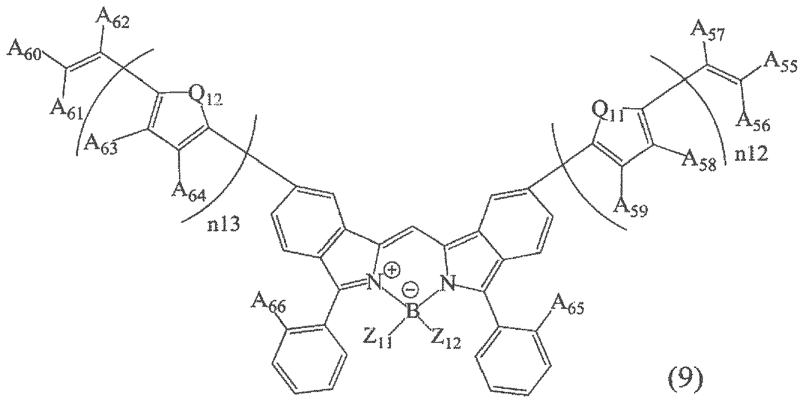 wherein Z₁₁ and Z₁₂ each independently represent a halogen atom; n12 represents an integer of 0 to 5; Q₁₁ represents an oxygen atom, a sulfur atom or a selenium atom, and when n12 is two or more so that the number of Q₁₁ is two or more, one of the Q₁₁ atoms may be the same as or different from another thereof; A₅₅ and A₅₆ each independently represent a hydrogen atom, a carboxyl group, a cyano group, a phosphoric acid group or a sulfonic acid group, or A₅₅ and A₅₆ may be linked to each other to form a ring; A₅₇ represents a hydrogen atom, an aliphatic hydrocarbon residue or an alkoxyl group; A₅₈ and A₅₉ each independently represent a hydrogen atom, an aliphatic hydrocarbon residue, a halogen atom or an alkoxyl group, and when nl2 is two or more so that the number of A₅₈ and the number of A₅₉ are each two or more, one of the A₅₈ substituents may be the same as or different from another thereof and one of the A₅₉ substituents may be the same as or different from another thereof, or A₅₈ and A₅₉ may be linked to each other to form a ring; n13 represents an integer of 0 to 5; Q₁₂ represents an oxygen atom, a sulfur atom or a selenium atom, and when n13 is two or more so that the number of Q₁₂ is two or more, one of the Q₁₂ atoms may be the same as or different from another thereof; A₆₀ and A₆₁ each independently represent a hydrogen atom, a carboxyl group, a cyano group, a phosphoric acid group or a sulfonic acid group, or A₆₀ and A₆₁ may be linked to each other to form a ring; A₆₂ represents a hydrogen atom, an aliphatic hydrocarbon residue or an alkoxyl group; A₆₃ and A₆₄ each independently represent a hydrogen atom, an aliphatic hydrocarbon residue, a halogen atom or an alkoxyl group; when n13 is two or more so that the number of A₆₃ and the number of A₆₄ are each two or more, one of the A₆₃ substituents may be the same as or different from another thereof and one of the A₆₄ substituents may be the same as or different from another thereof, or A₆₃ and A₆₄ may be linked to each other to form a ring; and A₆₅ and A₆₆ each independently represent a hydrogen atom, a halogen atom, an aliphatic hydrocarbon residue or an alkoxyl group.

10. The compound according to claim 9, wherein in Formula (9), Z₁₁ and Z₁₂ are each a fluorine atom, n12 and n13 are each an integer of 1, Q₁₁ and Q₁₂ are each a sulfur atom, one of A₅₅ and A₅₆ is a carboxyl group and the other is a cyano group, one of A₆₀ and A₆₁ is a carboxyl group and the other is a cyano group, A₅₇ and A₆₂ are each a hydrogen atom, A₅₈ and A₆₃ are each a hydrogen atom, A₅₉ and A₆₄ are each an n-hexyl group, and A₆₅ and A₆₆ are each a methoxy group.

11. The compound according to claim 1, represented by Formula (10): 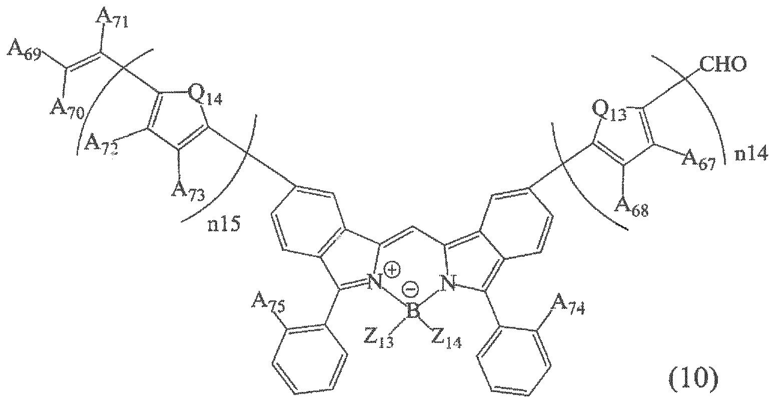 wherein Z₁₃ and Z₁₄ each independently represent a halogen atom; n14 represents an integer of 0 to 5; n15 represents an integer of 0 to 5; Q₁₃ represents an oxygen atom, a sulfur atom, or a selenium atom, and when n14 is two or more so that the number of Q₁₃ is two or more, one of the Q₁₃ atoms may be the same as or different from another thereof; Q₁₄ represents an oxygen atom, a sulfur atom or selenium atom, and when n15 is two or more so that the number of Q₁₄ is two or more, one of the Q₁₄ atoms may be the same as or different from another thereof; A₆₇ and A₆₈ each independently represent a hydrogen atom, an aliphatic hydrocarbon residue, a halogen atom or an alkoxyl group, and when n14 is two or more so that the number of A₆₇ and the number of A₆₈ are each two or more, one of the A₆₇ substituents may be the same as or different from another thereof and one of the A₆₈ substituents may be the same or different from another thereof, or A₆₇ and A₆₈ may be linked to each other to form a ring; A₆₉ and A₇₀ each independently represent a hydrogen atom, a carboxyl group, a cyano group, a phosphoric acid group or a sulfonic acid group, or A₆₉ and A₇₀ may be linked to each other to form a ring; A₇₁ represents a hydrogen atom, an aliphatic hydrocarbon residue or an alkoxyl group; A₇₂ and A₇₃ each independently represent a hydrogen atom, an aliphatic hydrocarbon residue, a halogen atom or an alkoxyl group, and when n15 is two or more so that the number of A₇₂ and the number of A₇₃ are each two or more, one of the A₇₂ substituents may be the same as or different from another thereof and one of the A₇₃ substituents may be the same as or different from another thereof, or A₇₂ and A₇₃ may be linked to each other to form a ring; and A₇₄ and A₇₅ each independently represent a hydrogen atom, a halogen atom, an aliphatic hydrocarbon residue or an alkoxyl group.

12. The compound according to claim 11, wherein in Formula (10), Z₁₃ and Z₁₄ are each a fluorine atom, n14 and n15 are each an integer of 1, Q₁₃ and Q₁₄ are each a sulfur atom, A₆₇, A₇₁ and A₇₂ are each a hydrogen atom, A₆₈ and A₇₃ are each an n-hexyl group, one of A₆₉ and A₇₀ is a carboxyl group and the other is a cyano group, and A₇₄ and A₇₅ are each a methoxy group.

13. A method for manufacturing the compound represented by Formula (1) according to (1), comprising introducing a substituent X₁ by a cross-coupling reaction.

14. A photoelectric conversion element comprising the compound represented by Formula (1) according to claim 1 which is carried by a thin film of oxide semiconductor fine particles disposed on a substrate.

15. A photoelectric conversion element comprising one or more of the compounds represented by Formula (1) according to claim 1 and a sensitizing dye compound having a different structure from Formula (1) which are carried by a thin film of oxide semiconductor fine particles disposed on a substrate.

16. The photoelectric conversion element according to claim 14 or 15, wherein the oxide semiconductor fine particles comprise titanium dioxide, zinc oxide or tin oxide.

17. A solar cell comprising the photoelectric conversion element according to any one of claims 14 to 16.

## Amended claims

### Amended claims under Art. 19.1 PCT

**1.** (Amended)
A compound represented by Formula (1): 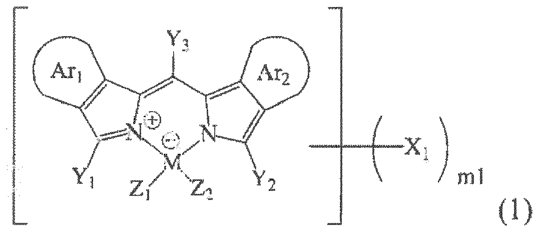 wherein ml represents an integer of 1 to 4; M represents a semimetal atom; Y₁, Y₂ and Y₃ each independently represent a hydrogen atom or an aromatic residue; Z₁ and Z₂ each independently represent a halogen atom; Ar₁ and Ar₂ each independently represent an aromatic ring; and X₁ represents one or more substituents on the aromatic ring Ar₁ and/or Ar₂ selected from the group consisting of Formulas (2), (3) and (4): 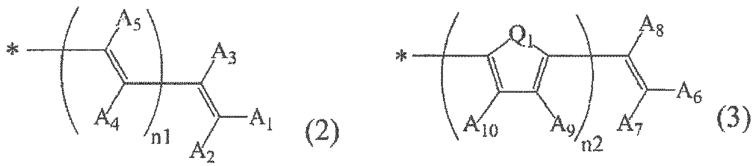 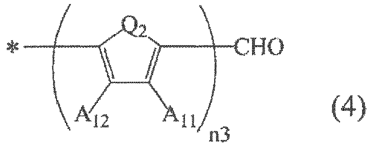 in Formula (2), n1 represents an integer of 0 to 5; one of A₁ and A₂ represents a carboxyl group and the other represents a carboxyl group or a cyano group, or A₁ and A₂ may be linked to each other to form a ring; A₃ represents a hydrogen atom, an aliphatic hydrocarbon residue, a halogen atom or an alkoxyl group; and A₄ and A₅ each independently represent a hydrogen atom, an aliphatic hydrocarbon residue, a halogen atom or an alkoxyl group, and when n1 is two or more so that the number of A₄ and the number of A₅ are each two or more, one of the A₄ substituents may be the same as or different from another thereof and one of the A₅ substituents may be the same as or different from another thereof, or A₄ and A₅ may be linked to each other to form a ring;
in Formula (3), n2 represents an integer of 1 to 5, A₆ and A₇ each independently represent a hydrogen atom, a carboxyl group, a cyano group, a phosphoric acid group or a sulfonic acid group, or A₆ and A₇ may be linked to each other to form a ring; A₈ represents a hydrogen atom, an aliphatic hydrocarbon residue, a halogen atom or an alkoxyalkyl group; A₉ and A₁₀ each independently represent a hydrogen atom, an aliphatic hydrocarbon residue, a halogen atom or an alkoxyl group, and when n2 is two or more so that the number of A₉ and the number of A₁₀ are respective are each two or more, one of the A₉ substituents may be the same as or different from another thereof and one of the A₁₀ substituents may be the same as or different from another thereof, or A₉ and A₁₀ may be linked to each other to form a ring; and Q₁ represents an oxygen atom, a sulfur atom or a selenium atom, and when n2 is two or more so that the number of Q₁ is two or more, one of the Q₁ atoms may be the same as or different from another thereof;
in Formula (4), n3 represents an integer of 1 to 4; A₁₁ and A₁₂ each independently represent a hydrogen atom, an aliphatic hydrocarbon residue, a halogen atom or an alkoxyl group, and when n3 is two or more so that the number of A₁₁ and the number of A₁₂ are each two or more, one of the A₁₁ substituents may be the same as or different from another thereof and one of the A₁₂ substituents may be the same as or different from another thereof, or A₁₁ and A₁₂ may be linked to each other to form a ring; and Q₂ represents an oxygen atom, a sulfur atom or a selenium atom, and when n3 is two or more so that the number of Q₂ is two or more, one of the Q₂ substituents may be the same as or different from another thereof; and
in Formulas (2) to (4), the mark * represents a binding site with the aromatic ring Ar₁ and/or Ar₂.

**2.** The compound according to claim 1, wherein Ar₁ and Ar₂ in Formula (1) are each a benzene ring.

**3.** The compound according to claim 1 or 2, wherein Y₁ and Y₂ in Formula (1) are each independently an aromatic residue, and Y₃ is a hydrogen atom.

**4.** The compound according to claim 1 or 2, wherein M in Formula (1) is a boron atom.

**5.** (Amended)
The compound according to claim 1, represented by Formula (5): 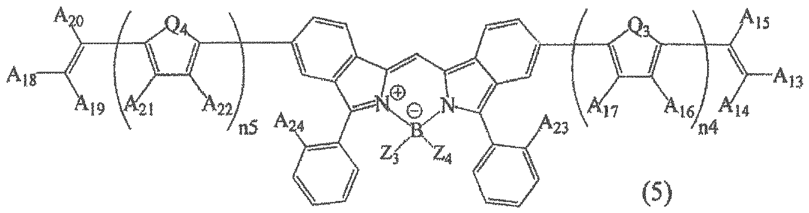 wherein Z₃ and Z₄ each independently represent a halogen atom; n4 represents an integer of 1 to 4; Q₃ represents an oxygen atom, a sulfur atom or a selenium atom, and when n4 is two or more so that the number of Q₃ is two or more, one of the Q₃ atoms may be the same as or different from another thereof; A₁₃ and A₁₄ each independently represent a hydrogen atom, a carboxyl group, a cyano group, a phosphoric acid group or a sulfonic acid group, or A₁₃ and A₁₄ may be linked to each other to form a ring; A₁₅ represents a hydrogen atom, an aliphatic hydrocarbon residue or an alkoxyl group; A₁₆ and A₁₇ each independently represent a hydrogen atom, an aliphatic hydrocarbon residue, a halogen atom or an alkoxyl group, and when n4 is two or more so that the number of A₁₆ and the number of A₁₇ are each two or more, one of the A₁₆ substituents may be the same as or different from another thereof and one of the A₁₇ substituents may be the same as or different from another thereof, or A₁₆ and A₁₇ may be linked to each other to form a ring; n5 represents an integer of 1 to 4; Q₄ represents an oxygen atom, a sulfur atom or a selenium atom, and when n5 is two or more so that the number of Q₄ is two or more, one of the Q₄ atoms may be the same as or different from another thereof; A₁₈ and A₁₉ each independently represent a hydrogen atom, a carboxyl group, a cyano group, a phosphoric acid group or a sulfonic acid group, or A₁₈ and A₁₉ may be linked to each other to form a ring; A₂₀ represents a hydrogen atom, an aliphatic hydrocarbon residue or an alkoxyl group; A₂₁ and A₂₂ each independently represent a hydrogen atom, an aliphatic hydrocarbon residue, a halogen atom or an alkoxyl group; when n5 is two or more so that the number of A₂₁ and the number of A₂₂ are each two or more, one of the A₂₁ substituents may be the same as or different from another thereof and one of the A₂₂ substituents may be the same as or different from another thereof, or A₂₁ and A₂₂ may be linked to each other to form a ring; and A₂₃ and A₂₄ each independently represent a hydrogen atom, a halogen atom, an aliphatic hydrocarbon residue or an alkoxyl group.

**6.** The compound according to claim 5, wherein in Formula (5), Z₃ and Z₄ are each a fluorine atom, n4 and n5 are each an integer of 1, Q₃ and Q₄ are each a sulfur atom, one of A₁₃ and A₁₄ is a carboxyl group and the other is a cyano group, one of A₁₈ and A₁₉ is a carboxyl group and the other is a cyano group, A₁₅ and A₂₀ are each a hydrogen atom, A₁₆ and A₂₁ are each a hydrogen atom, A₁₇ and A₂₂ are each an n-hexyl group, and A₂₃ and A₂₄ are each a methoxy group.

**7.** (Amended)
The compound according to claim 1, represented by Formula (6): 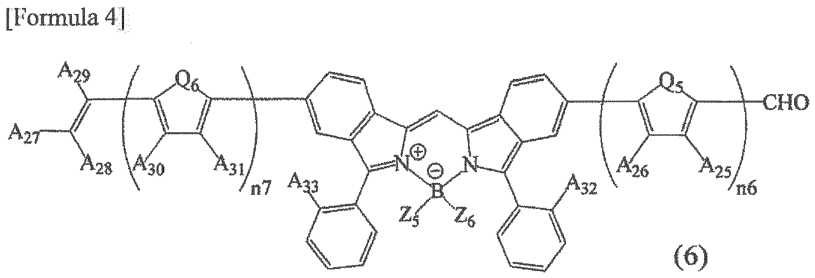 wherein Z₅ and Z₆ each independently represent a halogen atom; n6 represents an integer of 1 to 4; n7 represents an integer of 1 to 4; Q₅ represents an oxygen atom, a sulfur atom or a selenium atom, and when n6 is two or more so that the number of Q₅ is two or more, one of the Q₅ atoms may be the same as or different from another thereof; Q₆ represents an oxygen atom, a sulfur atom or a selenium atom, and when n7 is two or more so that the number of Q₆ is two or more, one of the Q₆ atoms may be the same as or different from another thereof; A₂₅ and A₂₆ each independently represent a hydrogen atom, an aliphatic hydrocarbon residue, a halogen atom or an alkoxyl group, and when n6 is two or more so that the number of A₂₅ and the number of A₂₆ are each two or more, one of the A₂₅ substituents may be the same as or different from another thereof and one of the A₂₆ substituents may be the same as or different from another thereof, or A₂₅ and A₂₆ may be linked to each other to form a ring; A₂₇ and A₂₈ each independently represent a hydrogen atom, a carboxyl group, a cyano group, a phosphoric acid group or a sulfonic acid group, or A₂₇ and A₂₈ may be linked to each other to form a ring; A₂₉ represents a hydrogen atom, an aliphatic hydrocarbon residue or an alkoxyl group; A₃₀ and A₃₁ each independently represent a hydrogen atom, an aliphatic hydrocarbon residue, a halogen atom or an alkoxyl group, and when n7 is two or more so that the number of A₃₀ and the number of A₃₁ are each two or more, one of the A₃₀ substituents may be the same as or different from another thereof and one of the A₃₁ substituents may be the same as or different from another thereof, or A₃₀ and A₃₁ may be linked to each other to form a ring; and A₃₂ and A₃₃ each independently represent a hydrogen atom, a halogen atom, an aliphatic hydrocarbon residue or an alkoxyl group.

**8.** The compound according to claim 7, wherein in Formula (6), Z₅ and Z₆ are each a fluorine atom, n6 and n7 are each an integer of 1, Q₅ and Q₆ are each a sulfur atom, A₂₅, A₂₉ and A₃₀ are each a hydrogen atom, A₂₆ and A₃₁ are each an n-hexyl group, one of A₂₇ and A₂₈ is a carboxyl group and the other is a cyano group, and A₃₂ and A₃₃ are each a methoxy group.

**9.** (Amended)
The compound according to claim 1, represented by Formula (9): 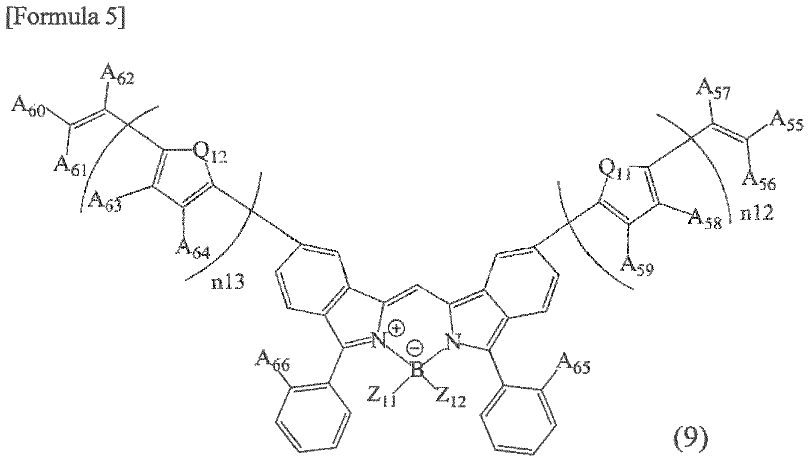 wherein Z₁₁ and Z₁₂ each independently represent a halogen atom; n12 represents an integer of 1 to 5; Q₁₁ represents an oxygen atom, a sulfur atom or a selenium atom, and when n12 is two or more so that the number of Q₁₁ is two or more, one of the Q₁₁ atoms may be the same as or different from another thereof; A₅₅ and A₅₆ each independently represent a hydrogen atom, a carboxyl group, a cyano group, a phosphoric acid group or a sulfonic acid group, or A₅₅ and A₅₆ may be linked to each other to form a ring; A₅₇ represents a hydrogen atom, an aliphatic hydrocarbon residue or an alkoxyl group; A₅₈ and A₅₉ each independently represent a hydrogen atom, an aliphatic hydrocarbon residue, a halogen atom or an alkoxyl group, and when n12 is two or more so that the number of A₅₈ and the number of A₅₉ are each two or more, one of the A₅₈ substituents may be the same as or different from another thereof and one of A₅₉ may be the same as or different from another thereof, or A₅₈ and A₅₉ may be linked to each other to form a ring; n13 represents an integer of 1 to 5; Q₁₂ represents an oxygen atom, a sulfur atom or a selenium atom, and when n13 is two or more so that the number of Q₁₂ is two or more, one of the Q₁₂ atoms may be the same as or different from another thereof; A₆₀ and A₆₁ each independently represent a hydrogen atom, a carboxyl group, a cyano group, a phosphoric acid group or a sulfonic acid group, or A₆₀ and A₆₁ may be linked to each other to form a ring; A₆₂ represents a hydrogen atom, an aliphatic hydrocarbon residue or an alkoxyl group; A₆₃ and A₆₄ each independently represent a hydrogen atom, an aliphatic hydrocarbon residue, a halogen atom or an alkoxyl group, and when n13 is two or more so that the number of A₆₃ and the number of A₆₄ are each two or more, one of the A₆₃ substituents may be the same as or different from another thereof and one of the A₆₄ substituents may be the same as or different from another thereof, or A₆₃ and A₆₄ may be linked to each other to form a ring; and A₆₅ and A₆₆ each independently represent a hydrogen atom, a halogen atom, an aliphatic hydrocarbon residue or an alkoxyl group.

**10.** The compound according to claim 9, wherein in Formula (9), Z₁₁ and Z₁₂ are each a fluorine atom, n12 and n13 are each an integer of 1, Q₁₁ and Q₁₂ are each a sulfur atom, one of A₅₅ and A₅₆ is a carboxyl group and the other is a cyano group, one of A₆₀ and A₆₁ is a carboxyl group and the other is a cyano group, A₅₇ and A₆₂ are each a hydrogen atom, A₅₈ and A₆₃ are each a hydrogen atom, A₅₉ and A₆₄ are each an n-hexyl group, and A₆₅ and A₆₆ are each a methoxy group.

**11.** The compound according to claim 1, represented by Formula (10): 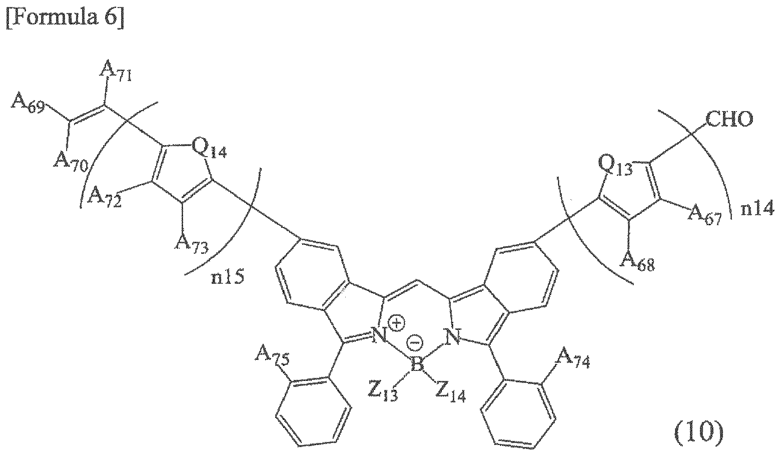 wherein Z₁₃ and Z₁₄ each independently represent a halogen atom; n14 represents an integer of 1 to 4; n15 represents an integer of 1 to 5; Q₁₃ represents an oxygen atom, a sulfur atom, or a selenium atom, and when n14 is two or more so that the number of Q₁₃ is two or more, one of the Q₁₃ atoms may be the same as or different from another thereof; Q₁₄ represents an oxygen atom, a sulfur atom or selenium atom, and when n15 is two or more so that the number of Q₁₄ is two or more, one of the Q₁₄ atoms may be the same as or different from another thereof; A₆₇ and A₆₈ each independently represent a hydrogen atom, an aliphatic hydrocarbon residue, a halogen atom or an alkoxyl group, and when n14 is two or more so that the number of A₆₇ and the number of A₆₈ are each two or more, one of the A₆₇ substituents may be the same as or different from another thereof and one of the A₆₈ substituents may be the same as or different from another thereof, or A₆₇ and A₆₈ may be linked to each other to form a ring; A₆₉ and A₇₀ each independently represent a hydrogen atom, a carboxyl group, a cyano group, a phosphoric acid group or a sulfonic acid group, or A₆₉ and A₇₀ may be linked to each other to form a ring; A₇₁ represents a hydrogen atom, an aliphatic hydrocarbon residue or an alkoxyl group; A₇₂ and A₇₃ each independently represent a hydrogen atom, an aliphatic hydrocarbon residue, a halogen atom or an alkoxyl group, and when n15 is two or more so that the number of A₇₂ and the number of A₇₃ are each two or more, one of the A₇₂ substituents may be the same as or different from another thereof and one of the A₇₃ substituents may be the same as or different from another thereof, or A₇₂ and A₇₃ may be linked to each other to form a ring; and A₇₄ and A₇₅ each independently represent a hydrogen atom, a halogen atom, an aliphatic hydrocarbon residue or an alkoxyl group.

**12.** The compound according to claim 11, wherein in Formula (10), Z₁₃ and Z₁₄ are each a fluorine atom, n14 and n15 are each an integer of 1, Q₁₃ and Q₁₄ are each a sulfur atom, A₆₇, A₇₁ and A₇₂ are each a hydrogen atom, A₆₈ and A₇₃ are each an n-hexyl group, one of A₆₉ and A₇₀ is a carboxyl group and the other is a cyano group, and A₇₄ and A₇₅ are each a methoxy group.

**13.** A method for manufacturing the compound represented by Formula (1) according to claim 1, comprising introducing a substituent X₁ by a cross-coupling reaction.

**14.** A photoelectric conversion element comprising the compound represented by Formula (1) according to claim 1 which is supported on a thin film of oxide semiconductor fine particles disposed on a substrate.

**15.** A photoelectric conversion element comprising one or more of the compounds represented by Formula (1) according to claim 1 and a sensitizing dye compound having a different structure from Formula (1) which are carried by a thin film of oxide semiconductor fine particles disposed on a substrate.

**16.** The photoelectric conversion element according to claim 14, wherein the oxide semiconductor fine particles contain titanium dioxide, zinc oxide or tin oxide.

**17.** A solar cell comprising the photoelectric conversion element according to any one of claims 14 to 16.
